(19) Europäisches Patentamt
European Patent Office
Office européen des brevets

(11) **EP 0 555 376 B1**

(12) **EUROPEAN PATENT SPECIFICATION**

(45) Date of publication and mention
of the grant of the patent:
**18.03.1998 Bulletin 1998/12**

(51) Int Cl.6: **G21K 1/00**

(86) International application number:
**PCT/US91/08167**

(21) Application number: **92900210.3**

(22) Date of filing: **31.10.1991**

(87) International publication number:
**WO 92/08235 (14.05.1992 Gazette 1992/11)**

(54) **DEVICE FOR CONTROLLING RADIATION AND USES THEREOF**

VORRICHTUNG ZUR STEUERUNG VON STRAHLUNG UND IHRE VERWENDUNGEN

DISPOSITIF POUR CONTROLER DES RADIATIONS ET LEURS UTILISATIONS

(84) Designated Contracting States:
**AT BE CH DE DK ES FR GB GR IT LI LU NL SE**

(30) Priority: **31.10.1990 US 607456**
**01.04.1991 US 678207**
**01.04.1991 US 678208**
**01.04.1991 US 678437**
**01.04.1991 US 678603**

(43) Date of publication of application:
**18.08.1993 Bulletin 1993/33**

(73) Proprietor: **X-RAY OPTICAL SYSTEMS, INC.
Voorheesville, NY 12186 (US)**

(72) Inventor: **KUMAKHOV, Muradin, A.
Moscow (SU)**

(74) Representative: **Haug, Dietmar, Dipl.-Ing. et al
Patentanwälte
Andrae Flach Haug Kneissl
Bauer Schneider,
Balanstrasse 55
81541 München (DE)**

(56) References cited:
**WO-A-88/01428        DD-A- 240 091**
**DE-B- 1 803 806       GB-A- 1 227 929**
**GB-A- 1 474 955**

## Description

This invention relates to devices for controlling radiation and, more specifically, to devices for controlling X-ray and gamma ray beams, and beams of charged particles and neutrons, and can be used to shape converging, diverging and quasi-parallel beams in a wide spectral range, at large aperture angles, and on short shaping paths.

The invention may be used to control X-ray, gamma and neutron beams in medical radiography and radiotherapy, to shape beams for X-ray microanalyzers and X-ray diffraction analyzers, and to improve the efficiency of gamma ray utilization in Mössbauer examinations.

An advantageous application of this invention is to concentrate energy radiated by various sources with the objective of producing radiation beams with a high power density in a small area, e.g., to create oriented radiation detectors tuned to small size localized sources, for instance in radioastronomy.

Various devices are used to control particle, X-ray and gamma ray beams; these devices are based on radiation interference and diffraction, for instance Fresnel microzone plates, multilayer mirrors, and Bragg crystals. Also used for charged particle beam control are magnetic and electrostatic elements. A critical shortcoming of these devices is their narrow spectral band, principally due to the physical phenomena on which they are based.

As is known, incidence of beams of various charged particles, neutrons, X-rays and gamma rays onto boundaries of condensed media, features a certain value of the grazing angle, called the critical angle of total external reflection, below which reflection is accompanied by very low losses. In the case of very smooth surfaces and low radiation absorption in the material of the reflective surface, the losses with total external reflection are so low that they allow efficient beam control via multiple reflections at angles below critical.

Known in the art are devices functioning with multiple total external reflection in bent tube channels to concentrate and shape quasi-parallel beams of X-rays (Soviet Physics +Uspekhi, vol. 157, issue 3, March, 1989. V.A. Arkad'ev, A. I. Kolomijtsev, M.A. Kumakov, I.Yu, Ponomarev, I.A. Khodeyev, Yu.P. Chertov, I.M. Shakhparonov. "Wideband X-ray Optics With Wide-Angle Aperture", pp. 529-537). This device comprises a plurality of channels with inner surfaces featuring total external reflection, with input butt-ends facing a radiation source, and with output butt-ends directed at a radiation receiver. The channel-forming elements are located on the generatrices of imaginary coaxial barrel-shaped surfaces.

A shortcoming of this prior art device is the considerable loss in radiation transfer efficiency along the tube channels, due to the inaccuracy of positioning of the tube channels along the generatrices of imaginary barrel-shaped surfaces and non-optimal orientation of the input and output butt-ends at the source and receiver of radiation, respectively. Another shortcoming is the device's relatively narrow spectral band which arises from non-optimal tube channel size.

X-ray lithography utilizes a variety of sources including X-rays emitted from a small area (point-sources) and synchrotron generated X-rays to generate an image. Unfortunately, X-ray lithographic systems have been limited by the inability to adequately manipulate the X-ray beam.

X-ray optics incur difficulties not encountered in the visible or infra-red (IR range). Refraction in passing through media of a different refractive index cannot be used because of the strong absorption of photons with sufficient energy to excited or ionize electronic levels inside the media. Diffraction and interference phenomena can be used to deflect X-rays using Bragg scattering in single crystals, in multi-layer mirrors or by using zone and phase plates. Although these approaches are useful in many applications, they are very energy (wave length) selective and cannot be used to control X-ray beams having a broad energy spectrum. The use of reflection has also been limited because surfaces of all known materials have very low reflection coefficients for X-radiation at large angles of incidence.

Grazing-incidence optics have been developed based on the phenomenon of total external reflection of X-rays. This is widely used in synchrotron radiation facilities where flat mirrors are used for deflection and curved mirrors are used for focusing parallel beams. These mirrors typically use a single reflection. Such devices have an extremely small angular aperture due to the small value of the total-external-reflection angle (milliradians at KeV energies).

Point-source X-ray lithography using existing equipment is limited by intensity, radial magnification, penumbral blur and source position instability, and synchrotron-source X-ray lithography is not intensity limited and has a beam which does not show significant divergence of any significance in the vertical direction.

The subject invention provides a solution to the long felt need in the art for an improved system of X-ray lithography by providing the benefits of improved X-ray control, precision and accuracy.

X-rays, gamma rays, and particle radiation are currently used in many types of analytic instruments. By using radiation, much can be learned about the composition, structure, and other characteristics of a sample. Unfortunately, conventional instruments have limited intensity and/or limited control over beam direction or divergence.

One of the most important and widely used nondestructive evaluation methods for a sample (materials, components or systems) is X-ray fluorescence analysis or spectrometry (XRF). X-ray fluorescence spectrometry, as an analytical tool, has developed primarily along two paths: wavelength dispersive spectrometry (WDXRF) and energy dispersive spectrometry (EDXRF). Moreover, the two described measurement techniques may be combined to get rapid, semi-quantitative results followed by high resolution measurements, although few commercial instruments can accomplish this.

X-rays produced by photon bombardment of solid targets include monoenergetic X-rays characteristic of the target material on a broad background of "bremstrahlung" radiation, Unfortunately, secondary X-ray spectra excited by such an X-ray source usually has a background especially at lower energies from scattering of the bremstrahlung continuum radiation in the sample.

The subject invention can improve X-ray fluorescence analysis by (1) decreasing measurement time due to increased intensity reaching the detector, (2) decreasing measurement time due to decrease in bremstrahlung radiation reaching the detector causing photon pile-up, (3) increasing resolution by increasing signal to noise ratio, (4) decreasing the bremstrahlung radiation reaching the detector, (5) increasing resolution for WDXRF by very precise control of angular relationships, (6) improving ability to evaluate small well defined areas, (7) improving ability to determine the distribution of constituents by scanning, (8) improving ability to determine average composition over a well defined area without moving the sample, source aperture, or any other part, (9) allowing analysis of well defined interior volumes in a solid, and reducing cost of other components in system, such as ability to use smaller detectors.

The inventor of the subject invention first proposed the focusing of X-rays by multiple reflections from surfaces with certain special shapes and has demonstrated that transmission through these "Kumakhov" lenses could be as high as 50%. Moreover, even with lower transmission, as much as a four order of magnitude increase in X-ray intensity was obtained due to the large collection angular aperture possible (.25 rad).

Beams of radiation are used in a wide variety of medical applications, in both diagnosis and therapy. However, the use and/or effectiveness of conventional medical equipment is limited by difficulties such as (i) obtaining high intensity beams of narrow band width at desired energies, especially due to the presence of photons or particles of higher than desired energies which are not readily filtered out; (ii) lack of ability to form parallel beams having desired cross-sections and to form convergent beams; (iii) large losses in intensity when collimating; and (iv) no effective means to channel radiation for delivery directly to the lining of body cavities.

These limitations result in poor resolution imaging, high level radiation dose delivered a patient's healthy tissue, radiation contamination of medical personnel, and expensive sources, detectors, and other equipment components. The Kumakhov lens' accuracy, and precision of radiation delivery minimies such problems.

In summary, the subject invention provides a novel Kumakhov lens suitable for use in X-ray lithography, analytic instruments, medical devices, and the like.

The article "Wide-band X-ray Optics with a large angular aperture", Soviet Physics +Uspekhi, vol. 157, issue 3, March 1989 of V.A. Arkad'ev et.al. discloses a device for controlling radiation according to the preamble of claim 1.

Disadvantages of this prior art are the considerable loss in radiation transfer efficiency along the channels, due to the inaccurancy of positioning the channel-forming elements, and the relatively narrow spectral band.

It is the object of the invention to provide a device for controlling radiation, comprising a high radiation transfer efficiency along the channels together with a relatively wide spectral band.

The object of the invention is achieved by the features of claim 1. Preferred embodiments of the invention are disclosed in the dependend claims.

It is a further object of the subject invention to improve the efficiency of radiation transfer along the channels of a beam control device, to expand the angular and spectral bands of radiation beams being controlled, to reduce the labor consumption of device manufacture, to reduce the overall dimensions of the device, to reduce the size of its focal area and correspondingly increase the efficiency of beam energy concentration and beam power density at the device output, to improve radiation beam uniformity at the device output and reduce angular beam divergence, and to reduce the effects of background radiation on the radiation beams being shaped.

According to the invention there is provided a device for controlling beams of particles, X-ray and gamma quanta having a plurality of channels with inner surfaces exhibiting multiple total external reflections, with input butt-ends facing a source of radiation, and with output butt-ends aimed at a radiation receiver, and in which the channels are preferably formed by elements positioned along the generatrices of imaginary barrel-shaped coaxial surfaces, in accordance with the principles of this invention, by spatially locating the channel-forming elements with a rigid support structure, and by providing each channel with a channel width, D, in the radial direction at the input butt-end, meeting the condition:

$$D_1 \le 2\theta_D F + D$$

where $D_1$ is the effective radiation source diameter from which radiation is captured by the lens, $\theta_D$ is the minimum value of the critical total external reflection angle of the radiation in the desired spectral band, and F is the distance from the radiation source to the channel input butt-end, as measured along a central axis of beam propagation.

In the case where the plurality of channels comprise bent tubes with longitudinal axes located along the generatrices of imaginary coaxial barrel-shaped surfaces, it is advantageous to implement the rigid support structure of the present invention with discs positioned normal to the central axis of beam propagation, and to provide each disc with a honeycomb pattern of apertures accommodating the tubes, thus, rigidly fixing the latter along generatrices of barrel-shaped surfaces. These rigid supports can take a number of forms, including solid plates with holes formed by processes such as lithography or laser machining, or a solid frame with wires or other items in patterns across the large opening at predetermined spacings along two or more directions in the plane, producing a grid.

This approach ensures a high accuracy of the bent channel shape, its rigid location, minimal deviation of the curvature radius from its optimal value, and accurate and rigid aiming of the input and output butt-ends at the radiation source and receiver, respectively, thus providing maximal capture of the radiation into the channels and radiation transfer with minimal losses.

In another aspect of the invention, individual one(s) of the discs may be made axially translatable relative to the other discs. This approach when applied, for example, to a disc nearest the input butt-ends provides adjustability of focal length and capture angle. Translatable supports are useful as well, for the ability to tune the transmission energy bandwidth and spectrum, and to adjust the beams focal spot size and exit focal length.

In cases where the channels are formed by gaps between coaxial barrel-shaped beam reflective layers or envelopes, coaxial to the beam being controlled, the rigid support structure may comprise at least two rigid grids (of, for example, honeycomb pattern) positioned at the input and output butt-ends of the channels, normal to the beam axis, with the envelopes rigidly fitted to the grids by their butt-ends. The advantage of such a design is minimization of radiation intensity losses in the device's fixing structure, simplification of device assembly, lower weight of envelope reinforcement, and minimization of envelope deformation by the reinforcing structure.

In embodiments employing bent tubes as the channel-forming elements, it is advantageous to position supporting discs with honeycomb patterns of apertures fixing the location of the bent tubes along the central axis of the controlled beam with a spacing of supports of $L \leq \sqrt{12EI/(QR_1)}$, where E is the tube elasticity modulus at the maximum temperature the tubes will experience including possibly elevated temperatures due to radiation absorptions, I is the moment of inertia of the cross section of the tubes relative to the neutral axis, Q is the tube mass per unit length, and $R_1 = 2D/Q^2$ is the critical tube curvature radius, as determined by the high-energy boundary of the required radiation spectrum. This minimizes tubes sagging under their own weight to an allowable curvature, at which the radiation intensity losses during radiation transfer along the channels is not excessive.

In the event that the plurality of channels is designed as capillaries, it is another feature of this invention to group these latter into separate bundles with the longitudinal axes of the bundles positioned along generatrices of imaginary coaxial barrel-shaped surfaces, coaxial to the controlled beam's central axis, and to design the rigid support structure as discs positioned normal to the controlled beam axis and provided with honeycomb patterns of apertures to accommodate each of the capillary bundles. This design configuration is advantageous in that it allows expansion of the spectral band of the device due to a smaller diameter of the channels and a greater number of channels, whereas the labor content of assembling depends on the number of capillary bundles, rather than on the number of channels. It also reduces breakage due to the strength of the bundles compared to the strength of small individual capillaries. The device dimensions can also be reduced due to a lower critical curvature radius $R_1$ of the channels.

In the case mentioned earlier, with the plurality of channels designed in the form of bent tubes with longitudinal axes located along generatrices of imaginary barrel-shaped surfaces coaxial to the central axis of the controlled beam, it is also possible, in accordance with the principles of the present invention, to form the rigid honeycomb pattern support structure out of the tube walls, rigidly linked by their external surfaces, making the channel width in each tube variable along the channel length and proportional to the corresponding dimension of the device at each cross section of the latter. This embodiment provides the advantage that the entire device can be formed by plastically deforming a bundle of tubes to have a larger channel size in the wide part of the device and making the channel diameter very small at the butt-ends oriented at the focal point. This can be done by methods such as drawing thermoplastically heated tube bundles. This approach allows reducing of the diameter of the focal area by several orders of magnitude, thus, correspondingly increasing radiation energy concentration. Once automated, this method will serve as a low cost method for manufacturing the invention.

In another aspect of the present invention, where the plurality of channels comprise bent tubes having their longitudinal axes positioned along the generatrices of imaginary coaxial barrel-shaped surfaces, it is expedient to compose the rigid honeycomb pattern support structure of bushings encompassing each tube in a plane normal to the central axis of beam propagation, with the bushings rigidly fitted to one another to constitute a support with the aid of adhesive or interlocking mechanisms, or clamping devices (e.g., an outer band). This significantly simplifies assembling of the device and allows creation of devices with a substantially greater number of channel-forming elements, thus expanding the range of angular beam control.

Similarly, it is also expedient, in the case where the plurality of channels are designed with capillaries, these latter being grouped into bundles with the longitudinal axes thereof positioned along the generatrices of imaginary coaxial barrel-shaped surfaces, to compose the rigid honeycomb pattern support structure of bushings encompassing each capillary bundle in a plane normal to the controlled beam axis and rigidly fitted to one another by adhesive or interlocking mechanisms or clamping devices. This allows simplifying the device assembly.

Instead of bushings surrounding each tube or bundle of capillaries, coplanar stacked cradles can be employed to form the rigid support structure.

The rigid support structure may be mounted for rotation, as a unit, around the central axis of beam propagation, thus allowing equalization of time-averaged radiation intensity along the beam cross section by averaging irregularities caused by beam transfer via separate channels.

According to yet another aspect of this invention, it is suitable to have different lengths for different channels selecting the lengths thereof in accordance with the required attenuation of the radiation intensity in each area of the cross section of the beam being shaped. This allows control of the radiation intensity along the cross section of the beam being shaped by canceling out irregularities caused by different intensity losses during radiation transfer via channels of different curvature. The most common use is to equalize beam intensity. Alternatively, an absorbing filter with a density or thickness varying over the cross sections; the most common use being a filter with absorptions falling off from its center to its periphery can be positioned in the beam path to accomplish the same purpose.

It has further proven advantageous to make the individual elements diverging (e.g. conically diverging) with a taper angle $\theta_1 < \theta$ - $D/L_1$, where $\theta$ is the required divergence angle of the quasi-parallel beam, and $L_1$ is the length of the tapered tube section. In this case, radiation transfer in the flared out channels is accompanied by beam divergence reduction to the value of the taper angle.

In another aspect of the invention, the channel forming elements can be located along generatrices of imaginary coaxial surfaces of compound curvature. For instance, the output butt-ends of channels may be extended with channel-forming elements located along the generatrices of imaginary toroidal surfaces matched to corresponding ones of said barrel-shaped surfaces, with the output butt-ends oriented at the radiation receiver. This allows providing a higher density of radiation beams thus shaped.

It is productionally effective to create the rigid support structure by filling the gaps between tubes with a compound. It is also suitable to provide the device with an external screening casing of a material opaque to the radiation of the controlled beam, with apertures in the casing aligned with the channel butt-ends, and employing only curved channels and radiation absorbing inter-tube material in order to block any straight line paths to an enclosed radiation receiver or source, thus reducing the share of background radiation in the radiation beams shaped. Such filling also reduces the susceptibility of the device to movement such as vibrations.

The subject invention also provides an X-ray lithographic system comprising the above-described Kumakhov lens. An X-ray source is required and the Kumakhov lens is typically located between X-ray source and a mask.

The X-ray source may be a point source or a non-point source, such as a synchrotron. A Kumakhov lens may also be located between a mask and a resist. The subject invention also teaches a method for X-ray lithography, which comprises: providing a source of radiation; focusing the radiation from the source through a Kumakhov lens, and passing the focused radiation through a mask. This method may also add a Kumakhov lens to form a quasi-parallel beam and a second Kumakhov lens to focus the beam into a preselected band of energies.

The subject invention further provides an analytic instrument comprising a Kumakhov lens. Typically, the Kumakhov lens is located between a radiation source and a sample to be analyzed. The subject instrument maybe an X-ray device, such as an X-ray fluorescence device, X-ray microscope or X-ray diffraction device, an ionic device, such as an ion microscope, a neutron device, such as a neutron microscope or neutron diffraction device, or an electron beam device.

Most often the subject instruments comprise a monochromater in which the radiation source is capable of transversing both the Kumakhov lens and the monochromater. In this application, the Kumakhov lens is usually a divergent beam concentrator, parallel beam concentrator, quasi-parallel beam former, or quasi-parallel beam manipulator.

Another embodiment of the subject invention is where the Xumakhov lens is positioned between a secondary radiation source and a sample, with the Kumakhov lens typically functioning as a divergent beam concentrator, parallel beam concentrator, quasi-parallel beam former, or quasi-parallel beam manipulator.

The subject invention also provides for a Kumakhov lens being positioned between a sample to be analyzed and a means for detecting radiation with the Kumakhov lens typically functioning as a divergent beam concentrator, parallel beam concentrator, quasi-parallel beam former, or quasi-parallel beam manipulator.

A Kumakhov lens may function as a band-pass filter. Moreover, the subject instruments are suitable for use in digital subtraction analysis.

The subject invention further provides a method for analyzing a sample, which comprises providing a source of radiation; directing the radiation produced by the source through a Kumakhov lens; contacting the sample to be analyzed with the radiation exiting the Kumakhov lens; and detecting the radiation exiting the sample.

Typically, the radiation detected is then correlated with known parameters of such radiation.

The directing of radiation from the source may further comprise reflecting the radiation exiting the Kumakhov lens and passing the reflected radiation through a second Kumakhov lens. This usually is accomplished by using a crystal and may utilize a single crystal monochromater. Further, the radiation exiting the sample may be passed through a second Kamakhov lens prior to detection.

The subject invention additionally provides a medical device which comprises a Kumakhov lens. Medical devices are provided which are suitable for both diagnosis and therapy. Specific medical devices disclosed include an angiographic device, an endoscope, a tomography device, a device capable of ionizing tissue, a device useful for neutron capture therapy, and a device for X-ray fluorescence analysis. Moreover, the subject invention provides for the use of a Kumakhov lens in a medical device.

The subject invention also teaches a method of irradiating a subject, which comprises generating a beam of radiation; focusing the beam using a Kumakhov lens; and directing the beam at the subject. Further, a method of detecting the presence of a substance in a subject, which comprises generating a beam of radiation; focusing the beam using a Kumakhov lens; directing the beam at the subject; and detecting the remnants of the beam after contacting the subject is also taught.

### Brief Description Of The Figures

FIG. 1 shows a section along the controlled beam axis of an embodiment of the invention with tubes as the channel-forming elements fixed in place by discs having apertures positioned in a honeycomb pattern.

FIG. 2 shows a section of the embodiment shown in FIG. 1 along the A-A plane.

FIG. 3 shows a cross sectional view of the embodiment of FIG. 1 along the B-B plane in a case where the capillaries are extended until they touch.

FIG. 4 shows a section along the controlled beam axis of an embodiment of this invention with barrel-shaped envelopes as the channel-forming elements, fixed in place by gluing to honeycomb grids.

FIG. 5 shows a view of the embodiment shown in FIG. 4 from the radiation source side.

FIG. 6 shows part of an embodiment of this invention with capillaries grouped into separate bundles as the channel-forming elements.

FIG. 7 depicts the use of a bushing encompassing a bent tube to form a rigid supporting structure.

FIG. 8 depicts the use of a bushing surrounding a bundle of capillaries to form a rigid supporting yoke.

FIG. 9 illustrates a rigid support structure composed of stacked cradle members.

FIG. 10 shows a section along the controlled beam axis of an embodiment of this invention with channel-forming elements designed with tubes plastically shaped to produce varying channel cross sections, wherein the rigid honeycomb pattern support structure is formed by the walls of the tubes themselves.

FIG. 11 depicts an arrangement for rotating a rigid channel supporting structure about a central beam axis.

FIG. 12 shows an embodiment having an axially translatable support disc.

FIG. 13 shows a section along the controlled beam axis of an embodiment of this invention, wherein the channel-forming elements are tubes shaping a quasi-parallel beam, extended with rectilinear tube sections of different length to equalize the radiation intensity along the cross section of the quasi-parallel beam.

FIG. 13A shows a section along the controlled beam axis of an embodiment of the invention, in which an absorption filter is employed to equalize radiation intensity along the cross section of a quasi-parallel beam.

FIG. 14 shows a section along the controlled beam axis of an embodiment of the invention, wherein the channel-forming elements are tubes shaping a quasi-parallel beam, extended with flared tubes to reduce the divergence of the shaped quasi-parallel beam.

FIG. 15 shows a section along the controlled beam axis of an embodiment of the invention, wherein channel-forming elements located along generatrices of imaginary barrel-shaped surfaces are continued along generatrices of toroidal surfaces.

FIG. 16 shows a section along the controlled beam axis of an embodiment of the invention, wherein the gaps between channel forming tubes and between tube supporting discs are filled with a solidifying material.

FIG. 17 shows a section along the controlled beam axis of an embodiment of the invention, wherein the entire device is enclosed in a screening casing having apertures aligned with the input and output butt-ends of the radiation transfer channels.

FIG. 18 shows a typical graph of transmission coefficient vs. energy for bending of photons.

FIG. 19 shows a capillary of a special geometry near the capillary inflection point illustrating photons traveling from one wall to the other.

FIG. 20 shows a typical graph of transmission coefficient vs. photon energy for a special geometry which provides a high energy cutoff.

FIG. 21A shows a series of rectangular capillaries and reflection of the initial parallel beams.

FIG. 21B shows a graph of photon count from each beam vs. photon energy, with the two beams $I_1$ and $I_2$ showing special distributions.

FIG. 22 shows obtaining beams using variable width capillaries with their size diminishing towards their entrance end.

FIG. 23 shows a lens with non-uniform channel cross sections which produces a small focal spot.

FIG. 24 shows an asymetrical lens system which obtains a small spot of high intensity radiation from a divergent source.

FIG. 25 shows input baffling of a lens element.

FIG. 26 shows capillary elements with the inter-element space cooled with a fluid (gas or liquid).

FIG. 27 shows a poly-capillary having a 300 µm diameter with each individual channel having a diameter of about 10 µm.

FIG. 28 shows a schematic representation of a system showing a source, a Kumakhov lens and a mask. X-rays generated at the source transverse the Kumakhov lens, and proceed to the mask.

FIG. 29 shows a schematic representation of a system showing a source, a Kumakhov lens and a mask. X-rays generated at the source transverse the Kumakhov lens, and proceed to the mask. The beam exiting the Kumakhov lens is narrower than in Figure 28.

FIG. 30A shows a schematic representation of a system having a source, a Kumakhov lens, a mask and a wafer.

g = mask/wafer gap
θ = lens capture angle (sr)
δ = radial magnification

FIG. 30B shows a schematic representation of the X-rays traversing the mask and hitting the wafer.

θ = maximum beam divergence from axis
ρ = penumbral blur

FIG. 31 shows a representation of the magnified beam cross-section taken at a position to the butt end of the lens.

FIG. 32A shows a schematic representation of a system which uses a divergent beam synchrotron, a Kumakhov lens for focusing the beam to quasi-parallel, a Kumakhov lens for energy band reflection and Kumakhov lens for beam shaping.

FIG. 32B shows a representation of the beam cross-section taken along planes 1-1 and 2-2.

FIG. 33A shows a representation of synchrotron radiation coming off a synchrotron ring.

FIG. 33B shows a representative transformation of synchrotron radiation into a large cross-section with small divergence and filtration of higher energy photons.

FIG. 34 shows a schematic representation of projected lithography including an X-ray source, a first Kumakhov lens, mask filter, a second Kumakhov lens and a resist.

FIG. 35 shows a representation of the second Kumakhov lens for projection lithography.

FIG. 36 shows a schematic representation of a divergent beam concentrating Kumakhov lens.

FIG. 37 shows a schematic representation of a parallel beam concentrating Kumakhov lens.

FIG. 38A shows a schematic representation of a quasi-parallel beam forming Kumakhov lens.

FIG. 38B shows a second schematic representation of a quasi-parallel beam forming Kumakhov lens.

FIG. 39 shows a schematic representation an X-ray source, a Kumakhov lens, a sample and detector. X-rays travel from the source, through the lens and to the sample where they are deflected and then detected.

FIG. 40A shows a schematic representation of an X-ray source, sample, Kumakhov lens and detector. X-rays travel from the source, to the sample where they are deflected, pass through the Kumakhov lens and are then detected.

FIG. 40B shows a schematic representation of a system having an x-ray source, sample, first Kumakhov lens, crystal, second Kumakhov lens and detector. X-rays travel from the source to the sample where they are deflected through the first Kumakhov lens to the crystal and the second Kumakhov lens to the detectors.

FIG. 41A shows a schematic representation of system having an X-ray source, first Kumakhov lens, sample, second Kumakhov lens and detector. X-rays travel from the source through the first Kumakhov lens to the sample where it is deflected through the second Kumakhov lens to the detector.

FIG. 41B shows a schematic representation of the sample (as shown in FIG. 33A) with some of the X-rays being deflected to the second Kumakhov lens and other X-rays passing through the sample.

FIG. 42 shows a schematic representation of a complex analytical system having a source power supply, an X-ray source, Kumakhov lens, sample, sample positioning system, energy dispersive detectors, single crystal or multi-layer reflector, detector electronics, complete central and analysis system.

FIG. 43 shows a schematic representation of a system having an X-ray source, Kumakhov lens, single crystal monochromator, sample, Kumakhov lens, and detector.

FIG. 44A shows a schematic representation of a source, a Kumakhov lens, and capillaries.

FIG. 44B shows a schematic representation of a source, Kumakhov lens, and multiple capillaries.

FIG. 45 shows a schematic representation of a source, a Kumakhov lens, and a system of capillaries.

FIG. 46 shows a schematic representation of a microscope with synchrotron radiation.

FIG. 47 shows a schematic representation of a lens mode of barrel-shaped capillaries.

FIG. 48 shows a schematic representation of a trajectory of photons through a barrel-shaped capillary.

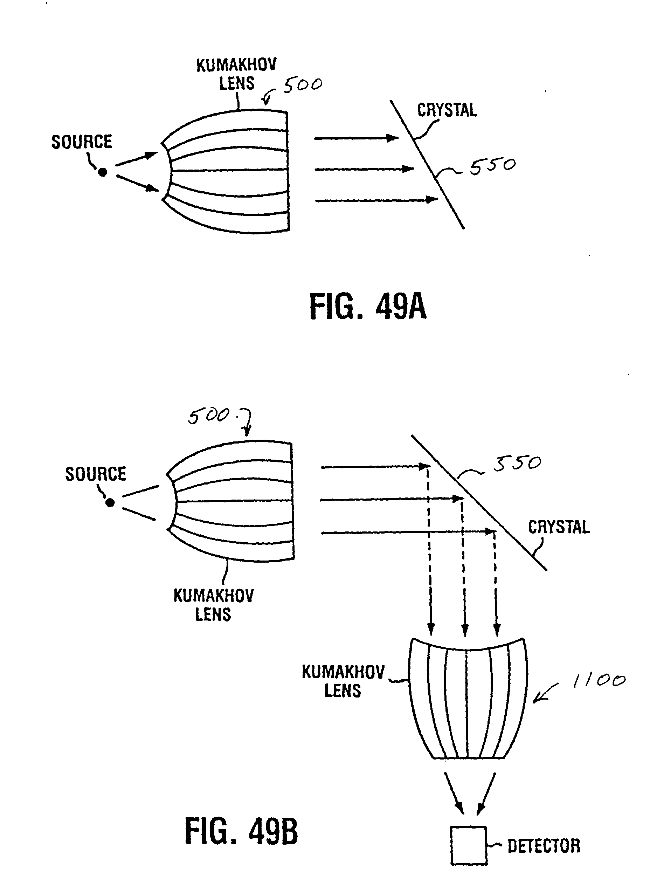

FIG. 49A shows a schematic representation of diffraction by using a source, Kumakhov lens and a crystal.

FIG. 49B shows a schematic representation of a differentiation using a source, a first Kumakhov lens, a crystal, a second Kumakhov lens and a detector.

FIG. 50 shows a schematic representation of a system where radiation is passed through a Kumakohov lens and a crystal monochromater (in Laue geometry) to a subject.

FIG. 51A shows a schematic representation of a system where radiation is passed through a Kumakhov lens and reflected off asymetrically cut crystals before entering the subject.

FIG. 51B shows a representation cross-sections of the radiation beam produced taken along planes 1-1, 2-2 and 3-3, respectively.

FIG. 52 shows a top view representation of a section of a collimator.

FIG. 53 shows a schematic representation of a system where radiation from two sources each pass through transmission detectors. The two beams then pass through the subject, crossing at the point of interest, tranverse a collimeter, pass a transmission detector and terminate at a position determinating detector.

FIG. 54 shows a schematic representation of Kumakhov lens, a crystal monochromater in Laue geometry, a subject, a collimeter, and a two-dimensional position sensitive detector.

FIG. 55 shows two graphs of photon count vs. photon energy. The dotted line represents the energy absorption of the line of interest (e.g., an iodine K line). The top graph is for a beam from a monochromater and the bottom graph is for a beam from a Kumakhov lens.

FIG. 56 shows a graph illustrating two peaks generated through a Kumakhov lens. Again, the dotted line represents the absorpotion energy for the line of interest.

FIG. 57 shows a schematic representation of (1) a radiation source, (2) a Kumakhov lens which captures divergent radiation produced by the source, (3) large channels, and (4) small channels (polycapillaries).

FIG. 58 shows a schematic representation of a radiation source emitting in 3 dimensions ($X_o$, $Y_o$, $Z_o$), a Kumakhov lens capturing radiation and emitting the radiator in the direction of a deflector.

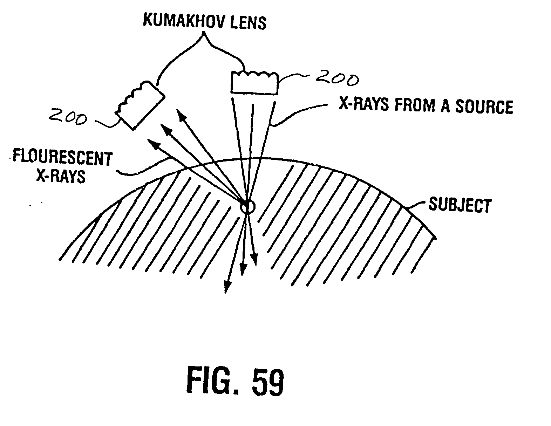

FIG. 59 shows a schematic representation of X-rays passing through a Kumakhov lens on the way to a subject, with deflected fluorescent X-rays being detected by a second Kumakhov lens.

## Detailed Description of the Invention

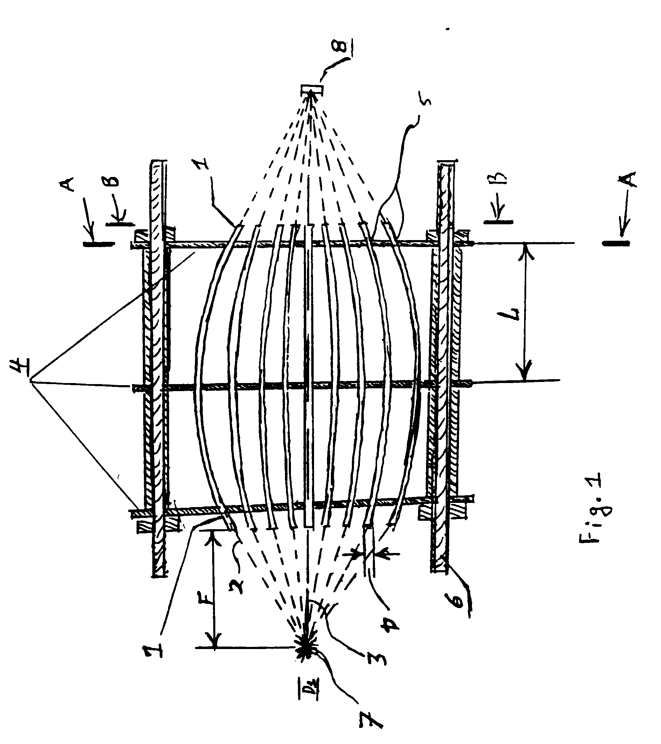

The device (also referred to as a Kumakhov lens) for controlling beams of particles, X-ray and gamma quanta, comprises a plurality of channels with inner surfaces featuring multiple total external reflections. In the embodiment of FIG. 1, the channel-forming elements are bent hollow tubes 1. The longitudinal axes 2 of tubes 1 are located along the generatrices of imaginary barrel-shaped surfaces coaxial to central axis 3 of the controlled beam. The channel-forming elements are rigidly linked to one another by a rigid support structure.

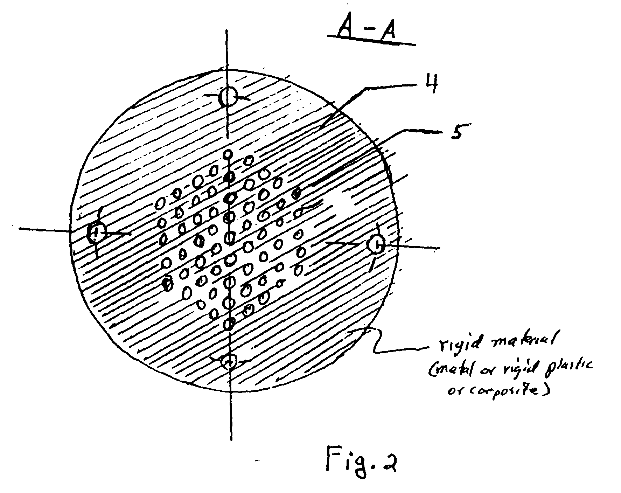

The rigid structure includes discs 4 positioned normal to axis 3 of the controlled beam. These discs are each provided with a honeycomb pattern of apertures 5, for receiving and supporting tubes 1 therein. In the honeycomb pattern, as shown in FIG. 2, each aperture is surrounded by six equally spaced nearest apertures, except for those apertures on the perimeter of the pattern. Other arrangements of apertures are possible, but this is preferred for most applications. The inter-aperture spacing on each disc 4 depends upon the intended axial position of the disc and is chosen so as to rigidly fix the positions of tubes 1 (FIG. 1) along the generatrices of barrel-shaped sur- faces. Discs 4, which are made of rigid material (e.g. metal or rigid plastic or composite), are rigidly linked to one another by frame 6.

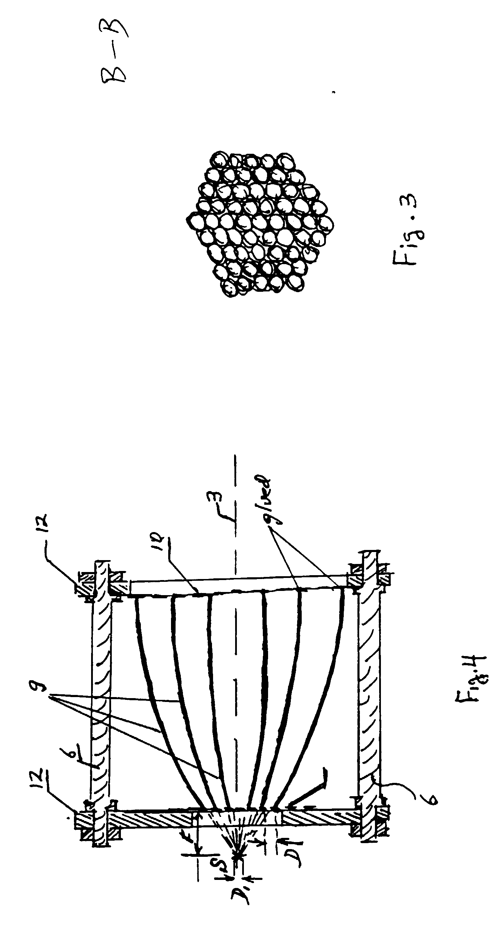

The input butt-ends of bent tubes 1 face radiation source 7, and the output butt-ends are oriented at radiation receiver 8. Both sets of butt-ends are preferably arranged in hexagonal close packed formation, as illustrated in FIG. 3.

Referring again to FIG. 1, in accordance with the present invention, the radial width D of each channel (the diameter of tube 1 at the input butt-end) is defined as:

$$D_1 \leq 2\theta_D F + D$$

where $D_1$ is the effective diameter of radiation source 7;

$\theta_D$ is the minimum critical angle of total external reflection in the spectral band specified; and
F is the distance from radiation source 7 to the input butt-end of tubes 1 measured along central axis 3.

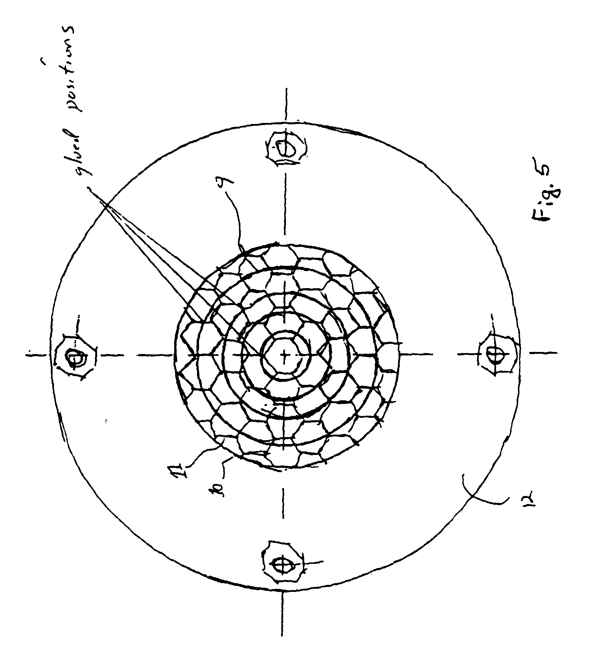

FIG. 4 depicts another embodiment of the present invention, wherein channels are formed by gaps between barrel-shaped beam reflective layers or envelopes 9, coaxial to the controlled beam axis 3. The rigid support structure comprises at least two grids 10 having, for example, honeycomb arrays of cells 11 (FIG. 5), positioned at the input and output butt-ends of the channels normal to controlled radiation beam axis 3. The rigid support member can be in shapes other than honeycomb, but should be carefully chosen as the blocked conditions can form an undesirable pattern in the beam. Envelopes 9 are rigidly fixed in space by being fitted to grids 10 by their butt-ends (for instance, by gluing), and grids 10 are fitted to support rings 12 which, in turn, are rigidly linked to one another by frame 6, as shown in FIG. 4.

The radial width D of each channel in this embodiment is defined by the distance between two adjacent envelopes in the radial direction at the butt-end plane, as shown in FIG. 4.

Referring again now to embodiments in which bent tubes serve as the channel forming elements, to improve the filling factor of the input cross section by tube 1 (FIG. 1) channels, the cross section of each of tubes 1 can advantageously be made triangular, rectangular, hexagonal or of other shape at which the filling factor of the device input cross section is maximal. The rigid support member may be in a shape other than honeycomb, but should be carefully chosen since blocked radiation can form an undesirable pattern in the beam.

With uniformly bent tubes 1 with a channel of D size, even an originally parallel radiation beam injected into tube 1 is incident on the channel walls at angles ranging from zero to $\theta_{max}$, where $\theta_{max} = (2D/R)^{1/2}$, R being the radius of tube 1 bend, so that each specific type and energy level of radiation features a so-called critical bending radius $R_1 = 2D/\theta^2_D$, below which the capture efficiency falls off proportional to $R/R_1$.

In case of rectangular channels, this decay is linear; with cylindrical channels it follows a more complex law. In beam control devices local bends due to tube sagging under their own weight should be limited to $R > R_1$.

It is preferable to position discs 4 with honeycomb pattern located apertures 5 fixing bent tubes 1 along the controlled beam axis 3 with a spacing of supports of $L \leq (12EI/QU_1)^{1/2}$, where E is the elastic modulus of tubes 1, I is the moment of inertia of tube cross section relative to its neutral axis, Q is tube weight per unit length and $R_1$ is the critical bend radius of tubes 1, as defined by the high-energy boundary of the radiation. With such a positioning of discs 4, additional bending of tubes 1 under their own weight will not exceed a value required to retain total filling of the channels of tubes 1 by the radiation being transferred.

Expansion of the operating spectral range of devices of this invention and their application to control neutron beams are related to the reduced critical angle of total external reflection and, correspondingly, to the necessity of reducing the diameter of tubes 1. At tube diameters below 100 µm, device assembly procedures become rather complicated.

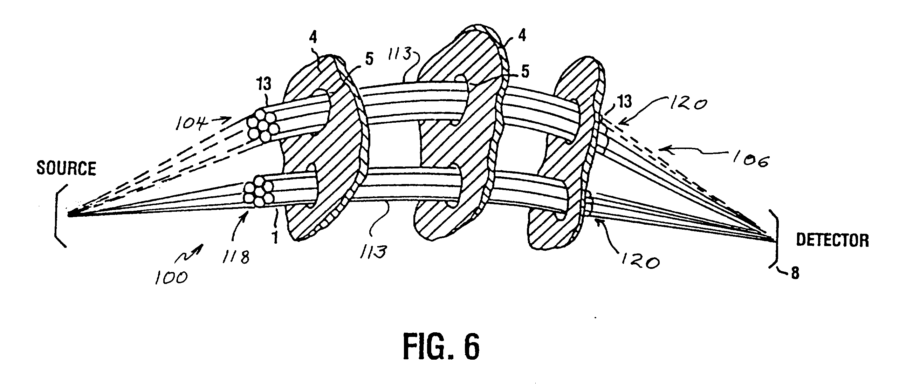

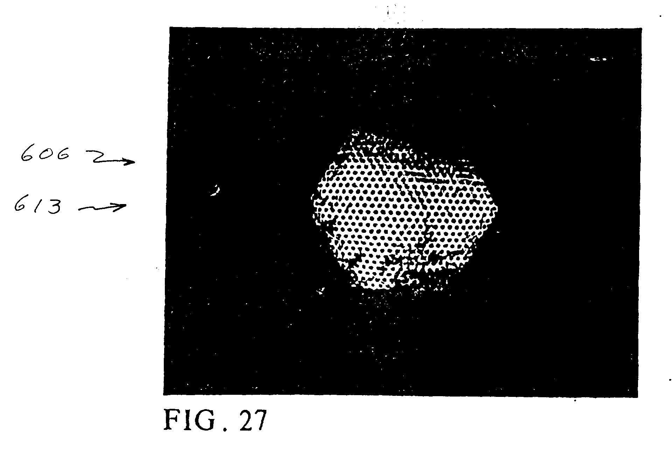

In the case of tubular channel-forming elements, it is advantageous to fabricate each tube 1 as a plurality of interconnected capillaries 13, with a smooth reflecting surface providing multiple total external reflections (FIG. 6 and FIG. 27). With this construction, the effective channel diameter can be reduced by several orders of magnitude. This facilitates operating spectral band expansion to the region of higher energies, and allows smaller bend radii of tubes 1 due to critical bend radius being here determined by the diameter of capillary channel 13, rather than by that of tube 1. Thus, the channel diameter may be reduced to sub-micron dimensions and the number of channels enlarged by several orders of magnitude, whereas the labor consumption of assembling the device is determined by the number of such multi-capillary tubes and is, therefore, retained at the level of the original tubular design.

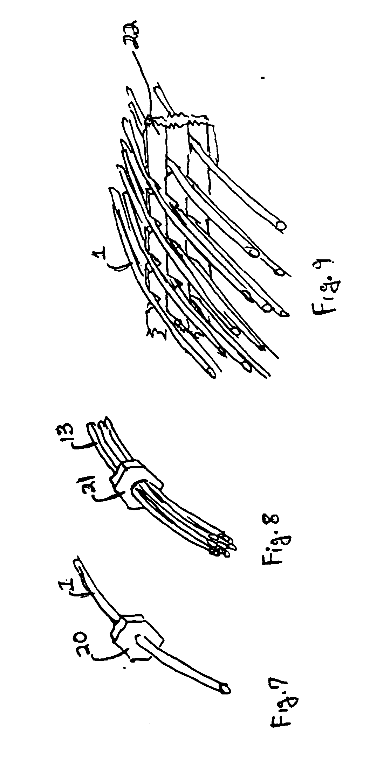

In embodiments where the plurality of channels is designed with bent tubes 1 (FIG. 1), with the longitudinal axes thereof positioned along generatrices of imaginary coaxial barrel-shaped surfaces, the rigid honeycomb structure may be implemented with bushings 20 encompassing each bent tube 1 in a plane normal to the controlled beam axis, as depicted in FIG. 7. The bushings are rigidly linked to one another such as by adhesive or interlocking mechanisms, or clamping mechanisms.

Similarly, where the plurality of channels is embodied with capillaries 13 (FIG. 6) grouped into separate bundles, the longitudinal axes of which are positioned along generatrices of imaginary coaxial barrel-shaped surfaces, the rigid honeycomb structure may be in the form of bushings 21 (FIG. 8) enclosing each bundle of capillaries 13 in a plane normal to the controlled beam axis. Again, with the bushings rigidly linked to one another such as with adhesive or a bandage brace to form a yoke.

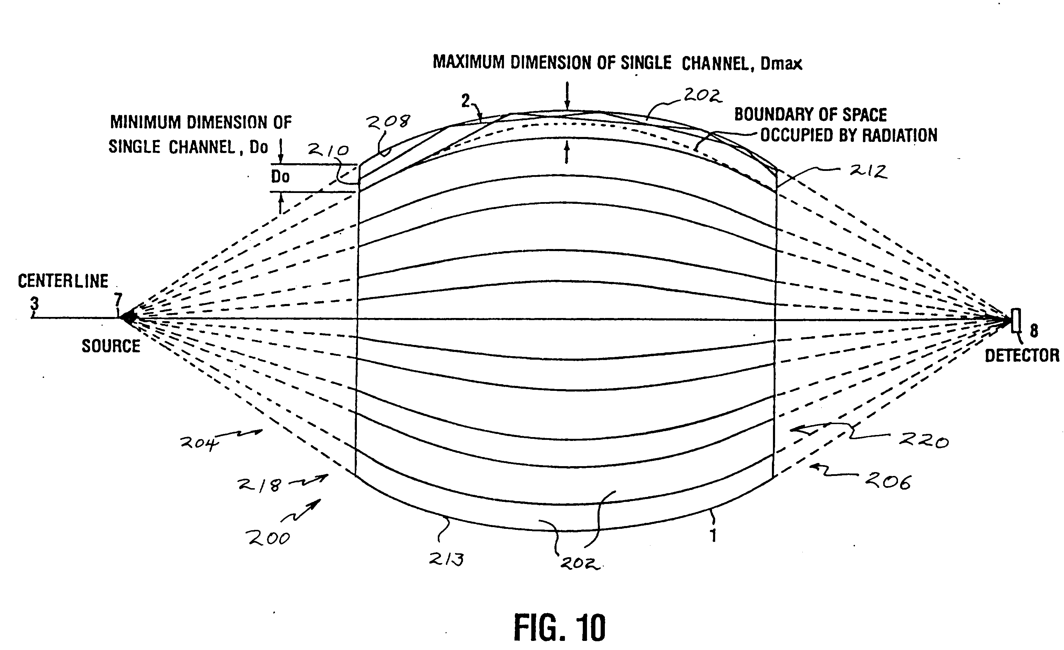

Alternatively, tubes 1 (or bundles of capillaries 13) may be supported in desired position with rigidity secured stacked cradle members 22, as shown in FIG. 9.

In the case of tubular channels, when it is desired to simplify assembly procedures, reduce the channel diameter in tubes 1 to a practicable minimum, and reduce the size of the beam concentration area, thus increasing the beam density in this area, the rigid honeycomb structure may be formed by the walls of tubes 1 rigidly fitted to one another by their external surfaces. This invention envisions fabrication of such a device with thermoplastic tubes such as glass tubes (FIG. 10). This provides a variable channel width along the tube length from $D_o$ at tube 1 butt-ends to $D_{max}$ at their middle sections, which, in this embodiment, is proportional to the diameter of the corresponding given tube barrel-shaped surface in each cross section of the latter. Under these conditions, the critical bend radius of tubes 1 is defined by the input diameter $D_o$, because the incomplete filling of the channel cross section with the radiation being transferred between the device butt-ends is not critical in terms of transfer efficiency.

In the preferred embodiment depicted in FIG. 10, each tube 1 is bent along a curve approximating a circle arc, so that the radiation captured by its thin end at the device input is transferred via a flaring out and then, if necessary, tapering off channel by reflections from only a wall with positive Gaussian curvature and never arriving at the opposite wall, therefore retaining the range of grazing angles acquired at the device input till it arrives at the output, where, according to this invention, the diameter of tubes 1 is at least the input diameter $D_o$, because in the opposite case it becomes impossible to avoid reflections from the opposite wall, leading to additional radiation losses due to the grazing angle exceeding the critical angle $\theta_D$ of total external reflections.

The device of this invention can be used to shape quasi-parallel radiation beams for such applications as long-haul energy transmission (for instance, data transmission), transmission of images of the objects being irradiated without geometric distortions, and Bragg radiation monochromatization with the aid of planar crystals. In a number of cases (for instance, in X-ray lithography), the radiation beam is required to be highly homogeneous and highly parallel. However, quasi-parallel beams shaped by multiple total external reflections in tubular systems exhibit non-uniform radiation distribution across the beam cross section due to the discrete nature of radiation transfer via separate tubes 1 (microinhomogeneity), with intensity falling off from the beam center to its edges due to a lower efficiency of radiation transfer at a higher curvature of tubes 1 (macroinhomogeneity).

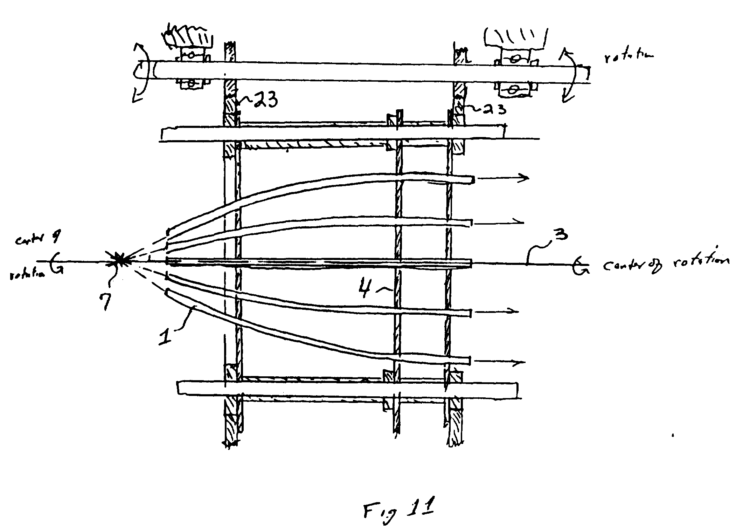

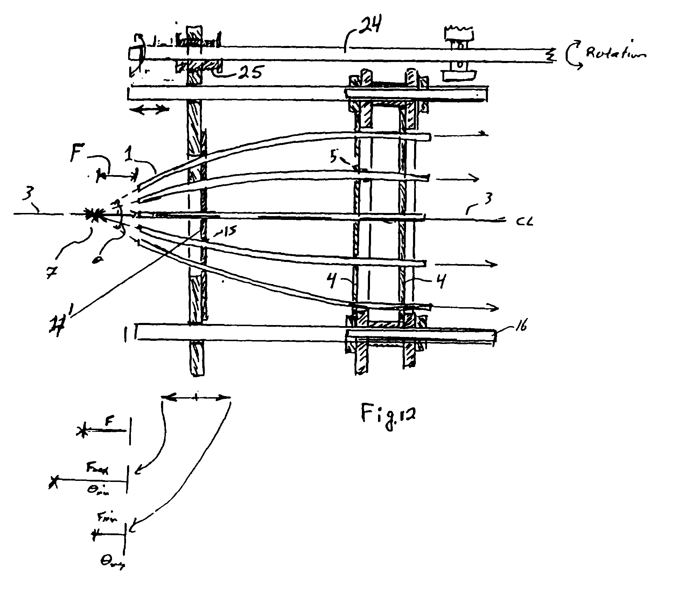

In cases when the inhomogeneity of the beam caused by discrete radiation transfer via a plurality of channels is critical, the rigid honeycomb structure, according to this invention, may be mounted rotatable around the controlled beam axis 3, so that the beam intensity can be equalized by averaging over the exposure time. This rotation can be accomplished, for example, with an externally driven circumferential gear set 23 as shown in FIG. 11, and can be used to shape quasi-parallel beams, for instance in X-ray lithography applications.

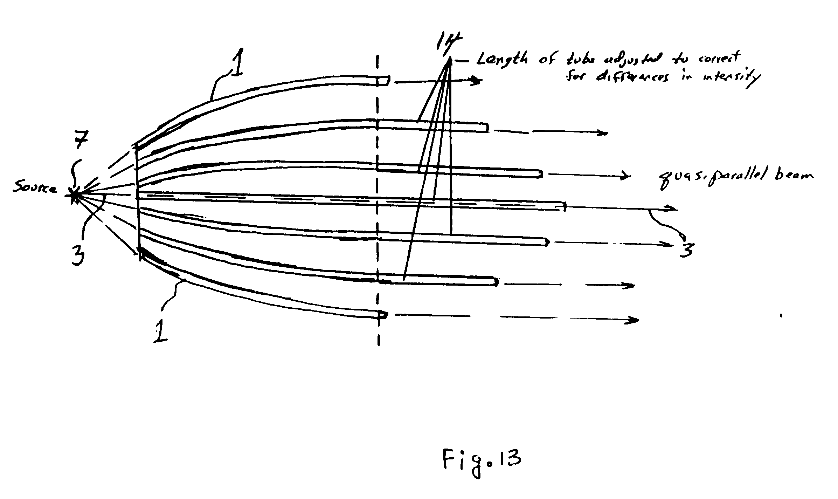

FIG. 12 illustrates an embodiment of the invention in which a support disc 4' near the input butt-ends of tubes 1 is axially translatable. A rod 24 acting through a worm gear mechanism 25 is employed to selectively translate disc 4' relative to stationary discs 4. Translation of disc 4' towards the input butt-ends serves to increase the focal length F and simultaneously decrease the capture angle $\theta$. Movement in the opposite direction has the converse effect. This construction also allows for tuning of the transmission energy bandwidth and spectrum.

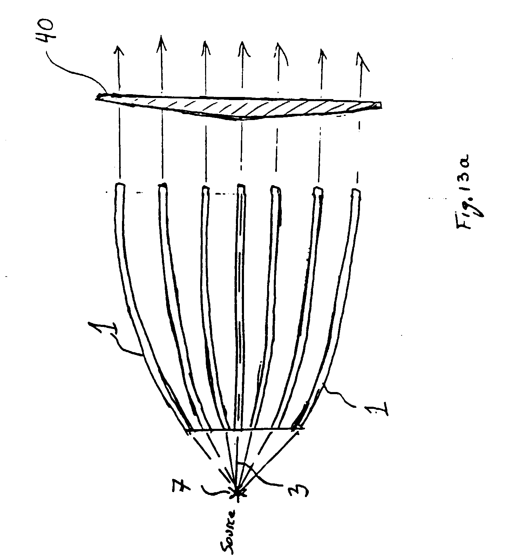

With longitudinal axes of tube 1 channels oriented parallel to one another at the output, output beam irregularities caused by radiation transfer efficiency variations due to beam travel via channels of different curvature may be smoothed out by extending the channel output butt-ends with rectilinear sections 14 (FIG. 13) of uniform cross section along their entire length. The lengths of the rectilinear sections 14 being selected according to the required attenuation of the beam intensity in each area of the shaped beam cross section. In this case a reduced intensity at the center of the quasi-parallel beam is provided by additional radiation absorption in elongated tubes 1. Tubes 1 butt-ends can also be distributed non-uniformly at the output with a pitch falling off from the center to the periphery in accordance with the required intensity distribution. Another possibility envisaged is positioning an absorbing filter 40 (FIG. 13a) in the beam path, with a density or thickness falling off from its center to its periphery in accordance with the original non-uniformity of the shaped beam. Such a filter can be produced, for instance, by lithography by exposing a resist, selected according to the type of radiation, to the shaped quasi-parallel beam.

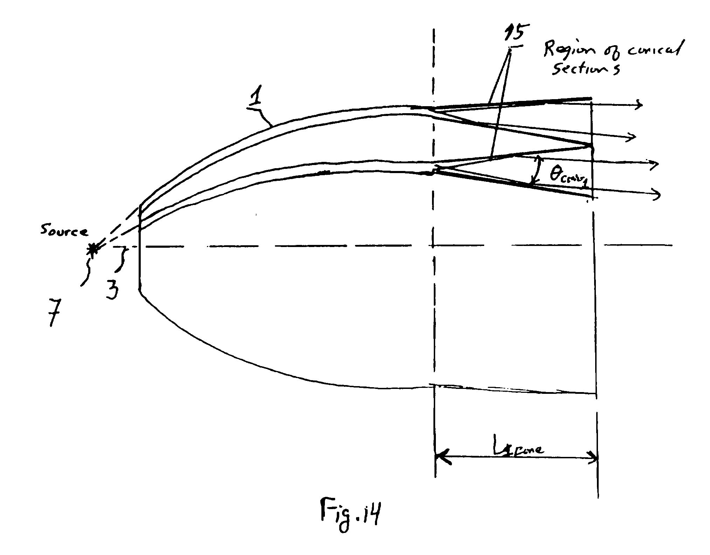

Divergence of the radiation from individual channels which are forming the shaped beam does not exceed the critical angle $\theta_D$ of total external reflection. If decreased divergence is necessary, it may be achieved by providing supplementary flaring out conical sections 15 (FIG. 14) of tubes 1 at the output, with the taper angle $\theta_1 < \theta - D/L_1$, where $\theta$ is the required divergence angle of the quasi-parallel beam and $L_1$ is the length of conical sections 15. Beam travel via a flaring out channel reduces beam divergence down to the taper angle.

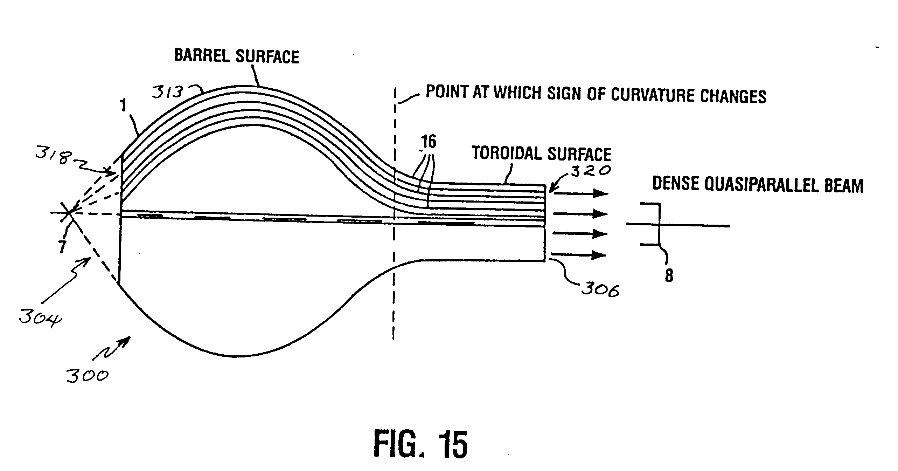

Using uniformly bent tubes 1 to shape quasi-parallel beams does not allow the output butt-ends of tubes 1 to be positioned with spacings, approximating those of the input butt-ends and, therefore, it is suitable to produce a quasi-parallel beam by extending the output butt-ends with sections 16 (FIG. 15) located along generatrices of imaginary toroidal surfaces, conjugate with the original barrel-shaped surfaces, and by orienting the output butt-ends of sections 16 at the radiation receiver. In this case, separate parts of the quasi-parallel beam are brought together, thus increasing the density of the output quasi-parallel radiation beam. The channel forming members may be located along generatrices of coaxial surfaces having other compound curvatures, if desired.

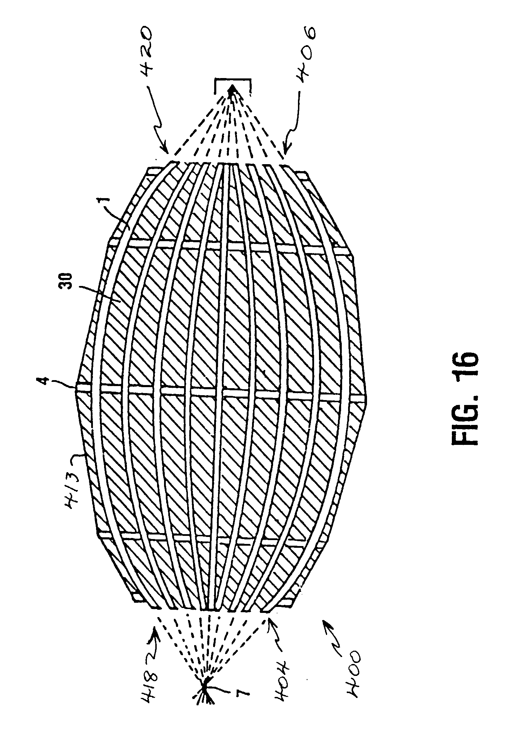

Devices with tubular channels can be designed with a rigid honeycomb structure of solidifying material 30 (FIG. 16) filling the gaps between tubes 1 and between discs 4. In certain applications, it may be possible to remove discs 4 completely and simply rely on the solidifying material to provide the desired support for tubes 1. Such a design arrangement is suitable for devices with a large number of thin tubes 1, since it is simpler in assembly, for instance with a porous polymer used as the solidifying material to fix parallel positioned tubes and forming the barrel shape by compressing inside a barrel-shaped casing. This design configuration can be considerably lighter due to the absence of supporting superstructure, and this may be important, for instance, when designing X-ray telescopes for use in space.

Rigid and precise fixing of channel-forming elements, e.g. tubes 1 in discs 4 with honeycomb pattern positioned apertures 5, provides location of uniformly bent sections of channel-forming elements with a precise aiming of the channel input and output butt-ends at the source 7 and receiver 8 of the radiation, respectively. Meeting the condition $D_1 \leq 2\theta F + D$ ensures radiation incidence from any point of source 7 onto the channel walls at a grazing angle less than $\theta_D$, thus ensuring total external reflection of the radiation captured in the channel. A strictly fixed uniform bend of the channels facilitates retaining the radiation grazing angle relative to the channel walls and effective transfer of this radiation from the channel input to its output and its direction at radiation receiver 8.

It is proposed to concentrate parallel radiation beams with the aid of the herein above described quasi-parallel beam shapers by simply reversing the direction thereof, such that the previously described "output" butt-ends are aimed at the original parallel beam and the former "input" butt-ends are directed at the focal point.

Radiation monochromatization can be achieved by placing a crystal with planes at the Bragg angle relative to the quasi-parallel beam.

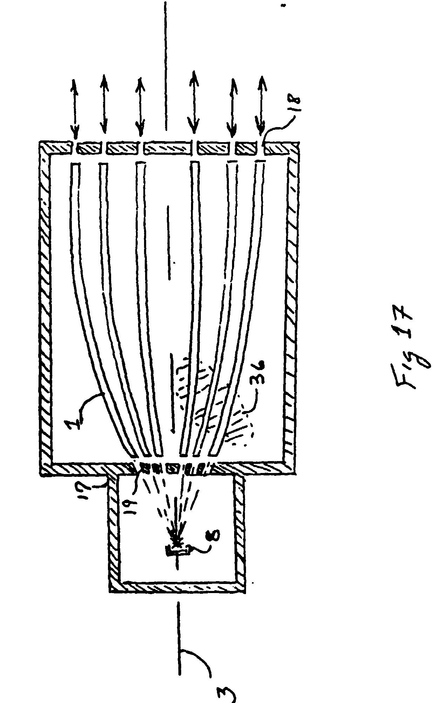

In case of inadmissible high background radiation it is preferable, as illustrated in FIG. 17, to enclose the entire beam controlling device (support structure not shown), along with the radiation receiver 8 (or source 7), inside an external screening casing 17 of a material opaque to the controlled radiation, with apertures 18 and 19 aligned with the axes of the channels at the input and output butt-ends, respectively. In this embodiment, the channel forming element along central axis 3 may be either omitted or blocked, and the gaps between tubes 1 filled with radiation absorbing or blocking material 36, so that no straight line paths to receiver 8 are available for transmission of unwanted background radiation.

The device for controlling beams of gamma, X-rays and particles is essentially a system of specifically oriented reflecting surfaces. Based on the total multiple internal reflections effect, the device allows transformation of diverging radiation from an isotropic source into a quasi-parallel beam, and also its focusing. The device may be designed as a bundle of bent glass tubes, or as a system or superimposed coaxial "barrel-shaped" reflecting surfaces.

The device provides control of gamma and X-ray radiation with the energy ranging from $1 \times 10^2$ eV to $1 \times 10^7$ eV, at radiation capture angles from an isotropic source ranging from a hundredth to several tens of degrees, depending on the radiation energy. The divergence of a quasi-parallel beam does not exceed the critical reflection angle, and can be as small as $10^{-4}$ radians. When used to focus the radiation, the concentration of gamma, X-rays or particles in the focal spot can be tens of thousands of times higher than would be the intensity at that position without the focusing optics. The focal spot diameter is limited by the diameter of the focusing tubes and can be as small as $10^{-8}$ cm.

This device may be used to create qualitatively novel instruments for a wide range of scientific and engineering applications.

Embodiments employing a system of layers of bent tubes feature channels of identical length in a given layer with channel lengths in adjacent layers chosen to provide similar transmission characteristics. Furthermore, these X-ray waveguides and particle guides are oriented relative to the incident radiation, so that the beam grazing angle at the channel walls does not exceed the angle of total external reflection. The number of reflections of the beam from the guide increases with the distance from the beam central axis, resulting in the beam being turned by a wide angle. These features facilitate beam focusing and larger beam capture angles.

The device design is simplified and the accuracy of its assembling is improved by supplementing the system with discs (or other equivalent supporting structures), the apertures of which accommodate the tube radiation guides, with the distance between these discs and the lengths of the free X-ray waveguide ends being subject to the previously described restrictive conditions.

Transition from the system designed with a bundle of radiation guides to a system comprising a plurality of superimposed second order surfaces separated by gaps provides a design, better adapted to streamlined production, with lower assembling and production labor requirements. Furthermore, this design allows producing focal spots of smaller size and reduces beam energy losses during radiation transmission via the system.

Making the system elongated and contracted at the side opposite to the radiation source, and ensuring that the tangent to the second order surface at the inflection point is at an angle less than the critical reflection angle allows the density of quasi-parallel beams to be substantially increased.

Such design embodiments of the device are equally effective in providing radiation beam control- capabilities and can be used to design competitive instruments and equipment.

One of the most important sources of high-energy photons is a synchrotron. Synchrotron radiation is radiation emitted when charged particles are accelerated by deflection in a curved path. The energy of the radiation depends on the electron or positron energy and the radius of bending. In general, synchrotron sources are designed to produce radiation in the vacuum ultra violet range and X-ray range of the spectrum. Although the Kumakhov Lens can in principle operate with photon energy as low as 0.1 keV (X-100Å), they are primarily designed for higher energy photons in the range from 0.5 keV to 1 Mev ($\lambda$-0.01Å). The Kumakhov lens also works with some types of particles, but the synchrotron is not a source of particles. The primary interest in this radiation source is the very high intensity and broad and continuous energy range possible. The X-ray intensity is determined by the number (current) of electrons (or positrons) circulating in the storage ring and the radius of curvature of the deflection. Both the photon intensity and energy are enhanced by the use of wigglers or undulators which cause the beam to oscillate in the vertical plane with a small amplitude and high frequency by the use of periodic magnetic electrostatic fields of alternating sign. The photon energy spread is continuous from very low energy (visible) up to a maximum.

The radiation from a synchrotron is in the form of a fan of photons from each sharp bend in the particle storage ring. The height of the fan is normally 0.5-2mm. The width of the fan may be several degrees. For example, on the National Synchrotron Light Source the width of the fan at each position is 6 degrees -- so from each port through a thin beryllium window emerges a fan of 6° x 1mm wide; highly parallel in the vertical direction -- divergent in the horizontal direction. In order to use this radiation as efficiently as possible -- several beam lines are crowded into this narrow angular range, each capturing a degree or so of the radiation fan. The limitation in use of the radiation is often physical space to allow the beam monochromators, deflection mirrors, and equipment to exist within the 6° wedge. To gain space, the beam lines often become very long -- with resultant decrease of beam intensity because of the horizontal divergence.

A non-coaxial lens may be used with point sources and coaxial lenses and non-coaxial lenses used with parallel sources (e.g., a synchrotron), quasi-parallel sources, and extended sources, together with the sources, stated above. However, this technology is in no way limited to coaxial lenses used with point sources. For synchrotrons, the input end of the lens device usually needs to be aligned with the direction of the X-rays entering them, whereas with a point source all channels are oriented towards a point, with a parallel beam the input ends will normally be parallel. And for a dispersed source which is isotropically divergent from each point, the input channels can be parallel, oriented at a single point on the source, or any angle in between.

Synchrotron beams diverge in the horizontal plane (e.g., National Synchrotron Light Source X17 wiggler beam has a divergence of 5 mrad). A Kumakhov lens makes. it possible to transform a divergent beam into a quasi-parallel one. Parallelism may be obtained on about $0.1\theta_{cr}$, where $\theta_{cr}$ is the critical reflection angle (i.e., we may obtain a divergence of 0.1 mrad on a glass C-52 lens for 30 keV photons. In one example initial beam losses will be about 30 - 40%.

The suggested optics can effectively focus synchrotron radiation beams into a very small spot, eventually less than about 1 micron will be possible. The intensity in such a small spot may be increased by greater than about $10^4$.

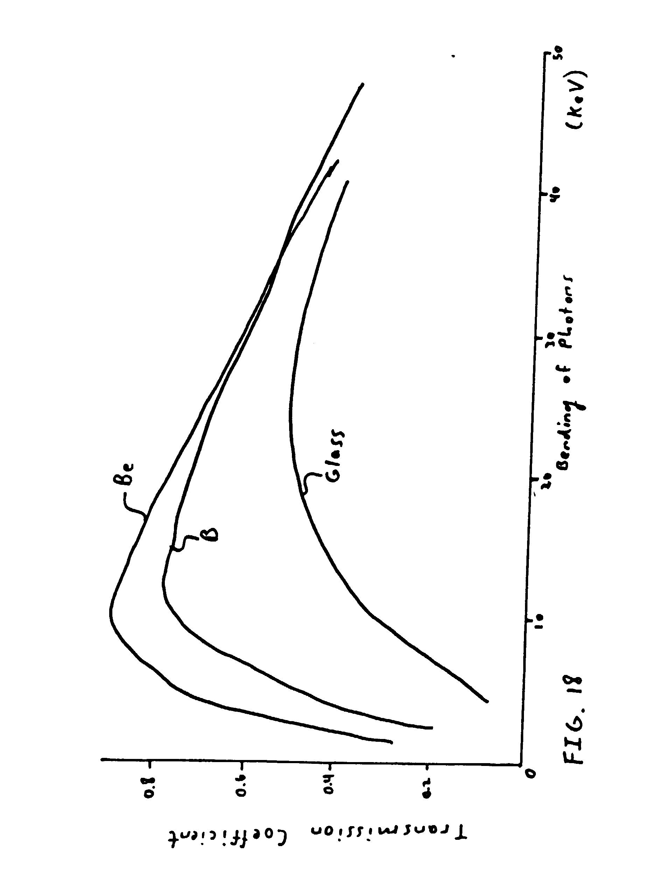

Capillary optics allow turning of high energy photons through large angles. Fig. 18 shows the dependence of transmission coefficients for photons turning 90° for different materials and for a range of energies. It can be seen that 10 - 30 keV photons may be turned with only a 30% intensity loss. Such a high efficiency is connected with the high reflectivity of the capillaries' inner surface.

Synchrotron beams have a small cross section and low divergence. Typically a beam might start out at about 0.5 mm x 0.5 mrad and even less. This makes it possible to obtain wide beams with an exceptionally small divergence using Kumakhov lenses (e.g., if we need to transform a synchrotron radiation beam into a parallel beam with the size L, using the Louiville theorem we may in principle obtain divergence θ, established from the formula $I_o\theta_o = L\theta$. If $I_o\theta_o$ = 0.25 mm x mrad and L ≈ 10 cm, θ = 2.5 x 10$^{-6}$ rad.

In order to obtain supercollimated synchrotron beams, the ends of the channels have to be tapered out, getting wider.

Filtering out high energy photons or high energy particles is extremely difficult using conventional equipment and is a common problem for many applications and a wide variety of source types. For parallel beams such as synchrotrons a monochromatic beam can be obtained by using a crystal-monochromator. However, higher energy harmonics appear which are extremely difficult to remove.

One of the useful features of the Kumakhov lens is its ability to transmit a broad band of photon and particle energies. On the other hand, the energies transmitted can be controlled and this control can be used for a variety of applications. The control can result from selective absorption by choice of the lens materials, and selective transmission by selection of the lens design parameters. This control is possible for photons and particles such as neutrons. The examples discussed herein will be for X-rays.

Control of the spacing of the lens elements (for lenses made from capillaries of circular cross section this will be the capillary inside diameter) and the curvature of lens elements also provide control of the transmission band width. In general, small spacing and large curvature increases the transmission of high energy photons, and large spacing and small radius of curvature enhances the transmission of low energy photons. In general, the transmission is optimized when the dimensionless parameter

$\gamma \geq 1.00$ when

$$\gamma = \frac{R\,(\theta_{cr})^2}{2D}$$

where R is the radius of curvature of the lens element, $\theta_{cr}$ is the critical angle of total external reflection and D is the channel width of the individual capillary for a capillary based lens. The effective transmission band width can be as small as a few keV by choice of the materials and parameters, but is usually greater than about 10-20 keV. Selection of the energy band width to eliminate background due to low energy photon electron multiple scattering or Compton scattering or thermal diffuse scattering of high energy photons can be advantageous for many applications.

By selecting the material making up the interior surface of the lens elements the photon energies transmitted can be controlled. For example, a copper coating will transmit photons from about 0.6 to 1 keV and about 6 to 10 keV. In general, low energy photons are selectively absorbed although a coating with beryllium will give efficient transmission down to photon energies as low as 100 eV.

Glass capillaries possess a very good inner surface and their reflection coefficient is very high at angles $\leq \theta_{cr}$. (e. g., at E= 30 keV ($\theta_{cr}$ = 1.11 x 10$^{-3}$ rad) the single reflection coefficient $R_1$ = 0.995 if $\theta_{incid}$ = 10$^{-3}$ rad, which is noticeably higher than the reflection coefficient of polished surfaces. At the same time at $\theta \geq \theta_{cr}$, the reflection coefficient sharply decreases (e.g., at $\theta_{incid}$ = 1.1 x 10$^{-3}$, $R_1$ = 0.987, and at $\theta_{incid}$ = 1.2 x 10$^{-3}$, $R_1$ has already decreased to 0.2. That means a 10% change in the incidence angle leads to a nearly 5 times decrease in the reflection coefficient).

This phenomenon of sharp reduction of $R_1$ near $\theta_{cr}$ may be very effectively used for filtering if photons make several reflections. But in order to be able to filter selectively using this technique the beam must have a very small divergence. This very condition characterizes synchrotron radiation (e.g., vertical beam divergence in the NSLS is near 10$^{-4}$ rad).

Table 1 lists calculated high energy filtering for E=30 and 33 keV.

TABLE 1

| N = number of reflections; $R^N$ = reflection coefficient $\gamma$ = ratio $R^N$(30 kev)/$R^N$(33 keV) | | | |
|---|---|---|---|
| N | 1 | 5 | 10 |
| $R^N$ (30 keV) | 0.984 | 0.92 | 0.85 |
| $R^N$ (33 keV) | 0.3 | 2.7 x 10$^{-3}$ | 5.0 x 10$^{-6}$ |
| $\gamma$ | 3.28 | 383 | 1.44 x 10$^5$ |

As it is clear from the table, after 10 reflections the intensity of 33 keV photons is reduced by over 5 orders of magnitude compared to 30 keV photons. the intensity of 30 keV photons stays practically the same.

It was suggested before calculating this example that the beam enters a straight capillary at an angle of 1.1 x 10$^{-3}$ rad.

This method can be used up to very high energies including the $\gamma$ range.

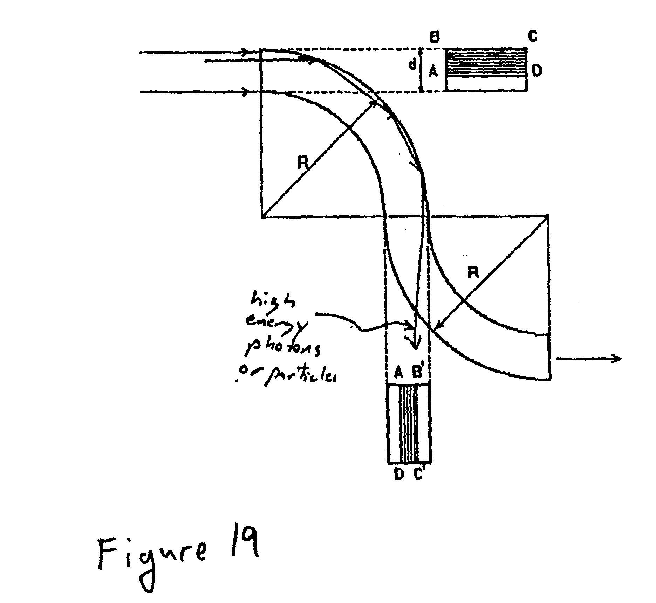

By providing the capillary a special geometry (Fig. 19), near the capillary's inflection point, photons travel from one wall to the other. In order for them to stay in the channel, the entrance angle in relation to this new surface has to be smaller than the critical angle. As high energy photons have small reflection angles, they leave the capillary.

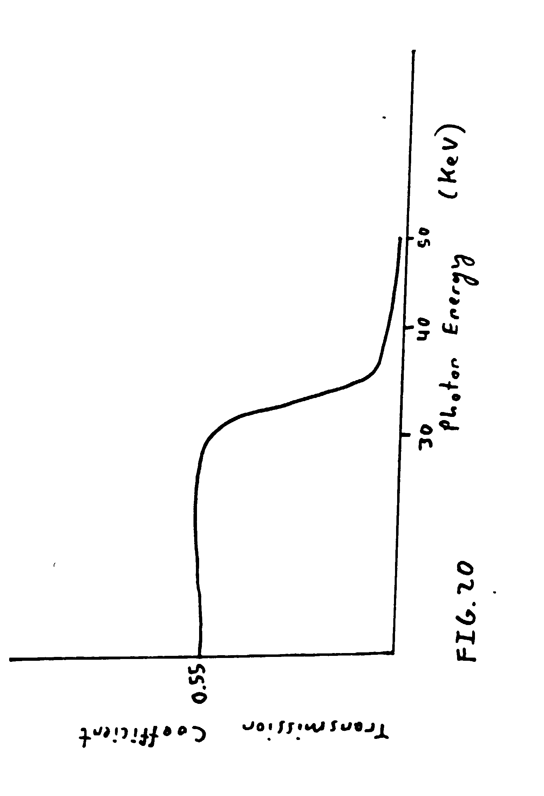

FIG. 20 shows experimental results for a divergent beam from a point source. The transmission of photons with E = 40 keV decreases by an order as compared to photons with E = 33 keV, and the transmission of 50 keV photons is reduced down to 10$^{-4}$.

By changing the capillary's radius of curvature, the filtering border is changed. Decreasing the radii decreases the filtering energy, and vice versa.

The result shown in FIG. 20 is that for the first experiments. By specially shaping the capillary, the sharpness of energy filtering can be increased.

A capture with capillaries at an angle to the beam makes it possible to effectively cut the beam over a very narrow energy range, obtaining two separate beams, one including the energies higher than the selected energy and the other beam including the energies lower than the selected energy. This is possible because many of those photons which strike a surface at an angle larger than the Fresnel angle simply pass through the material. At higher energies only a small percent of the photons are absorbed.

To use this design, the beam must have low divergence. Best results are obtained from using a rectangular capillary or system of rectangular capillaries or flat surfaces.

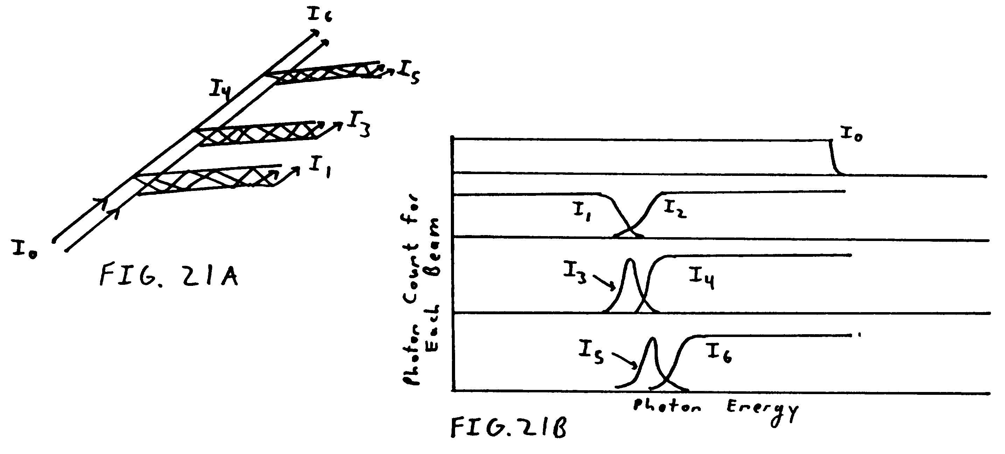

Referring to FIG. 21A, if the initial parallel beam, $I_0$m strikes a surface or capillary opening at an angle $\theta_0$, those photons with a $\theta_{critical} > \theta_0$ are reflected, and those photons with a higher energy and therefore their $\theta_{critical} < \theta_0$ pass through. Therefore, two beams are obtained $I_1$ and $I_2$, with spectral distribution as shown in FIG. 21B.

By using the above technique more than once it is possible to tailor a narrow band width. For example, if beam $I_2$ from FIG. 21A encounters another capillary, flat surface, or capillary system at an angle of incidence, $\theta_1$, slightly less than that of the first surfaces encountered, $\theta_0$, then those photons with $\theta_1 < \theta_{critical} < \theta_0$ will be reflected as beam $I_3$. $I_3$'s spectral distribution is shown in FIG.21B. Similarly, multiple band widths can be selected by continuing the process, e.g. resulting in beam $I_5$ in FIG. 21B. Out of a synchrotron beam it is possible to achieve quasi-monochromatic beams which have a beam width with a ratio of energy width/energy of a few 10$^{-2}$ with only a 50% loss in beam intensity in the energies represented. By using such a tailored band width it is possible to obtain a much higher flux quasi-monochromatic beam than would be in the monochromatic beam obtained from a crystal monochromator. And multiple narrow band width beams can be obtained at desired energies.

Frequently, the photon intensity is so large that absorption of even a small fraction of incident photons will result in heating to temperatures of hundreds of degrees -- sometimes exceeding the melting point of metals and frequently producing large thermal gradients with accompanying mechanical stress and deformation. This effect is particularly serious from absorption in isolating windows, diffracting crystals or deflecting mirrors. To accommodate the large photon flux intensity at the input of a Kumakhov lens, a number of design features can by included.

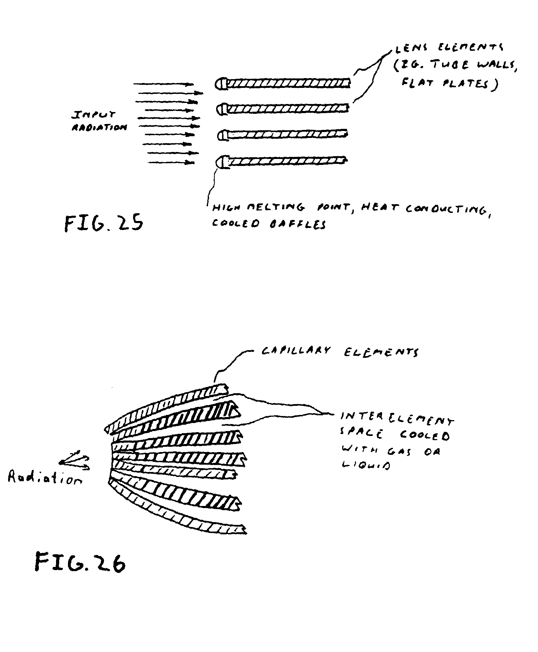

FIG. 25 shows that input baffling baffles may be hollow and cooled with flowing fluid (liquid or gas), or may be solid and cooled by coils on the surface or at the periphery.

By stopping the radiation that would otherwise strike and be stopped by the ends of the lens elements, the lens is kept from heating. The radiation entering the lens elements strike the wall of the lens at different distances from the entrance because of the gentle curvature (less than the critical angle for the total external reflection of the highest energy photons transmitted) and therefore are distributed over a very much larger area than oblique incidence.

The lens itself may be fabricated from high melt temperature glass, ceramic or metal materials. For example, fabrication from pure $SiO_2$ (quartz) will allow temperatures as high as 2000°C before distortion in melting will interfere with photon transmission. The lens elements may also be coated with high melting thermally conducting elemental or compound materials such as tungsten, silicon carbide, carbon, etc.

The lens elements may also be cooled by:

i: surrounding them with solid material of high thermal conductivity which is then cooled by openings in the bulk or the periphery through which liquid gas is passed, or which have specially attached cooling fins of high cross-sectional area; or

ii: passing a fluid (liquid or gas) coolant between the lens elements. It is possible to do this even though the lens is operated in a vacuum since the walls of the lens elements serve as a vacuum barrier (see, FIG. 26);

iii: passing a cooling gas through the lens. This can be done when high energy photons are being transmitted if a cooling gas is chosen such as helium which has high thermal conductivity and low absorption cross section for the transmitted photons.

An important use of a Kumakhov lens is to control the direction and cross-section of a radiation beam. Beam cross-sections can be reshaped to achieve desired cross-sections by designing the surfaces. For example, if capillaries are used it is clearly possible to capture a thin rectangular beam such as might come from a synchrotron and by so orienting the capillaries or capillary bundles (polycapillaries) (see, for example, FIG. 27), emit a square or circular beam. This can be particularly advantageous on the synchrotron if an area with a vertical dimension larger than the vertical dimension of the original beam must be irradiated. A synchrotron beam has been broadened from lmm to a quasi-parallel beam of 6 cm with only a 50% loss of intensity.

The input shape of the transmitting lens can be configured to accommodate the shape of the beam such as the photon beam emerging from the synchrotron. For the synchrotron this shape will in general be asymmetric because of the tangential emission from the particle storage ring and the fan shape of the radiation field, but it can be any arbitrary shape to accommodate the beam coming from the source.

It is even possible to deflect the beam through angles of 90° or larger in order to, for example, irradiate vertical targets instead of having to irradiate horizontal targets.

As it is possible to turn beams, it is also possible to split beams and separate the beams. This has been experimentally demonstrated.

Because in certain embodiments of the Kumakhov lens, some of the portions of the beam are turned through larger angles than others or are turned on smaller radii than other sections of the beam, these portions of the beam may have higher losses. Methods for controlling intensity across the beam cross-section (usually to obtain uniform intensity) already discussed include variable filtering and selectively extending the lengths of some channels to increase losses in that portion of the beam. The drawbacks to both of these methods is that control of intensity is obtained by increasing losses, i.e., decreasing photon intensity thereby decreasing the efficiency of the lens. A method of controlling intensity across the beam which does not suffer from this drawback is modifying the spacing between channels, so the spacing is larger where intensity should be decreased and smaller where intensity should be increased. In this way photons are redistributed rather than filtered out. The drawback of this method is that microhomogeneity is decreased.

Many types of sources are subject to spatial instability, including synchrotron beams which are subject to certain fluctuations. A Kumakhov lens can capture radiation from an area which may exceed the size of the source. Therefore, small shifts of the source's location do not practically affect the intensity, parallelism, and uniformity of the photon beam which comes from the Kumakhov lens. This makes it possible to stabilize the source's spatial location.

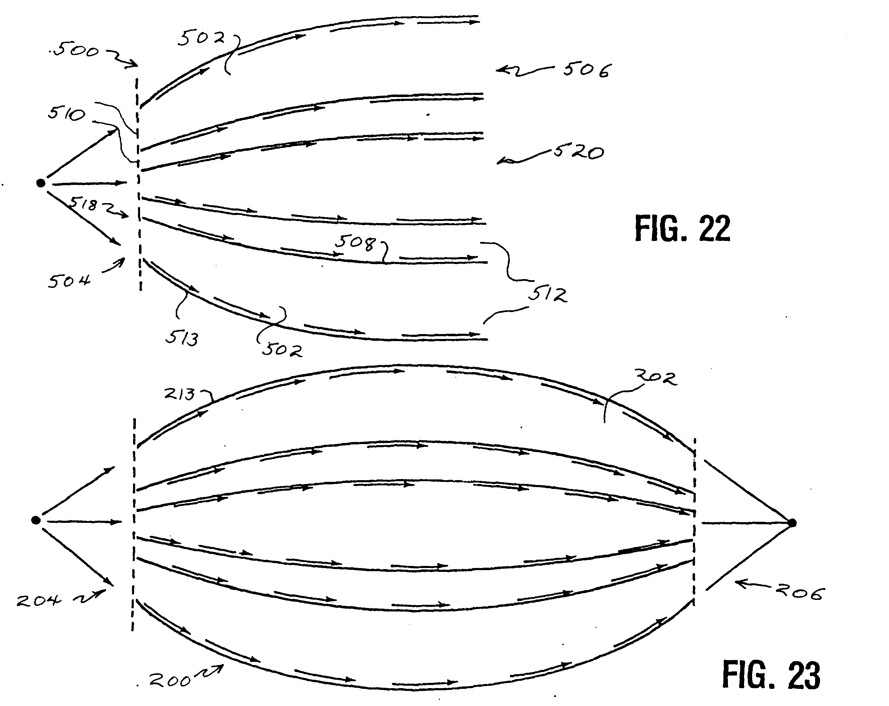

In order to obtain small divergence it is possible to use barrel-shaped capillaries with their size diminishing towards their entrance end. (FIG. 22). In this case if the source's size is small enough and the channel's curvature radius is great enough we may obtain at the exit a divergence much smaller than the critical reflection angle.

To obtain a small focal spot, the lens may be converged (FIG. 23).

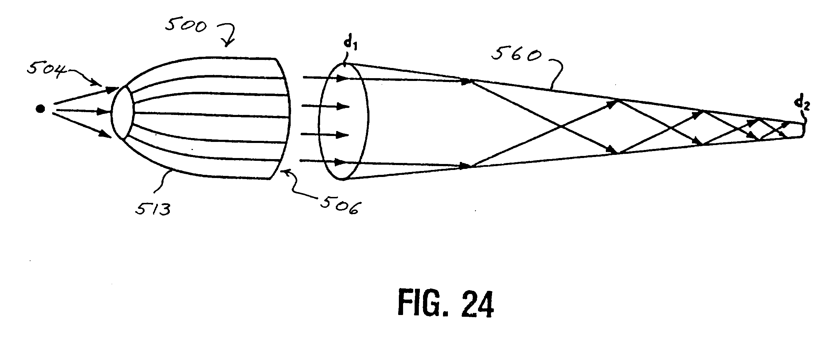

To obtain high intensity radiation from a divergent source we may use the geometry shown in FIG. 24. A half-barrel is located after the source, it transforms divergent radiation into a quasi-parallel beam, then there is a cone-shaped capillary. If the divergence after the half-barrel equals $\theta_1$, the ratio between the larger end diameter $d_1$ to the smaller one $d_2$ may be of the order of:

$$\frac{d_1}{d_2} \approx \frac{\theta_{cr}}{\theta_1}$$

where $\theta_{cr}$ is the complete external reflection (CER) angle. The minimum dimension of $d_1$ for X-ray photons is limited by diffraction and is - c/wp (c is light speed, wp is plasmal frequency), i.e. about 100 Å. For ions, this dimension may be brought down to atomic sizes.

Channel cross-sections need not be circular. For example, channels for tailoring narrow energy width beams often have a flat side and may be rectangular. Capillaries, capillary bundles, and individual channels in polycapillaries are often not circular as other shapes such as hexagonal, rectangular, and triangular can provide more efficient packing leading to higher open area in the lens cross section and to higher strength.

Lenses for controlling ions are most effective if the material the channels are formed from or a coating of the channels is electrically conducting so that an electrostatic space charge will not be built up which will electrically repel the ions. And surface finishes are especially critical.

For controlling neutrons, the surface of the channels should be selected so there are no materials which have a high absorption cross-section for neutrons. For example, glass capillaries containing boron have an extremely low efficiency for neutrons.

Kumakhov lenses can be designed to serve many functions simultaneously. For example, a single lens might capture divergent radiation and form a quasi-parallel beam as well as selectively filter the photon energies, and compensate for higher losses in the outer channels.

Kumakhov lenses utilize the specular reflection of X-rays from smooth surfaces for incidence angles smaller than the critical external reflection (CER) angle (of the order of $10^{-3}$ radians, depending on the wavelength). Closely spaced multiple surfaces act as a waveguide for the X-rays.

A Kumakhov lens may be used for X-ray lithography by placing a lens between the X-ray source and the mask-wafer combination to provide control over beam shape, intensity, direction, and energy distribution. The Kumakhov lens controls X-ray beams by multiple reflections along very smooth boundaries of condensed media which have special shapes which ensure that a sufficient portion of the beam never makes a reflection at an angle larger than the critical angle of total external reflection. Use of windows and choice of vacuum or gaseous medium for the system or portions of the system is consistent with this invention.

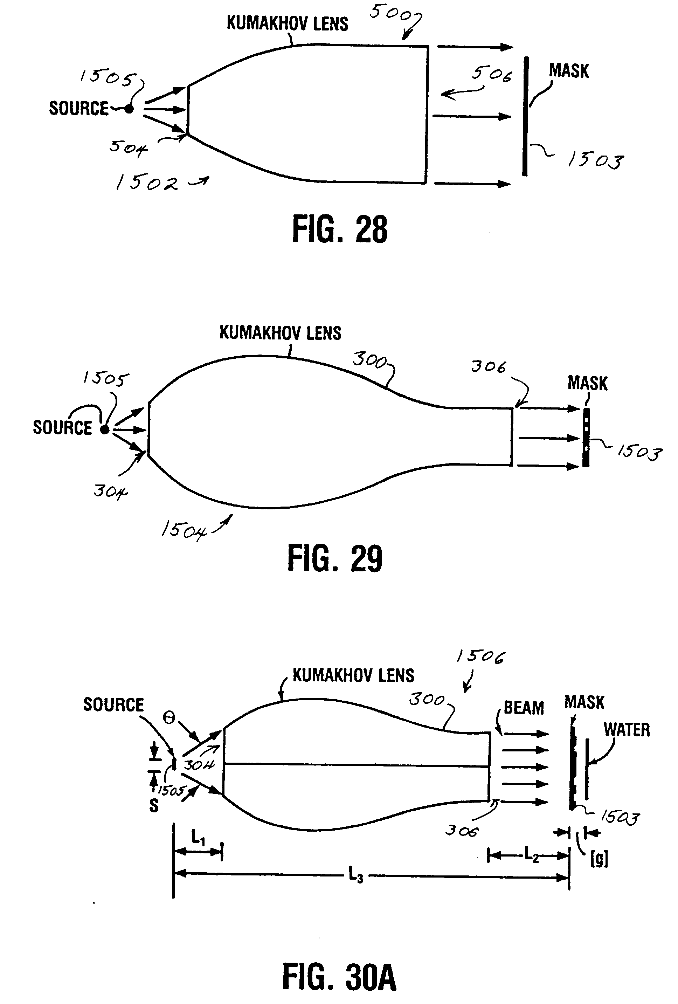

For point-source X-ray lithography, the Kumakhov lens selected is one capable of capturing a divergent beam and focusing that X-ray beam into a quasi-parallel beam oriented at the mask. FIGS. 28 and 29 represent examples of the invention and FIG. 29 is preferred for most applications because it delivers a higher intensity beam. The lens may be constructed using any of the structures described above.

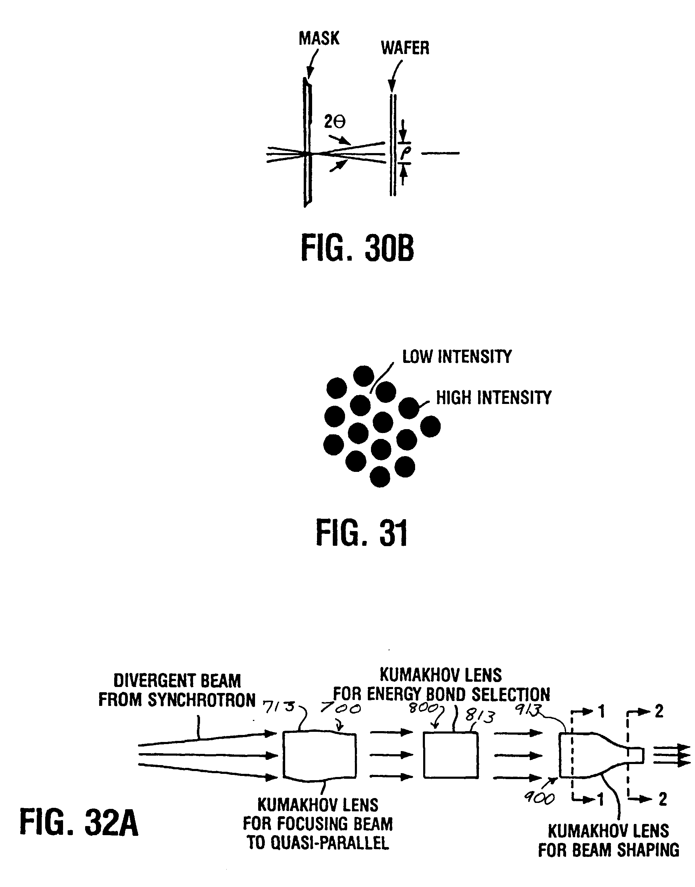

By use of the subject lithograph system (see FIGS. 30A and 30B) several benefits are obtained: (1) Increased intensity without pushing sources to their limit. Because the source output is collected over the solid angle $\phi$, more of the source power is transmitted to the wafer. And because the lens output is close to parallel, the distance to the mask is not as critical because the beam intensity does not drop off with the square of the distance. (2) Elimination of radial magnification because the beam is uniform in direction and divergence across its cross section, reducing sensitivity to gap control between mask and wafer and sensitivity to mask and wafer flatness while avoiding the need to compensate for run-out when constructing the mask. (3) Increased field size. Field size is not limited by radial magnification or parallax and can be controlled by the design of the lens to meet the requirements and lenses with 7 cm x 7 cm beams or greater are producible. (4) Decreased penumbral blur. $\rho = 2\sin\theta$, independent of S, $L_1$, $L_2$, and $L_3$. Penumbral blur can be further decreased by using lens channels such as capillaries which are flared at the end, thereby reducing $\theta$. (5) Decreased sensitivity to source position instability. Because the lens accepts X-rays from the same image focal area and focuses X-rays in the same direction, even if the source position were to shift and effect the intensity delivered to the mask, the geometric relationship between beam direction, mask and wafer would not be affected. (6) Separation of source from mask. Not only does the production of a quasi-parallel beam by a Kumakhov Lens allow the sample and source to be separated by a large distance, it also physically separates the source and sample so that line of sight transmission of material evaporated or sputtered from the source does not get onto the mask or sample. This is particularly serious for electron beam and laser sources and can also be a problem with plasma sources. Even a small amount of contaminant on a sample can be disastrous and on a thin mask can seriously degrade the performance and shorten the useful lifetime of the mask. (7) Selected band width. A Kumakhov lens can filter out undesirable photon energies. Filtering out higher energy photons is normally very difficult. But by using the Kumakhov lens energy photons can be filtered out and by using a reflection angle which exceeds the Fresnel angle (critical angle of total external reflection) of the high energy photons. This selective filtering is possible as the Fresnel angle decreases as photon energy increases.

Because there are discrete channels in the lens, the intensity of X-rays exiting the lens have some variations across the cross section as shown in FIG. 31 for a lens composed of circular capillary channels. This may be corrected by positioning the lens sufficiently far from the mask for the small angular beam divergence from each channel to homogenize the intensity across the lens cross section. Alternatively, the lens may be rotated. Because portions of the X-ray beam exiting the lens farthest from the center axis of the lens are typically at lower intensity due to the lens geometries, modifications to the lens such as selectively lengthening channels, or using of a filter, can be made to avoid a drop in intensity in the beam at increasing distance from the center axis of the beam.

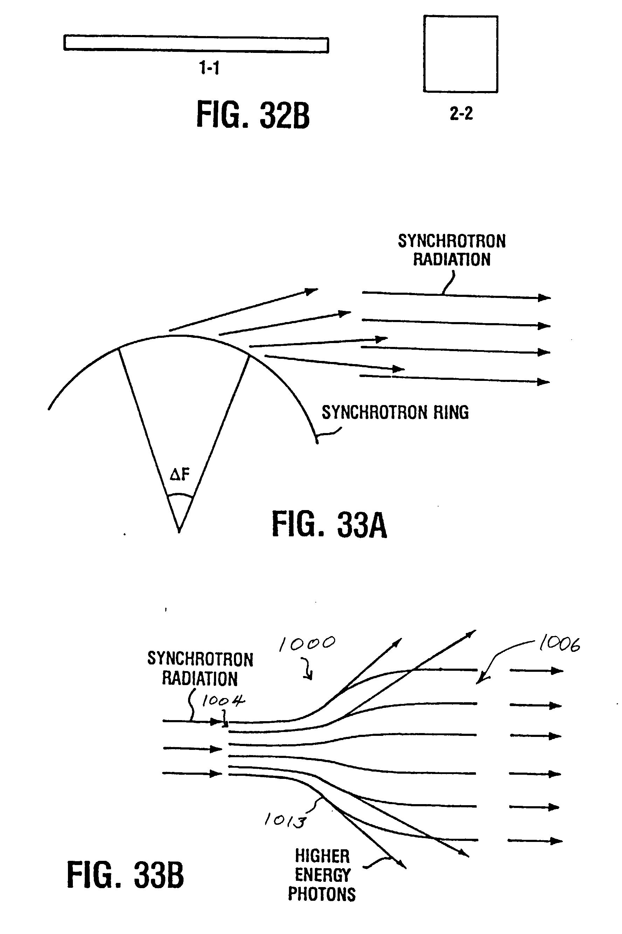

The synchrotron-source designed X-ray lithography system uses a Kumakhov lenses or lens to capture a divergent beam and focus it into a quasi-parallel beam, or reshape the beam to expose a more two dimensional area without needing to scan, redirect the beam to another orientation, split the beam into multiple orientations, select a portion of the energy band, or combinations of these by using complex lenses or combinations of lenses (FIGS. 32A and 32B). This permits tailoring beam shape and increasing of beam efficiency, changing beam direction, switching of synchrotron beam, and selecting energy band.

Considerations which apply to synchrotron-source based X-ray lithography would also be applicable if non-point-source X-ray lithography sources become available.

Projection X-ray lithography refers to X-ray lithography where there is a demagnification between the mask and the image on the resist. This enables the features on the mask to be larger than the features of the device created from the image. No known projection X-ray lithography demonstrates feasibility for commercial use.

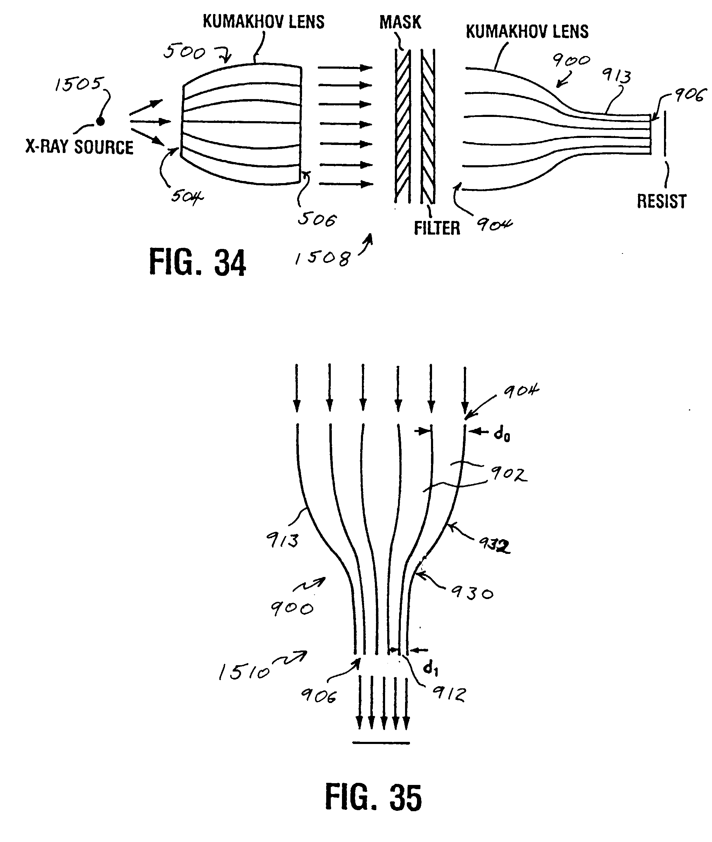

The subject invention for projection X-ray lithography is based on capillary optics. FIG. 34 shows an embodiment using an isotropic source. After the source there is a Kumakhov lens, which transforms divergent radiation into a quasi-parallel beam; this beam falls on a pattern or mask, passes through a filter, a second Kumakhov lens, and then falls on the resist. The filter is not required, but enhances performance by making the beam striking the resist uniform across its cross-section. Without correction, the beam would be weaker further from the central axis because capillaries there are bent over a larger angle, leading to higher beam losses. Such a filter could be placed either between the first lens and the mask or between the mask and the second Kumakhov lens (see FIG. 34). Other methods of achieving beam uniformity may also be utilized.

FIG. 35 shows a Kumakhov lens between the mask and resist the capillaries decrease in diameter. The preferred embodiment is for the inner diameter of the capillaries to decrease from $d_o$ to $d_1$. It is also possible to have some or all of the reduction in total cross-section be from a reduction in the wall thickness between capillaries. However, it is very difficult to construct such a lens where the wall thicknesses decrease more rapidly than the inner diameters although theoretically it is possible to have capillaries of constant diameter which are positioned spaced apart at the entrance end and close packed at the exit end of the lens.

To use the subject device for submicron lithography, it is necessary that $d_1$ be a fraction of the feature size desired. The minimum value of $d_1$ cannot be less than c/wp where c is the speed of light and wp is the plasma frequency of the capillary's material. The value of c/wp is approximately 100 Å. If $d_1$ is too small the diffractive divergence becomes too large. For example, if the situation was X-rays at E = 1 keV and $\lambda$(wavelength) = 12 Å, $d_1$ = 120 Å then the diffractive divergence, $\theta$ would be about $10^{-2}$rad, ($\theta = \lambda/d_1$). It is not necessary that the capillaries have a circular cross-section.

The resist should be placed at a distance from the Kumakhov lens, which is equal to or greater than L = d/$\theta$ where d is the thickness of the capillary walls and $\theta$ is the divergence of the beam leaving the Kumakhov lens. This condition is necessary for mixing beams from neighboring capillaries. At the same time L should not be so great as to prevent mixing of beams from capillaries which are located far from each other.

Such a device can also be used with a synchrotron as a source. In some cases when using a synchrotron source it may be possible to not use a Kumakhov lens before the mask. However, the preferred embodiment is where there is a Kumakhov lens between the synchrotron source and mask. As mentioned elsewhere in this patent, this lens can be used for reshaping the cross-section of the beam, redirecting the beam, controlling divergence, and controlling the energy band width.

Another embodiment is where the mask or pattern in FIG. 34 is not a separate element by is incorporated into the end of the Kumakhov lens or into the Kumakhov lens.

Kumakhov lenses are suitable for use in analytic instruments with lenses having capillary diameters of 200-400 microns being suitable for transmission of X-rays in the energy range of about 500 eV to 10 Kev, i.e. lower than that needed for many XRF applications.

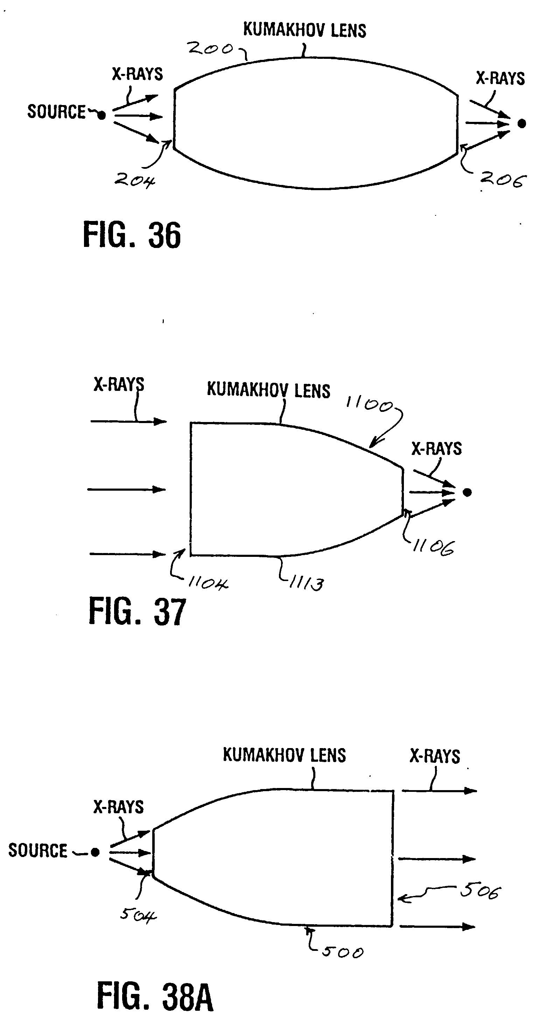

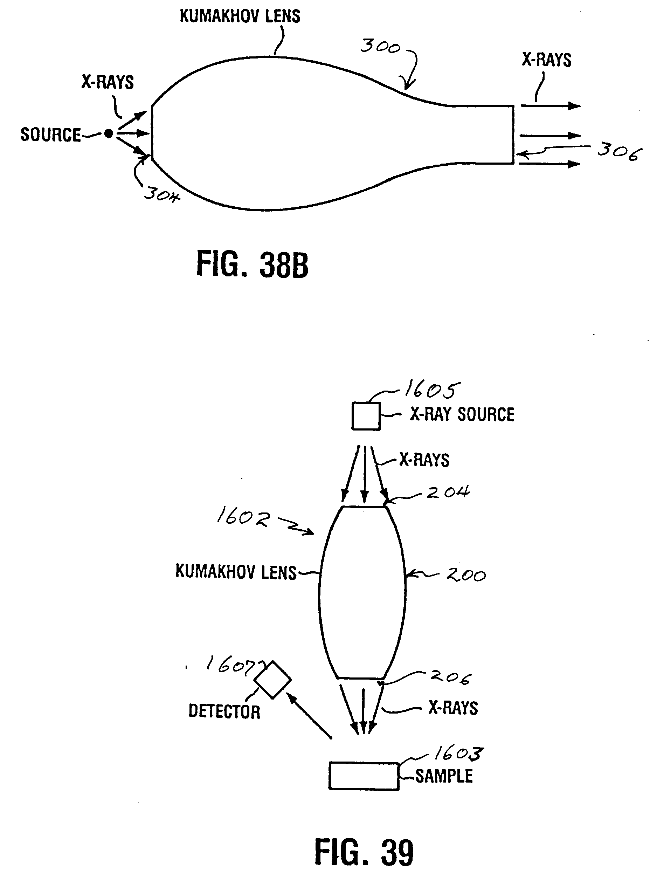

Kumakhov lenses can be subdivided into three types. Divergent-beam concentrators (FIG. 36) can collect radiation from a divergent X-ray source over an angular aperture of several tens of degrees and to focus it into a convergent beam. If desired, the beam can be focused into a very small spot (even less than 100 micron in diameter) depending on radiation energy and lens design; parallel-beam concentrators (FIG. 37) can concentrate a parallel X-ray beam into a convergent beam; and quasi-parallel-beam formers (FIGS. 38A and 38B) can convert divergent beam into a quasi-parallel beam. In most of the lenses made to date, divergence is equal to approximately 1/2 the critical angle for total external reflection, although in principle, divergence can be decreased to less than $10^{-4}$ radians by special lens design. A quasi-parallel-beam former can have a simple shape with only one direction of curvature along the longitudinal surface of a channel, essentially half a divergent-beam former (FIG. 38A). Quasi-parallel beam formers can also have a compound curve which results in a quasi-parallel beam concentrated in a smaller area (FIG. 38B).

Other shapes are suitable for special applications, including but not limited to, divergent beam concentrators with compound curves to obtain a longer focal length and lenses designed to change the direction of a beam or split a beam, sometimes while performing functions mentioned above. However, the preferred embodiment has a circular cross section although flat, square, rectangular, or have any cross section may also be utilized.

X-ray fluorescence (XRF) measures X-rays emitted by a sample for non-destructively obtaining a quantitative measure of the relative abundance of elements. By incorporating Kumakhov lenses into XRF devices, performance is significantly enhanced. A Kumakhov lens can be used with X-rays to obtain a larger collection angle, collimate, render beams parallel, reduce background X-rays, cause beams to converge, and collect from well defined small areas. Use of Kumakhov lenses with XRF devices improves performance (e.g., improving sensitivity, decreasing measurement time, relaxing the specification for other components such as sources, collimators, and detectors, thereby reducing their cost, improving spatial resolution, and enabling entirely new capabilities such as non-contact XRF analysis on interior points within the sample).

Kumakhov lenses utilized in XRF analysis in three different forms: 1) collection and focusing of X-rays incident on the sample; 2) collection and focusing of secondary X-rays emitted by the sample; and 3) both.

FIG. 39 shows a lens on the source side of the sample focusing the incident X-ray beam onto the sample provides a large increase in intensity and spatial resolution for localized or area analysis compared with collimators currently in use. For example, at least a factor of 200 increase in intensity with a spatial resolution of up to 30 microns (0.03mm) compared to a commercial EDXRF system which has spatial resolution of 0.25 x 1.25 $mm^2$ is possible. This takes into account the fact that without the lens, the source is closer to the sample. In addition to giving higher intensity and smaller spot size, the implementation of a Kumakhov lens provides more open space around the sample and avoids blocking effects and background problems arising from secondary X-rays emitted from collimators. If the X-ray source is not a primary source as in Secondary Target X-ray Fluorescence Analysis, STXRF, the use of the Kumakhov lens is even more important. A lens can be used between the primary source and the secondary source increase radiation from the secondary source and, even more important, a lens can be used between the secondary source and the sample. Scanning of the sample can be carried out by either moving the lens and source or moving the sample. The latter is generally preferred so as to retain the analyzed-area-detector geometry.

For many applications it is desirable to average over all or part of the sample. If the lens forms a convergent beam, the analyzed area may be easily adjusted by changing the lens-to-sample spacing and therefore the size of the excited area. By increasing the distance between the lens and the sample, the area of the sample irradiated can be increased. In this case, it is preferable to move the lens rather than the sample in order to retain the sample-detector geometry.

If multiple sources are used at the same or different times, lenses can be used to accurately control the irradiation on the sample, usually to ensure they irradiate the same area.

Positioning a sample so that a chosen area is excited is simplified by allowing another source of electromagnetic radiation to be temporarily positioned where the X-ray source is normally located. It is therefore be possible to directly determine the area to be excited. The preferred embodiment is to use a visible light source and view the area directly, but other spectra may be used and observed with the use of instruments.

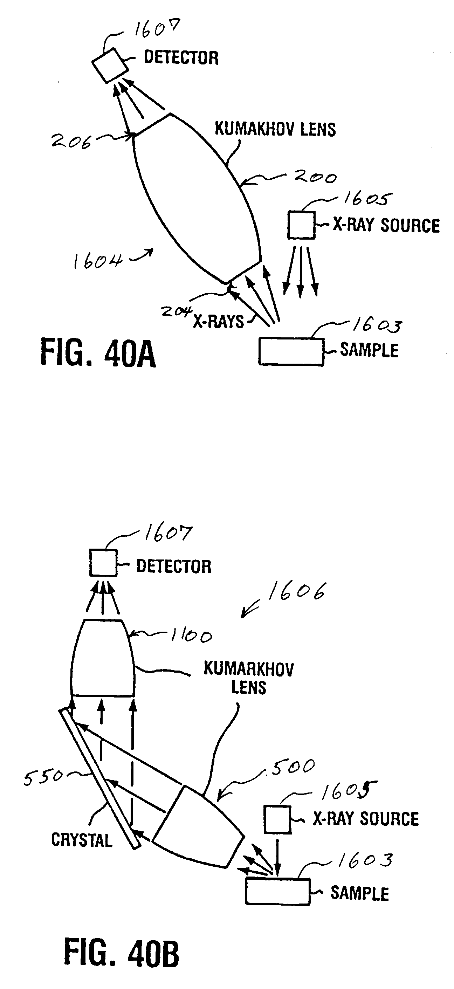

FIGS. 40A and 40B show a configuration with the lens between the sample and the detector. In the configuration shown, the lens collects X-rays from a selected spot on the sample and can therefore be used for selected area analysis. This may be done simultaneously with averaging measurements using an EDXRF or WDXRF detector which collects radiation from the entire sample. A Kumakhov lens between the sample and detector can also act as a band-pass filter, designed to cut off radiation at low energy or high energy and may permit the use of a smaller area, and therefore less expensive, or lower capacitance and therefore higher resolution EDS detector (FIG. 40B). For WDXRF, lenses can be used between the sample and crystal and between the crystal and detector. These lenses can provide improved collimation without the high absorption losses of the current systems.

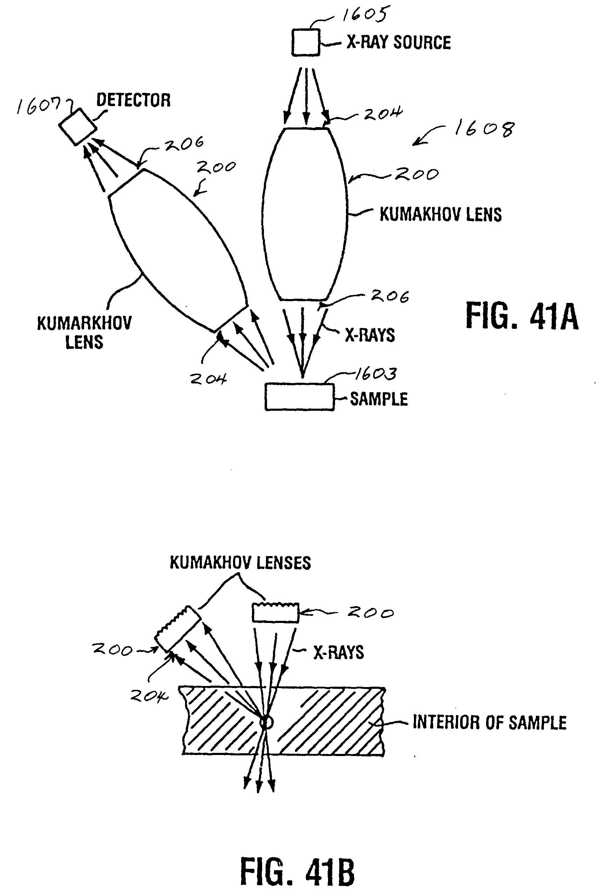

FIGS. 41A and 41B show lens on both the source and the detector side of the sample the advantage of a lens on the detector side is realized when used in conjunction with a lens on the source side. In this case, the volume of the sample measured is defined by the confluence of the object focal spot of the first lens and the image focal spot of the second lens as shown in FIG. 41B. By moving the sample, the spot may be positioned, even on the interior of the sample. Three dimensional micro-beam X-ray fluorescence analysis then becomes possible. Without Kumakhov lenses, any attempt to improve results requires the use of large sources, large area detectors, and radially oriented collimators. However, low photon count rates are of limited use and evolve problems with scattering and secondary emissions. Using Kumakhov lenses, spot size can be as small as 30 microns, and 3 micron spot sizes may be obtainable.

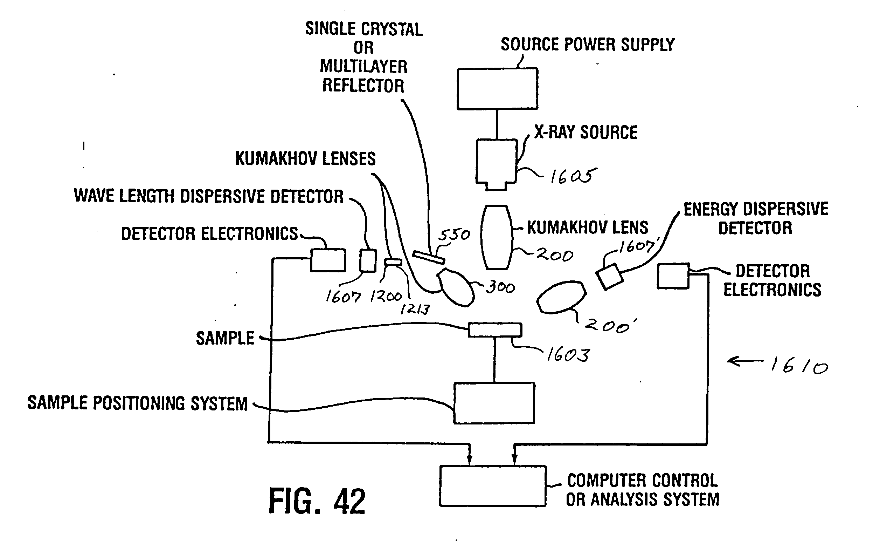

A Kumakhov lens has a fairly long focal length and leaves an area of the sample clear for relatively large collection angles. It is therefore possible to combine a variety of measurements in one instrument as shown schematically in FIG. 42. Beyond showing a do-it-all instrument, this figure summarizes the variety of measurements that can be carried out either singly or in combination.

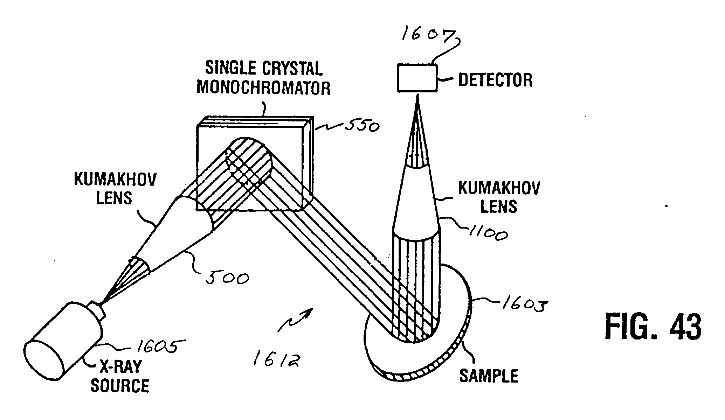

Other, more sophisticated XRF applications using Kumakhov lenses (see, FIG. 43) are envisioned. In this case, the Kumakhov lens produces a quasi-parallel beam which is then Bragg diffracted from a monochromatic crystal. The collimated monoenergetic beam is then Bragg diffracted from a single crystal sample, and the diffracted beam is either measured directly or collected and concentrated in a second Kumakhov lens as shown. Fluorescence radiation produced in the sample is collected and analyzed either directly or through a Kumakhov focusing lens. The configuration shown in FIG. 43 produces X-ray standing waves that can be used in conjunction with measurement of fluorescent X-rays to precisely determine (with precision of less than 0.05 angstrom) the position of impurity atoms in the crystal bulk or at crystal surfaces or interfaces or to determine lattice thermal vibration amplitudes and anisotropies. Depending on the diffraction angle from the monochromator crystal, the diffracted X-ray beam may be highly polarized. Use of such a polarized beam may be used in XRF measurements to significantly reduce background and increase sensitivity.

Kumakhov lenses are suitable for very sensitive digital subtraction analysis. By sequentially irradiating the sample area with two different wavelengths of X-rays and subtracting the detected X-ray emissions, background radiation can be eliminated, and very high sensitivity achieved. Obtaining two different wavelengths can be accomplished using a number of methods, including: using the sources, by filtering the X-rays between the source and the sample; by using monochromators to select wavelengths; by using two secondary sources; or by using Kumakhov lenses to obtain tailored band widths. Crystal(s) in the Laue geometry can also be used. Two or more wavelengths can be obtained by using a monochromator which differing angles so as to diffract different wavelengths. Sensitivity is maximized when the two wavelengths used to excite the sample are close and are on either side of the wavelength of the element or compound of interest.

If two different sources are used and the two sources are movable so as to sequentially place the sources in essentially the same position or along the same axis, a single lens between the source location and the sample can be used to increase intensity and ensure excitation of the same sample spot. If two different sources are used and the sources remain in their locations throughout the analysis, then two lenses or a complex lens can be used to increase intensity and ensure excitation of the same sample spot. If a single source is used, two lenses with different band-pass filtering characteristics can be used to obtain two different wavelength spectra for illuminating the sample. If one source is used and Bragg diffraction crystals are used to select wavelengths, use of lenses between the source and crystals may increase intensity, decrease divergence of the beams, and shape the beams, and use of lenses between the crystals and the sample can increase intensity, vary the size of the area of the sample excited, and ensure excitation of the same sample spot. If a single primary source or multiple primary sources are used with two or more secondary sources, lenses between the primary source(s) and the secondary sources can increase intensity and decrease the size of the secondary source spots. The secondary sources may either be in separate fixed locations or movable and sequentially placed in essentially the same position. Lenses between the secondary sources and the sample can increase intensity, ensure the same sample area is excited, and be used to adjust the size of the sample area excited.

Prior to the subject invention, the Göttingen X-ray microscope (described in: X-ray microscopy, Göttingen, Sept 14-16, 1963: Edit. S. Schwall, Spring Series in Optical Sciences, Vol. 43. Springer-Verlag, Berlin, Heidelberg, New York, Tokyo, 1984), provided best spatial resolution and brightness of any X-ray microscope. Unfortunately, this system is very complex, expensive, has high intensity losses, and requires a parallel beam such as from a synchrotron.

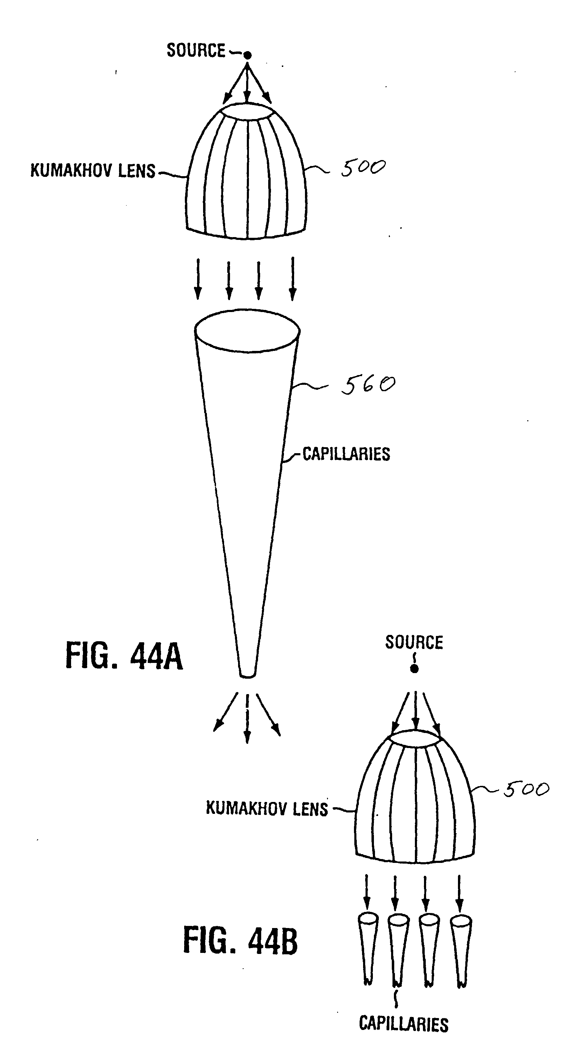

The subject X-ray microscope can be used with an ordinary X-ray source, such as, an X-ray tube with a Kumakhov lens is used after the source, transforming divergent radiation into a quasi-parallel beam. Then, a cone-shaped capillary is used (see, FIG. 44A). If the area of the spot after passing the Kumakhov lens is large, it is possible to emplace multiple cone-shaped capillaries (see FIG. 44B).

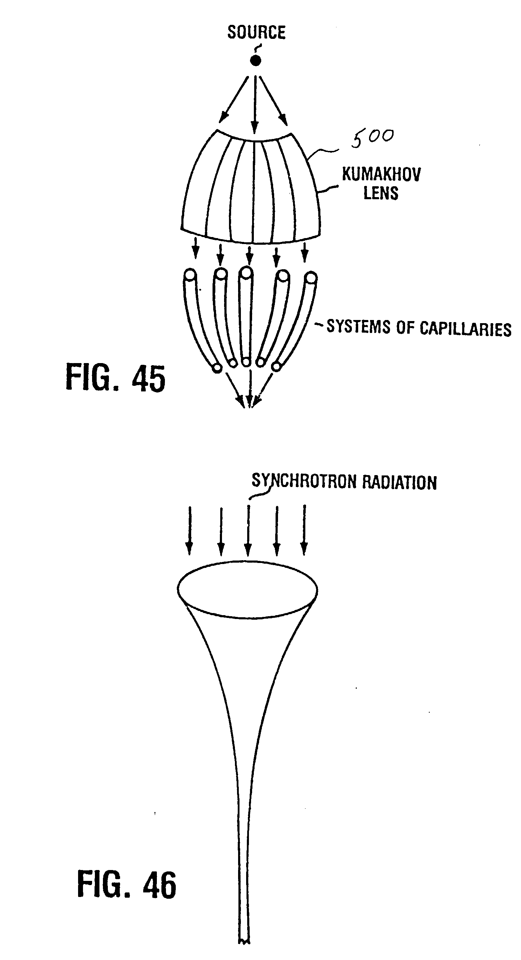

In a certain cases it is worth while to focus the radiation after passing the Kumakhov lens with the help of a system of bent cone-shaped capillaries (see FIG. 45). The capillaries in the device may be kept at a constant cross-section over the distance they are traveling, the capillaries would then be cone-shaped as they approach the focus. Bremstrahlung, channeled radiation, plasma source, laser plasma, etc. may be used as a radiation source.

If synchrotron radiation (SR) is used as a source, a monochromator may be used for selecting monochromatic radiation, followed by a cone-shaped capillary. SR is very intensive and losses on the capillaries' walls might cause overheating of their inner surfaces. The capillaries are heated most in areas where their diameters are minimum. To avoid this problem, the angle of the cone may be variable with the angle decreasing proportionately, with the diameter of the capillary (See FIG. 46). To effectively focus, the angular value of the cone should be smaller than the critical angle of total external reflection (the Fresnel angle). This provides focusing effectiveness that surpasses the Göttingen X-ray microscope by several orders of magnitude.

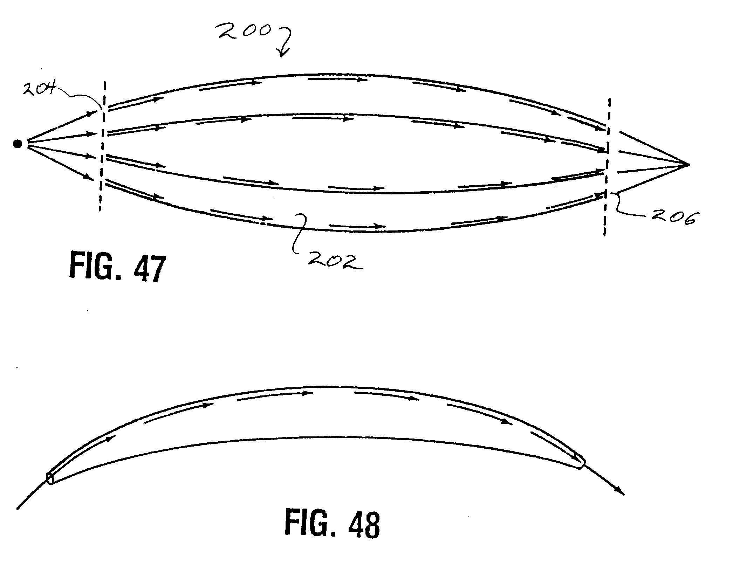

When a divergent radiation source is employed, a Kumakhov lens may be used in which each capillary is bent-barrel-shaped (see FIG. 47). A peculiarity of these capillaries is that the diameters at their ends are much smaller than their diameters in the middle. Meanwhile, the surface of each capillary and of the whole system is formed in such a way that their projection on the plane is a section of a circumference. Radiation travels along the outer surface (see FIG. 48). It is preferred where the diameter of the lens at the exit is equal to its diameter at the entrance. In the ideal construction of such an optical system, the size of the focal spot will near the size of the end of the individual capillaries, which can be smaller than 1 μm. The visualization of the shadow image in the X-ray microscope may be done by using X-ray vidicon, or other methods. The physical limit of one prototype X-ray microscope's spatial resolution is limited by diffraction of about 100 Å.

The subject X-ray microscope may be used together with other instruments, for example, an energy analyses of electrons knocked off from the surface. Additionally, it is possible to use a divergent source with a Kumakhov lens which forms a parallel beam and then pass the beam through a zone plate to obtain radiation focusing. Such a device achieves very small focal spots since the size of the focal spot is not limited by the size of the capillaries.

The schemes shown in FIGS. 44A-48 may be used for an ion microscope. The inner surface of the X-ray optical device and cone-shaped capillaries should be covered with a conductive layer to keep the beam from being blocked because of electrostatic space charge. To make the coefficient of reflection ions from the inner surface maximum, it is necessary to make the capillaries as smooth as possible. This smoothness is more critical for ions than for X-rays. The physical limitation of the spatial resolution of an ion microscope may be at the atomic level, i.e., about 1 Å.

As high intensities may be obtained in the focal spot, such a microscope may also be used in different technologies, e.g., for ion implantation, in lithography, etc.

Using a source of neutrons and a material which does not readily absorb neutrons to make the capillaries or to cover the inner surface of the capillaries, the systems shown in FIGS. 44A-48 may be applied as neutron microscopes.

Electron microbeam analysis is very similar to X-ray fluorescence except that the excitation is done by bombarding with electrons, rather than with X-rays. Use of electrons enables a small area to be excited. The subject electron microbeam analysis is similar to the parts of the invention for X-ray fluorescence which apply to use of a Kumakhov lens or lenses between the sample and the detector.

FIG. 40A shows a configuration with the lens between the sample and the detector except for electron microbeam analysis electrons rather than X-rays would be coming from the source. In this configuration, the lens collects X-rays from a selected spot on the sample and therefore reduces the background due to scattering. A Kumakhov lens between the sample and detector can also act as a band-pass filter, designed to cut off radiation at low energy or high energy, permitting the use of a smaller area, and therefore less expensive, or lower capacitance (higher resolution) energy dispersive detector. For WDXRF, lenses can be used between the sample and crystal and between the crystal and detector. These lenses can provide improved collimation without the high absorption losses of the current systems (see FIG. 40B).

X-ray diffraction is a widely used technique that evaluates angular distribution of X-rays coming from the sample. If the sample is other than a single crystal, e.g., a powder sample, a highly parallel beam is needed for irradiating the sample. Under certain conditions, a single crystal sample a convergent beam may be used.

Because angular distribution of the X-rays is being sought, it is not generally useful to use a Kumakhov lens which collects divergent rays from the sample and forms a parallel beam or forms a convergent beam. An important benefit is the use of a Kumakhov lens between the source and sample to fashion a beam which is parallel or convergent, as required for the particular analysis of a desired cross-sectional size and shape. Also useful is the ability to selectively filter out undesirable photon energies prior to the X-rays striking the sample by use of lens manufacture combinations, designing the Kumakhov lens channels to be bent in such a shape that they filter out higher energies, using materials which absorb lower energies, or using Kumakhov lenses which provide tailored band widths.

A Kumakhov lens can also be used to collect parallel X-rays from the sample and focus those photons on the detector. This configuration is very selective for a narrow angular range of X-rays coming from the sample without the losses inherent in normal collimation and only requiring a small detector.

The same geometries discussed for X-ray diffraction work for neutron diffraction, including filtering to control the energy band width. However, to use Kumakhov lenses for neutrons it is necessary to construct the lenses or coat the lenses with materials which have a very low absorption of neutrons. For example, materials containing boron are unsuitable because of boron's high absorption cross-section for neutrons.

In medical devices, Kumakhov lenses may be used between the radiation source and the subject to be irradiated. The term subject includes, but is not limited to, a patient (human or animal), a biological sample, a chemical sample or a material sample. In a medical device, the lens may be designed to either capture a portion of a divergent beam or capture a parallel beam. Once captured, the beam can be shaped into any desired cross-sectional shape. For imaging purposes, the selected shape is typically rectangular, with a cross-section large enough to image the area of interest.

The lens may also be designed to filter out radiation levels which are undesirable. For example, for X-rays applications, filtering is often desirable to remove higher energy (harder) X-rays. The lens parameters may then be adjusted to provide collimation (reduction in scattering). Depending on the application, a convergent, quasi-parallel, or divergent beam may be produced. Devices having Kumakhov lenses which produce parallel beams are preferred for imaging and devices with lenses which produce convergent beams are preferred for most therapeutic applications. Devices may also be constructed with lenses which function as guides to channel the radiation to parts of the body which are difficult to reach, such as the linings of internal body cavities. Multiple lenses may be used to accomplish a plurality of these functions, but it is preferred to utilize a single lens.

Medical devices with a Kumakhov lens between the source and patient may have the radiation beam strike other surfaces before reaching the patient. Two embodiments utilizing reflected beams will be described. In the first embodiment, the lens captures radiation from a divergent source and produces an intense quasi-parallel beam which is directed to a surface which reflects a monochromatic beam (such as that obtained from a Bragg reflection). This results in a narrow band-width beam which has higher intensity than that obtained without a Kumakhov lens. The second embodiment utilizes radiation from a divergent or parallel source which is captured by a Kumakhov lens and is focused on a material which then emits radiation characteristic of that material. For example, such a lens may be useful to provide high intensity broad band X-rays on a pure material capable of absorbing X-rays and emitting high intensity X-rays at a particular energy level characteristic of that material. Because very little radiation is emitted at other energy levels, a very clean beam having a characteristic energy level is required. When radiation is directed at a material other than a subject, a Kumakhov lens may be used between the irradiated material and the subject. In this configuration it is often desirable to shape, collimate, filter, or control the direction or divergence of the beam.

In medical devices, a Kumakhov lens or lenses may be used between the subject and a detection means. The principle benefits from such a positioning are (i) beam collimation (decreased background caused by scattering), (ii) controlling beam direction to reach the detector or detectors, and (iii) beam focusing to reduce the necessary detector size or beam expansion to simplify position sensitive detectors.

The following devices illustrate the subject invention. Although various aspects of the subject invention are described for a particular embodiment, it is to be understood that the principles set forth may be applied to alternative embodiments and are not to be taken as limitations.

Kumakhov lenses may be used with different types of sources in an angiography device and a variety of sources such as rotating anode or pulse X-ray sources may be used in such a device. For example, if a rotating anode source is used, the effective focal spot may be of the order of 1 x 1 mm$^2$ or smaller and the linear speed of the rotating anode may be about 100 m/s. The anode may be built up with the materials yielding characterizing lines near the iodine lines (e.g. La, Ce, Be and some others). If the electron energy is from about 500 to about 600 keV and the current is about 0.5 A it is possible to obtain a sufficient number characteristic photons in a very short period of time.

This method (the so-called "dual method") has been proposed using traditional filters. Unfortunately, the hard part of the bremstrahlung remained, making filtration virtually impossible. Additionally, crystal-monochromators are ineffective as photon beams diverge isotopically from the source.

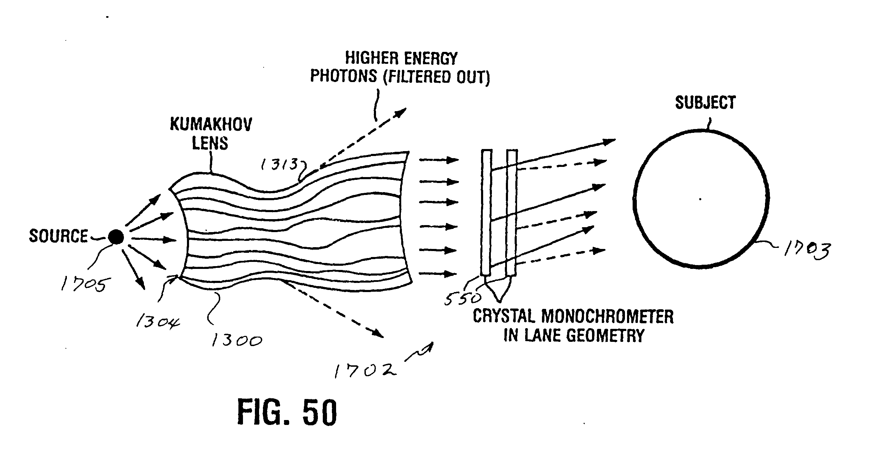

The angiography scheme of the subject invention is shown in FIG. 50. An X-ray optical device of the subject invention is placed in front of the radiation source which transforms divergent beams into a quasiparallel one of desired size (typically, about 15 x about 15 cm) while simultaneously filtering off the hard part of the radiation.

The X-ray optical device is followed by 2 crystal-monochromators in the Laue geometry on which 2 characteristic beams (before and after the iodine absorption line) are diffracted. A subject is then placed between the crystals and the detectors.

A representative embodiment includes a Kumakhov lens which collects about a $10^{-3}$ fraction of the isotropic beam and transforms it into a quasiparallel beam with a divergence of about 0.5 mrad With such a divergence, and a subject body having a thickness of about 20 cm, a spatial resolution of (700/200) microns may be obtained. Two beams with the total number of photons of from about 3 to 5 x $10^{12}$ fall on the subject's body during about $10^{-2}$ s. The radiation dose is several roentgens, (i.e., considerably lower than in traditional angiography). Also, irradiation lasts only about $10^{-2}$ s, so that contractions of the heart muscle do not blur the image. An important peculiarity of this method is that it is unnecessary to use a catheter to introduce iodine into the heart since a safe concentration of iodine may be injected directly into an arm vein.

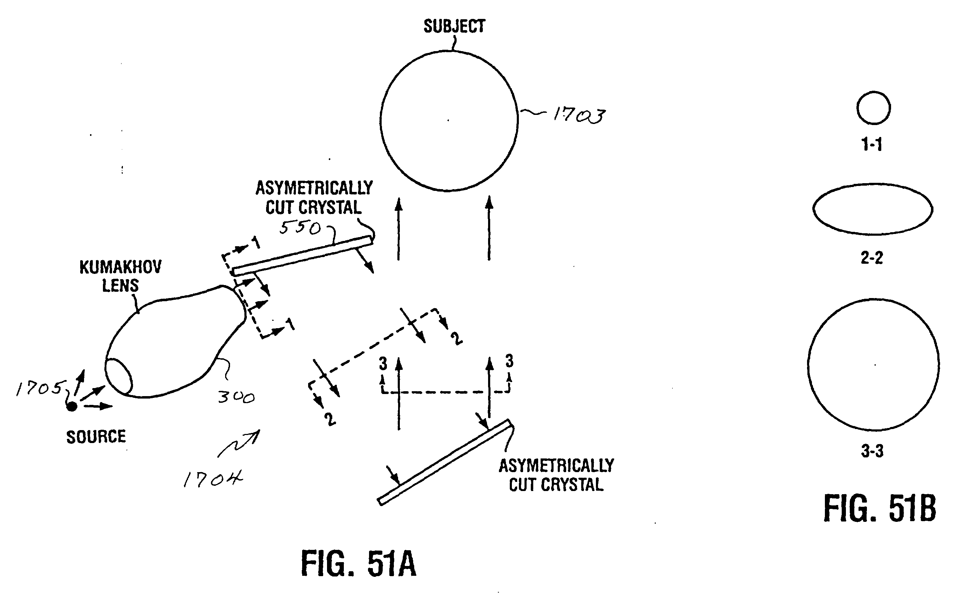

Several other embodiments of the subject angiography device may utilize Kumakhov lenses. Instead of using crystal-monochromators in the Laue geometry, asymmetrically cut crystals may be used as monochromators. A useful example of this is when the Kumakhov lens produces two intense quasi-parallel beams (FIG. 51 shows the path of one of those beams.) Each beam is then reflected off an asymmetrically cut crystal designed to select a desired energy of X-ray photons by Bragg reflection and to increase the size of the beam along one dimension. The beam is then reflected off another asymmetrically cut crystal designed to reflect the same photon energy and to expand the cross-section of the beam along another dimension. This results in a large cross-section beam of very narrow band width which is then directed at the subject. The second beam from the lens is monochromated to a different energy so that the energy of the two beams closely bracket the absorption energy of interest. The second beam follows a path similar to the first and intersects with the first beam at the subject.

Kumakhov lens collimators or other collimators may be used either before the patient or between the patient and the detectors to improve resolution. Collimation after the patient can also reduce the loss of spatial resolution. However, this improved resolution comes with some decrease in photon count.

Detection for digital subtraction angiography may be performed with two detectors located far enough from the subject so that the difference in angle between the two beams separates the two beams sufficiently so that the two beams do not overlap. Alternatively, a single detector can be used quite close to the subject. Because the distance from subject to detector is greatly reduced, there is a significant improvement in spatial resolution due to decreased image blur resulting from beam divergence. Prior to the subject invention, difficulties with this approach made it impractical for use with digital subtraction angiography.

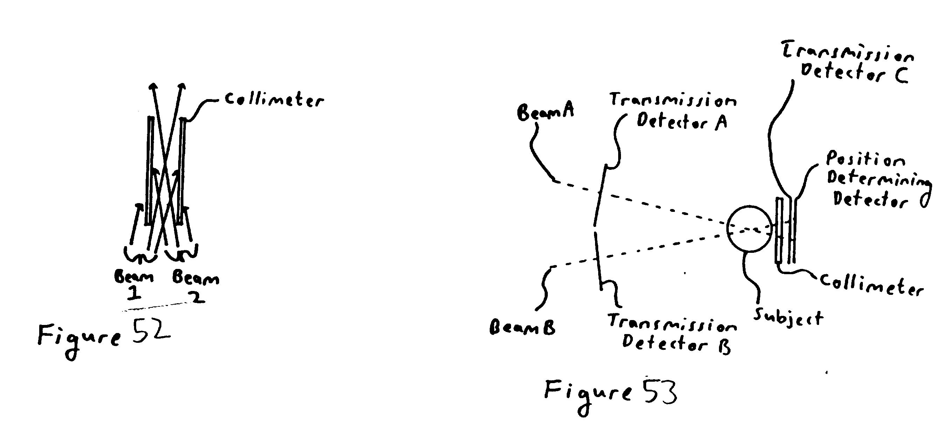

Scattering from a subject will reduce resolution unless collimation is used. But if the two beams pass through the patient a much of an angle from each other, traditional collimation will block much of the beam from one or the other angle. (See FIG. 52). A slit collimator with the slits in the planes formed by the crossing rays allows passage of the two beams with only small losses while absorbing the scattered radiation which was not parallel to the collimator slits.

An even more serious problem caused by using a single detector for digital subtraction angiography is the difficulty in discriminating between photons which emanate from the two beams. Although, the two beams are of different photon energies, they are often close enough (differences may be as small as 200 eV) that they cannot be differentiated by a two dimensional position sensitive detector.

One method of differentiating is to identify which beam the photons came through by tagging them. FIG. 53 shows a design utilizing such a method. By comparing transmission time differences between detectors A or B and transmission detector C it is possible to establish coincidence that tags which one of the two channels the photon came from. This tag is then applied to the position information recorded for that photon by the position determining detector. The information generated may then be used to differentiate the recorded image for the two beams so that digital subtraction may be performed. Transmission detectors are typically of a variety of types, including thin scintillation crystals. The function of transmission detector C could even be performed by the position determining detector itself if it is fast enough.

The subject method does not have a flux rate limitation since it chops the beam or beams so that photons of only a single energy arrive at the position determining detector during defined time intervals. For example, if two beams are used, they are alternatively transmitted so that information concerning photons arriving at the position detector may be accumulated independently for each beam. This information may then be used for digital subtraction imaging. By using this method, only a single position sensitive detector is necessary. Especially advantageous is chopping back and forth between energies by using one broad spectrum beam which strikes a monochromator and then rocking that monochromator between two well defined positions at a clearly defined interval. Once the monochromator is at each of the two positions, it will select a different energy photon. If the position detector data collection is correlated to the position of the detector, the data for each of the two energies may be collected separately. Information on photons which arrive at the monochromator while it is in motion are not collected. If there is instability in the beam, or the subject is in motion, the monochromator may be rocked back and forth at very short time intervals. The data for each energy may then be time averaged and unbiased between the energies, providing a set of data for digital subtraction. A variety of monochromators such as Bragg diffraction crystals, multilayers, and crystal diffracting based on the Laue geometry may be used.

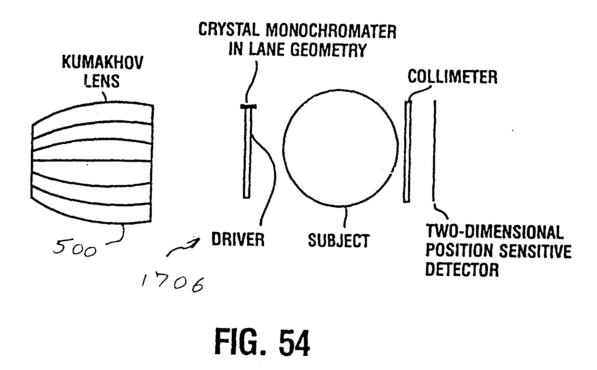

The preferred embodiment for digital-subtraction imaging of large areas is shown in FIG 54. A Kumakhov lens forms a collimated quasiparallel beam with a wide energy spectrum; the beam is diffracted in a crystal monochromator in the Laue geometry; the monochromator beam passes through the patient; the beam is collimated to remove scattered photons; and the photon positions are recorded by the position sensitive detector. To obtain a beam of a different energy, the monochromator is rotated slightly to change the angle relative to the beam. This rotation may be effected by attacking the crystal to hinge and driving a rotation with a piezoelectric crystal. At the alternative orientation, the crystal diffracts a beam of a slightly different energy at a slight angle from the initial beam. For an application such as angiography, the crystal may be repeatedly rocked back and forth at short intervals. The photon position data would be collected for each of the two energies which correspond to the two positions. This embodiment provides the benefit of removing sources of variation and resolution degradation by using a well-collimated, high intensity, quasi-parallel beam; using only one crystal; using only one detector; having two beams at only a very slight angle from each other; having two beams with energies which are close to each other; and minimizing the distance between the subject and the detector.

These techniques may be used for any type of digital subtraction imaging and are not limited to coronary angiography. Use of a Kumakhov lens in equipment for conventional angiography also has significant benefits. By collecting a large solid angle of radiation from the source and transforming that divergent beam into a parallel beam, photon flux may be increased. This is beneficial because higher flux allows an image to be obtained in a shorter time, thereby limiting movement artifact. Moreover, the high intensity and parallelism of the beam enables a narrow energy band width to be selected for passing through the subject. By using a narrow band width slightly above the absorption line of the contrast agent rather than a broad band width having energies below the absorption line, higher content can be obtained. The most common method of obtaining a narrow band width is by using monochromator.

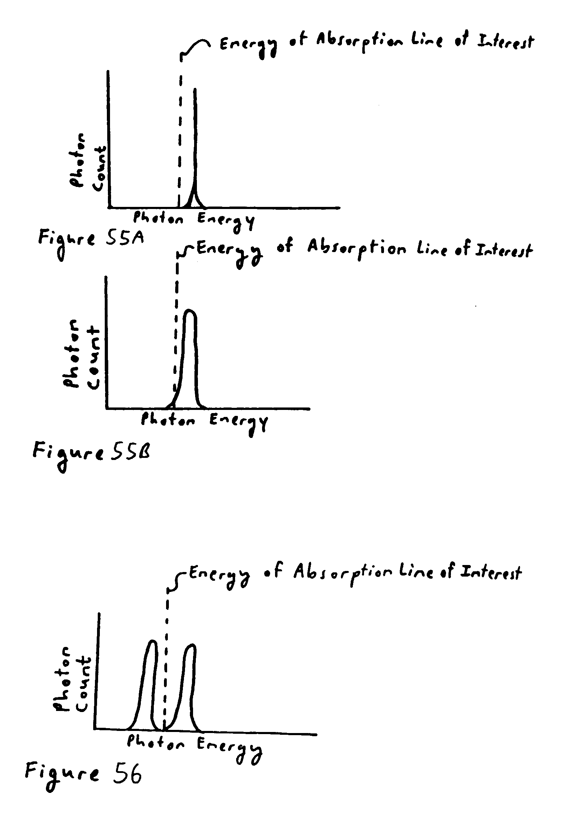

An enhancement which increases beam intensity (and therefore resolution) and/or decreases exposure time, acts to broaden the energy band width used. Monochromators select an extremely narrow band width. Some crystals such a germanium select a wider band width than silicon, but the band width is still very narrow. This very narrow band width leads to low flux as all other photons in the original beam are discarded. If the band width at the selected energy is increased a controlled amount, the flux may be increased significantly without noticeably decreasing the contrast which is obtained from the absorption at the absorption line of the contrast agent. FIG. 55 illustrates a band width selection which is possible using Kumakhov lenses. Such tailored band width selection is valuable for conventional imaging using a contrast medium and for digital subtraction imaging. In digital subtraction imaging, two tailored band-widths are transmitted, one directly above and one directly below the absorption line of the contrast agent (See FIG. 56).

Because of its advantages (significantly smaller radiation dose; improved resolution; safety connected with the non-use of probes; and low cost) this method provides an effective means for mass diagnosis of a population.

Synchrotron radiation (SR) allows a lower radiation dose to be delivered a patient. When a synchrotron source is used the radiation dose is near $2 \times 10^{11}$ photons, approximately an order of magnitude less than in the device discussed above. This occurs because two lines are selected out of the synchrotron's continuous spectrum with the help of crystal-monochromators. The lines lie very near the iodine absorption line. Digital angiography contrast is about $1/(\Delta\mu)^2$, where $\Delta\mu$ is the difference between the iodine absorption coefficients and the energy of the 2 beams used. The characteristic lines of elements are farther from the iodine absorption line than the lines selected from the synchrotron radiation, so to use a larger number of photons than a device with synchrotron radiation.

Angiography requiring a high radiation subject dose may be improved by using the bremstrahlung spectrum which appears when a target is irradiated by accelerated (i.e., up to 10 meV) electrons.

Calculations show that with electrons of 10 meV energy about $7 \times 10^5$ photons/electron on two lines - $\Delta E_1 = \Delta E_2$ = 100 ev may be obtained before and after 33169 keV/the iodine absorption line is obtained.

If losses in Kumakhov lenses are 2/3 and losses on the crystal are also 2/3, the number of photons reaching the patient are about $7 \times 10^5$ photons/electron. Therefore, an electron beam current of about 0.5 A is needed for approximately $10^{-2}$ of irradiation. Such pulses may be produced in different ways. One is by using an induction accelerator where the target can be removed after each pulse. Such an electron accelerator is much less expensive than a synchrotron ring.

Bremstrahlung from a relativistic electron beam can be captured quite efficiently by a Kumakhov lens because the bremstrahlung travels predominately in a straight forward direction. In the example described (as with synchrotron radiation), 2 narrow lines before and after the iodine absorption line are selected with the help of 2 crystal-monochromators. Patient radiation may be less than 1 roentgen.

Synchrotron radiation is used in digital subtraction angiography. The use of a Kumakhov lens may significantly improve the parameters of a synchrotron based angiography device.

SR beams diverge in the horizontal plane and a considerable part of the horizontally divergent SR beam may be transformed into a quasiparallel beam with the help of an X-ray optical device in order to use it for angiography.

A synchrotron beam of limited height, such as 1 mm, can be reshaped into a desired area, e.g. into (15 x 15)cm$^2$, using the subject lens. While reshaping the beam, divergence can be significantly decreased, up to 1 order of magnitude. In this case, spatial resolution considerably increases (i.e., even the smallest blood vessels of the heart can be observed). With a divergence of about $10^{-5}$ rad, resolution may be brought up to several microns. Use of Kumakhov lenses makes it possible to filter out the hard part of synchrotron radiation to prevent some of the high energy photons reflect off the crystal monochromators at a harmonic of the desired energy range.

An endoscope's diameter is limited to the size the orifice to be entered. Typically, the diameter of the endoscope (the X-ray portion) is less than about (4-5) mm and should be shielded so that radiation does not deviate from the desired area.

Using an X-ray source of several tens of microns by several about hundreds of microns in size and a Kumakhov lens capture angle of about 0.1 rad, the effective area of the source is about 10 microns$^2$. When the photon energy is several tens of keV, the efficiency of transforming the energy of an electron beam into radiation is about $10^{-3}$.

Considering the above factors, and supposing transportation photon losses will achieve about 80%, it is possible to obtain radiation intensity within the limits of about 1 to 10 roentgen per minute.

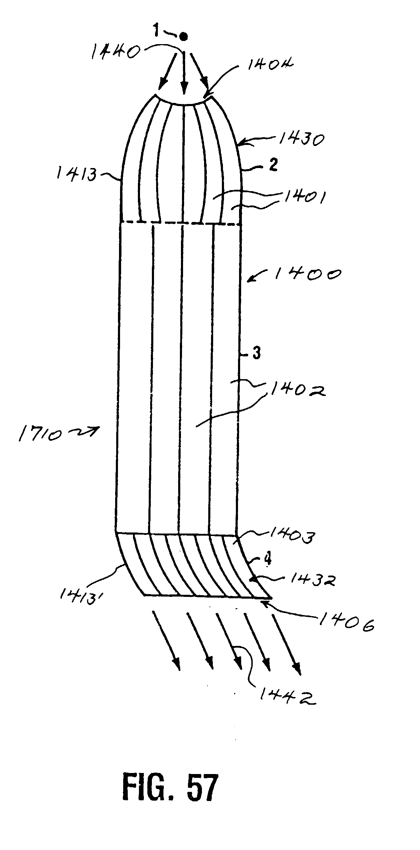

One embodiment of an endoscope is shown in FIG. 57. The initial part of the Kumakhov lens represents a semi-barrel transforming divergent radiation into a quasiparallel beam (2). After the gathering section of the lens is a transportation section (3). On this section, radiation channels, such as capillaries are made with a comparatively large diameter (approximately hundreds of microns). The channels in this section can also be of small diameter such as in section (2) and (4). The last section (4) is bent. Since body orifices have a limited diameter, it is preferrable to allow bending the beam in a small radius of curvature. To prevent loss in radiation transfer on the interface between (3) and (4), the capillary diameter in (4) should be small, preferrably smaller than about 0.1 $\mu$. This is because the fact that the share of the captured radiation is about $R\theta_c^2/2d$, where R is curvature radius in (4), $\theta c$ is the Fresnel angle, d is the capillary inner diameter. 4 is typically made out of polycapillaries.

The last section (4) may be mechanically bent by a special system or even rotated relative to the system's axis. The device is typically shielded so that scattered photons or particles do not penetrate the body.

An endoscope may be used for tumor irradiation. If the endoscope must endure significant bending, such as in the throat, a more intense source is necessary, since sharp bends incur considerable losses in flux. In such cases, an accelerator (e.g., channelled radiation or bremstrahlung) may be used instead of powerful X-ray tubes or other point sources.

A radiation endoscope may be assembled from existing light pipe endoscopes including the Olimpus GiF K/D3 type which has a diameter of about 12 mm. A biopsy canal may be used for the flexible radiation guides. The turning of X-rays in (4) (see, FIG. 57) is necessitated by tumors generally being located on a channel's walls.

In cases where the entire endoscope is rigid, the irradiation dose may be tabulated before hand. For a given source, the dose will depend only upon the irradiation time. This is important because a special dosimeter at the exit of the endoscope is not required. The last section (4) may be removable so alternative end sections can be installed depending on the angle necessary.

A system of the type shown in FIG. 52 may be used for the defectoscopy of localities difficult to access (in different cavities of an aircraft and other objects, pipes of small diameters, and so on).

A detector on the very end of the endoscope to allow the radiation dose to be monitored and controlled. This small detector at the end of a capillary or capillaries, may be any of a variety of types, including semiconductor detectors which transmit an electrical signal back up a wire or a detector which gives off visible light when irradiated. That visible light could be observed through an optical wave guide or guides which are part of the endoscope.

A thin relatively radiation transparent shield may be placed on the end of the endoscope to prevent matter from entering the radiation channels.

Tomography typically uses an X-ray tube source with a spectrum including characteristic lines as well as wide-energy bremstrahlung. One problem which arises is that of "beam hardening". "Beam hardening" is the effect from the low-energy end of the spectrum being attenuated more than the high-energy end, which shifts the mean energy of the spectrum towards higher energy. This effect is detrimental to computer tomography (CT); since the beam hardening errors in X-ray projections of different angles are combined during tomographic reconstruction. One solution to this problem is to use only characteristic lines from X-ray sources using crystals monochromators to filter the beam. However, from a divergent point source an insignificant portion of the rays enters the storage angle.

Because a Kumakhov lens can transform divergent radiation into a parallel beam, a Kumakhov lens may be used to transform divergent radiation into a parallel beam and then, using crystals-monochromators, obtain monochromatic beams of the necessary size. For example, using a rotating anode powered 50LW (a La anode with the lines $E_kd1 = 33.44$ keV, $E_kd2 = 33.03$ keV) we can obtain about $3 \times 10^{15}$ photons/s on the two lines if the rotation speed is about 100 m/s and the effective spot is about 1 x 1 mm in size.

Using a Kumakhov lens, a parallel current of about $3 \times 10^{12}$ photons/s x mrad of characteristic photons can be obtained. This current is very similar to the one in Stanford at SSRL 54 Pole. Only about $3 \times 10^8$ photons/s from the rotating anode in the same angular interval would be obtained without the Kumakhov lens. The Kumakhov lens in this embodiment increases the flux of a parallel beam by about 4 orders of magnitude.

Other sources to produce a parallel beam may also be used (induction diodes, plasmas, laser sources, and others).

When radiation penetrates a subject's body, scattered Compton radiation appears making it difficult to obtain images in CT. If a monochromatic parallel beam is used, scattering may be avoided by moving the detector a sufficient distance away from the subject. A parallel monochromatic beam also limits "beam hardening" effect.

Several beams of different energy are usually needed for Dual Photon Absorption (DPA) CT, e.g. in the area of 30 and 80 keV; one energy mainly represents the concentrations of the low-Z elements, while another represents the intermediate Z elements (P, S, Se, K, Ca, Fe). The second group of elements includes neurologically important elements K and Ca, abnormal brain-tissue concentrations of which may reveal disorders such as ischemic and incipient infraction [see for example: Mies G. et al., Ann Neurol, 16: 232-7, 1984; and Siesjo B.K., Eur Neurol, 25: 45-56, 1986].

The above device using a Kumakhov lens makes it possible to obtain quasi-monochromatic beams across a wide energy range, thereby solving the problems of DPACT.

Topography for establishing size and form of tumors may be accomplished by introducing radioactive elements into the body, waiting for the radioactive elements to collect in the tumor, and then detecting the radiation emitted with the help of a gamma-chamber consisting of a number of collimators. Unfortunately, drawbacks to this approach include: insufficient spatial resolution; high background (noise); and therefore, difficulty in obtaining a real 3-dimension image of the tumors.

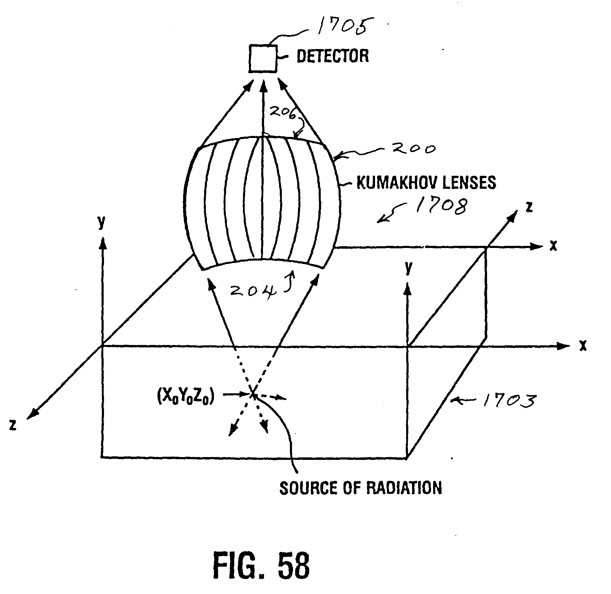

The subject device greatly reduces these problems. An example of applying a Kumakhov lens in topography is shown in FIG 58. The tumor under study is inside the patient at point $(X_0, Y_0, Z_0)$. The radiation capture angle $\phi_0$ may be 0.1 - 0.3 rad. Including energy losses in the lens 0.1 - 1 % of the radiation from the source may go into the detector. E.g., several ten to hundreds of photons per second may travel into the detector if the activity is about 1 microcurie (about 10' photons/s).

A detector is placed at the focal point of the Kumakhov lens to sharply increase signal to noise ratio. The spatial resolution of the system using a Kumakhov lens can be as low as several tens of microns, considerably exceeding the resolution of the existing gamma-chambers.

If the location of the tumor is unknown, tomography of a body is performed in two stages. Stage 1: the search for the tumor with the help of an X-ray optical device with a large focal spot and a large aperture angle. Stage 2: the use of a Kumakhov lens with a decreased focal spot (i.e., a higher resolution) to obtain a detailed 3-dimensional image of the tumor. If the focal spot of the lens is adjustable, it is possible to build a device which uses the same Kumakhov lens for Stages 1 and 2.

Sometimes a traditional gamma-chamber may be used in Stage 1 and an X-ray optical device in Stage 2. A complete image may be obtained by X-ray optical device scanning. This method is very rapid since the radiation capture angle is very large. Moreover, it is not necessary to register a great number of photons because signal/background ratio is high.

If a physician knows the approximate location of a tumor, he can rapidly obtain its image with a high resolution. Detection and examination of the tumor may be accomplished using a greatly reduced dose of radiation. For example, a source having an activity of about 0.1 microcurie (about $3 \times 10^3$ photons/s) may be examined in detail during several minutes.

A Kumakhov lens may also collect from an area rather than from a point. The collection lens may have the receiving channels oriented towards a convergent point which lies beyond the area of interest or may have channels which are paraljel on the receiving end. The emitting end of the lens is then oriented at a position sensitive detector providing imaging information.

It is difficult to control radiation direction and spectrum (leading to damage of healthy tissue) in radiation therapy. At present irradiation of inoperable brain tumors is done with the help of oriented collimators using Co isotopes as a source. Unfortunately, drawbacks of the method include high cost, system bulk and weight, ecological danger, fixed irradiation energy and large focusing spot. Fortunately, by using a standard X-ray source and a Kumakhov lens it is possible to focus the radiation at a point, thereby providing an appropriate dose. The focal spot of the X-ray optical device may be changed from several microns to a centimeter depending upon tumor size. Radiation energy can also be varied by changing the anode in the X-ray tube.

By using a highly collimated beam, the material to be irradiated receives a much higher dose than the surrounding healthy tissue and multiple parallel or convergent beams may be used.

Focusing beams and tailoring band widths improves radiation therapy. For example, OJ electron excitation is quite attractive when a convergent beam can be used on the volume of interest. The necessary dose of radiation can be dramatically reduced by tailoring band width to energies right above the absorption line of elements which have a low fluorescent yield. This beam tailoring may be done by creating a quasi-parallel beam with a Kumakhov lens and a monochromator, or by tailoring band widths with a Kumakhov lens which are wider than a monochromatic beam but narrow enough so that all the photons are at energies with high absorption.

Neutron capture therapy is concentrated on boron neutron capture. Problems with the current technology include the inability to filter gamma rays and higher energy neutrons from the beams and the inability to focus a neutron beam.

The subject invention includes a device which uses a Kumakhov lens to filter out the gamma rays and higher energy neutrons, thereby reducing the radiation dose received by the patient. Also possible is the use of a Kumakhov lens which forms a convergent beam. Convergent beams increase the dose the targeted area will receive while simultaneously reducing the radiation intensity experienced by the healthy tissue near the surface. For large tumors either a Kumakhov lens with a large focal spot can be used, or a lens with a smaller focal spot can scan the tumor.

Including a Kumakhov lens in a conventional planer X-ray imaging device has several advantages. A Kumakhov lens can capture a large solid angle of radiation emitted from the point source making it possible to use lower power sources and/or not push the radiation sources as hard, thereby extending their life. The use of a Kumakhov lens to select the band width mitigates beam hardening. Softer X-rays which increase radiation to the subject but do not pass through the subject with a high enough probability to increase the quality of the image can be eliminated. There are other simple filters which can be used to remove undesired lower energy radiation. However, removing higher energy than desired radiation is possible with a Kumakhov lens but extremely difficult by any other means. These higher energy photons degrade sensitivity because very few of them are absorbed by the subject. Some collimation can also be achieved by use of the Kumakhov lens.

Analysis can be performed by X-ray fluorescence to determine the level of selected elements. Such measurements can be done to determine the presence and concentration of undesirable heavy elements accumulated in the body. Without use of a Kumakhov lens, this method is typically impractical in vivo because healthy tissue receives a high radiation dose, high background noise results from from scattering, and low signal to noise occurs because of the low collection efficiency for the photons of interest.

A Kumakhov lens can be used to collect X-rays from a divergent source and focus those X-rays on the area to be evaluated. Another lens with its image focal spot congruent with that of the first lens collects divergent photons and concentrates them on an energy sensitive detector. Radiation exposure, both total and local, to the patient is minimized; the measurement is selective for the area of interest; collection efficiency is increased; and the signal to background is improved. Further enhancements include tailoring beam band width to photons just above the absorption line for the element of interest by using a Kumakhov lens for tailoring the band width or by using a monochromator to obtain a monochromatic beam. Another possible enhancement is accomplished by modifying the collection Kumakhov lens so it collects from an area of other than circular cross-section to obtain an average measurement across an area.

The invention described hereinabove is mainly an illustration of the principle of controlling gamma and X-ray radiation and particles, and is accompanied by a description of specific embodiments thereof.

## Claims

1. A device (100, 200, 300, 400, 500, 600, 700, 800, 900, 1000, 1100, 1200, 1300) for controlling radiation in the form of X-ray or gamma-ray beams or beams of neutrons, ions, or other charged particles,

   the device comprising a plurality of channels (202, 502, 902, 1401-1403) having input butt-ends (104, 204, 304, 404, 504, 904, 1004, 1104, 1404) capturing the radiation, inner surfaces exhibiting multiple total external reflections and output butt-ends (106, 206, 306, 406, 506, 906, 1006, 1106, 1406) emitting the radiation, said channels being formed by channel-forming elements (13, 113, 213, 313, 413, 513, 613, 713, 813, 913, 1013, 1113, 1213, 1313, 1413) located along generatrices of imaginary controlled surfaces,

   **characterised in that**

   - said channel-forming elements (13, 113, 213, 313, 413, 513, 613, 713, 813, 913, 1013, 1113, 1213, 1313, 1413) are spatially located with a rigid support structure, and
   - at least one of said channel-forming elements comprises a bundle of capillaries.

2. The device of claim 1, wherein the radial width of each input butt-end (D) satisfies $D_1 <= 2\theta_D F + D$, where:

   $D_1$   is the effective diameter of the radiation source from which radiation is captured,
   $\theta_D$   is the minimum critical angle of total external reflection in a specified spectral band, and
   $F$   is the distance of the radiation source to the input butt-end measured along a central axis.

3. The device of claim 1 or 2, wherein the bundle of capillaries (13, 113, 213, 313, 413, 513, 613, 713, 813, 913, 1013, 1113, 1213, 1313, 1413) is a plurality of interconnected capillaries.

4. The device of any of the preceding claims, wherein said bundles of capillaries (13, 113, 213, 313, 413, 513, 613, 713, 813, 913, 1013, 1113, 1213, 1313, 1413) are located along generatrices of said imaginary controlled surfaces.

5. The device of any of the preceding claims, wherein said imaginary controlled surfaces are imaginary coaxial barrel-shaped surfaces.

6. The device (200, 500, 900, 1400) of any of the preceding claims, characterized in that the channel width of each channel (202, 502, 902, 1401-1403) is variable along the length of the channel.

7. The device (200, 500, 900) of claim 6, characterized in that each channel (202, 502, 902) has a generally tapered shape over at least a portion of its length.

8. The device (500) of claim 7, characterized in that the width of the channels (502) at the output butt-ends (506) is greater than or equal to their width at the input butt-ends (504).

9. The device (200, 500) of claim 6, characterized in that the channel width of each channel (202, 502) is variable along the length of each channel and approximately proportional to the diameter of the device (200, 500) in each cross section of said device.

10. The device (200) of any of the claims 1 to 5, characterized in that the channel width (D) at the input butt-ends (204) is less than is necessary to achieve

$$\frac{(R\,\theta_{cr})^2}{2D} > 1,$$

where R is a radius of curvature of the channel (202), $\theta_{cr}$ is the critical angle of total external reflection for the energy of interest and D is the width of the channel.

11. The device (100, 200, 300, 400, 500, 700, 1300, 1400) of any of the claims 1 to 5, characterized in that the input butt-ends (104, 204, 304, 404, 504, 1304, 1404) of the device are oriented to capture divergent radiation.

12. The device (800, 900, 1000, 1100, 1200) of any of the claims 1 to 5, characterized in that the input butt-ends (904, 1004, 1104) of the device are oriented to capture parallel radiation.

13. The device (100, 200, 400, 1100) of any of the claims 1 to 5, characterized in that the output butt-ends (106, 206, 406, 1106) of the device are oriented to form a convergent beam.

14. The device (300, 500, 700, 800, 900, 1000, 1400) of any of the claims 1 to 5, characterized in that the output butt-ends (306, 506, 906, 1006, 1406) of the device are oriented to form a quasi-parallel beam.

15. The device of claim 14, characterized in that the length of each channel (902) is chosen to provide a desired attenuation of radiation flux to control the radiation intensity across the beam cross section emitted from the output butt-ends (306, 506, 906, 1006, 1406).

16. The device of claim 14, characterized in that the spacing at the butt-ends between the channels (902) is not constant across the device cross section to control the radiation intensity across the beam cross section emitted from the output butt-ends.

17. The device (300, 500) of claim 14, characterized in that the device further includes a planar cristal (550) positioned relative to the output butt-ends (306, 506) to be irradiated in operation with a quasi-parallel beam emitted from the output butt-ends (306, 506).

18. The device of any of the claims 1 to 5, characterized in that the channel forming elements (13, 113, 213, 313, 413, 513, 613, 713, 813, 913, 1113, 1213, 1313, 1413) are shaped so that the output butt-ends (106, 206, 306, 406, 906, 1006, 1106, 1406) are flared outwardly to reduce divergence of the beam emitted from the output butt-ends.

19. The device of claim 18, characterized in that the output butt-ends (106, 206, 306, 406, 906, 1006, 1106, 1406) are oriented to form a quasi-parallel beam.

20. The device of claim 19, characterized in that the channel forming elements (13, 113, 213, 313, 413, 513, 613, 713, 813, 913, 1113, 1213, 1313, 1413) are shaped so that the outwardly flared output butt-ends (106, 206, 306, 406, 906, 1006, 1106, 1406) of the device define a tapered angle less than or equal to the expression ($\theta$ - $DL_i$), where $\theta$ is a specified divergence angle of the quasi-parallel beam, $L_i$ is the length of the outwardly flat end portion of the channel, and D is the width of the channel.

21. The device (1400) of any of the claims 1 to 5, characterized in that the channel forming elements (1413, 1413') are shaped to form channels (1401, 1402, 1403) having a varying direction of the central axis of beam propagation.

22. The device of any of the claims 1 to 5, characterized in that the beam cross section changes in shape.

23. The device of any of the claims 1 to 5, characterized in that the beam is split or beams are combined.

24. The device (300, 700, 900, 1300, 1400) of any of the claims 1 to 5, characterized in that the channel forming elements (313, 713, 913, 1313, 1413) have compound curvature.

25. The device (300, 700, 1400) of claim 24, characterized in that the input butt-ends (304, 1404) are oriented to capture divergent radiation and the output butt-ends (306, 1406) are oriented to form a quasi-parallel beam emitted from the output butt-ends.

26. The device (300) of claim 25, characterized in that the channel forming elements (313) extend along a generatrices of imaginary toroidal surfaces conjugate to corresponding ones of said barrel-shaped surfaces.

27. The device of any of the claims 1 to 5, further comprising a partial or complete external casing made of material opaque to the controlled beam radiation, the casing having apertures aligned with the input butt-ends (104, 204, 304, 404, 504, 904, 1004, 1104, 1404) and the output butt-ends (106, 206, 306, 406, 506, 906, 1006, 1106, 1406) of the channels (202, 502, 902, 1401-1403).

28. The device of claim 27, characterized in that straight line transmission of radiation between the apertures is blocked.

29. The device (100) of any of the claims 1 to 5, characterized in that the device (100) comprises a plurality of channel forming elements (113) comprising a bundle of capillaries, and that the rigid support structure includes a plurality of discs or plates (4) having apertures (5) for locating and supporting the channel forming elements.

30. The device (100) of claim 29, characterized in that at least one of the discs (4) is selectively translatable along the central axis of the device (100) relative to at least one other disc (4).

31. The device (400) according one of the claims 1 to 5, characterized in that each channel forming element (413) comprises a bundle of capillaries, and that the rigid support structure is formed by a compound filling gaps between the bundles of capillaries.

32. The device (100, 200, 300, 500, 900, 1000, 1400) of any of the claims 1 to 5, characterized in that each channel forming element (113, 213, 313, 513, 913, 1013, 1413) comprises a bundle of capillaries extending side by side in a length with relationship, adjacent capillaries being joined together at outer surface portions substantially along their entire length.

33. Device of any of the claims 1 to 5, characterized in that the rigid support structure is rotatable mounted arround the central axis of beam propagation.

34. The device of any of the claims 1 to 5, characterized by a radiation-absorption filter for controlling the intensity of the beam across the beam cross section.

35. The device of any of the claims 1 to 5, characterized in that the channel forming elements (13, 113, 213, 313, 413, 513, 613, 713, 813, 913, 1013, 1113, 1213, 1313, 1413) are surrounded with a thermally conductive material that is cooled.

36. The device of any of the claims 1 to 5, characterized in that interior surface portions of the channel forming elements (13, 113, 213, 313, 413, 513, 613, 713, 813, 913, 1013, 1113, 1213, 1313, 1413) are composed of materials which selectively absorb radiation of predetermined energy bands.

37. The device of claim 36, characterized in that interior surface portions of the channel forming elements (13, 113, 213, 313, 413, 513, 613, 713, 813, 913, 1013, 1113, 1213, 1313, 1413) are coated with copper.

38. The device of claim 36, characterized in that interior surface portions of the channel forming elements (13, 113, 213, 313, 413, 513, 613, 713, 813, 913, 1013, 1113, 1213, 1313, 1413) are coated with beryllium.

39. The device of any of the claims 1 to 5, characterized in that the channel forming elements (13, 113, 213, 313, 413, 513, 613, 713, 813, 913, 1013, 1113, 1213, 1313, 1313) are shaped to define channels having cross-sectional shapes which are substantially rectangular.

40. The device of any of the claims 1 to 5, characterized in that interior surface portions of the channel forming elements are made of or coated with electrically conductive material.

41. The device (300, 500, 700, 800, 900, 1000, 1400) of claim 40, characterized in that the device further includes a tapered capillary (560) positioned for receiving radiation passing from the output butt-ends (506), the tapered capillary (560) having a longitudinal axis which extends in substantial alignment with the radiation-emission axis defined with respect to the output butt-ends (506), the tapered capillary (560) decreasing in width as the distance from the output butt-ends (506) increases.

42. The device of any of the claims 1 to 5, characterized in that the channel forming elements (13, 113, 213, 313, 413, 513, 613, 713, 813, 913, 1013, 1113, 1213, 1313, 1413) are shaped such that the radiation is reflected at angles near the critical angle for total external reflection of the highest energy for which high transmission efficiency is desired.

43. The device of claim 42, characterized in that the channel forming elements (13, 113, 213, 313, 413, 513, 613, 713, 813, 913, 1013, 1113, 1213, 1313, 1413) are shaped to define two arcuate portions of the channels respectively curving in substantially opposing directions.

44. The device of claim 42, characterized in that the device further includes ajustment means for adjusting the curvature of the channels.

45. An X-ray lithography system (1502, 1504, 1506, 1508, 1510) comprising a device (300, 500, 900) of any of the claims 1 to 44 located between an X-ray source (1505) and a mask (1503).

46. The X-ray lithography system (1502, 1504, 1506) of claim 45, characterized in that the channels (502, 509) are oriented to form a quasi-parallel beam of radiation.

47. The X-ray lithography system (1502, 1504, 1506) of claim 46, characterized in that the distance between the mask (1503) and the output butt-ends (306, 506, 906) is sufficient to homogenize any difference in beam intensity caused by the discrete pattern of the channels (502, 902).

48. An analytic instrument (1602, 1608, 1610, 1612) comprising a device of any of the claims 1 to 44, located between the radiation source (1605) and a sample (1603) to be analyzed, and a radiation detector (1607).

49. The analytic instrument (1604, 1606, 1608) comprising a device of any of the claims 1 to 44, located between a sample (1603) to be analyzed and a radiation detector (1607), and a radiation source (1605).

50. The analytic instrument (1602, 1604, 1606, 1608, 1610, 1612) of claim 48 or 49, characterized in that the analytic instrument is an X-ray device, an ionic device, an neutron device or an electron beam device.

51. The analytic instrument (1602, 1604, 1606, 1608, 1610, 1612) of claim 50, characterized in that the analytic instrument is an X-ray fluorescence device, an X-ray microscope, an X-ray diffraction device, an ion microscope, a neutron microscope or a neutron diffraction device.

52. A medical device (1702, 1704, 1706, 1708, 1710) comprising a device (300, 500, 1300, 1400) of any of the claims 1 to 44.

53. The medical system (1702, 1704, 1706, 1708, 1710) of claim 52, characterized in that the medical system is an angiographic system (1702, 1704, 1706), an endoscope (1710), a neutron capture therapy system or a tomography system (1708).

54. The medical system (1702, 1704, 1706, 1708, 1710) of claim 52 or 53, characterized in that the system further comprises a radiation source (1705), and that the device (300, 500, 1300, 1400) emits a convergent beam onto a subject (1703).

55. The medical system (1702, 1704, 1706, 1708, 1710) of claim 54, characterized in that the device (300, 500, 1300, 1400) is located between the radiation source (1705) and the subject (1703).

56. The medical system (1702, 1704, 1706, 1708, 1710) of claim 54, characterized in that the medical system further comprises a radiation detector, and that the device (300, 500, 1300, 1400) is located between the subject (1703) and the radiation detector.

57. An energy-selective radiation filter comprising a device of any of the claims 1 to 44.

58. The radiation filter of claim 57, characterized in that the radiation filter comprises a second device according to any of the claims 1 to 44, wherein the first device forms a quasi-parallel beam and the second device focus the beam into a preselect band of energies.

**59.** The radiation filter of claim 57, characterized in that the device includes substantially straight line portions extending generally normal to the direction of propagation of the radiation beam.

**60.** The radiation filter of claim 59, characterized in that the input butt-ends of the device have a cross-sectional shape which is substantially rectangular.

**Patentansprüche**

**1.** Vorrichtung (100, 200, 300, 400, 500, 600, 700, 800, 900, 1000, 1100, 1200, 1300) zum Steuern von Strahlung in der Form von Röntgen- oder Gammastrahlen, oder Strahlen von Neutronen, Ionen, oder anderen geladenen Teilchen,

wobei die Vorrichtung eine Vielzahl von Kanälen (202, 502, 902, 1401-1403) mit Eingangsenden (104, 204, 304, 404, 504, 904, 1004, 1104, 1404), die die Strahlung einfangen, Innenflächen, die mehrfache totale Oberflächenreflektionen zeigen und Ausgangsenden (106, 206, 306, 406, 506, 906, 1006, 1106, 1406) aufweist, die die Strahlung emittieren,

wobei die Kanäle durch kanalbildende Elemente (13, 113, 213, 313, 413, 513, 613, 713, 813, 913, 1013, 1113, 1213, 1313, 1413) gebildet sind, die entlang Erzeugender imaginärer Flächen angeordnet sind,

**dadurch gekennzeichnet, daß**

- die kanalbildenden Elemente (13, 113, 213, 313, 413, 513, 613, 713, 813, 913, 1013, 1113, 1213, 1313, 1413) räumlich durch eine feste Haltestruktur angeordnet sind, und

- mindestens ein kanalbildendes Element ein Bündel von Kapillaren aufweist.

**2.** Vorrichtung nach Anspruch 1, dadurch gekennzeichnet, daß die radiale Abmessung jedes Eingangsendes (D) der Gleichung $D_1 <= 2\theta_D F + D$ genügt, wobei:

$D_1$  der effektive Durchmesser der Strahlungsquelle ist, deren Strahlung eingefangen wird,

$\theta_D$  der kleinste Grenzwinkel von Totalreflektion in einem bestimmten spektralen Band ist, und

F  der Abstand der Strahlungsquelle zu dem Eingangsende gemessen entlang einer Mittelachse ist.

**3.** Vorrichtung nach Anspruch 1 oder 2, dadurch gekennzeichnet, daß das Bündel von Kapillaren (13, 113, 213, 313, 413, 513, 613, 713, 813, 913, 1013, 1113, 1213, 1313, 1413) eine Vielzahl miteinander verbundener Kapillaren ist.

**4.** Vorrichtung nach einem der vorhergehenden Ansprüche, dadurch gekennzeichnet, daß die Bündel von Kapillaren (13, 113, 213, 313, 413, 513, 613, 713, 813, 913, 1013, 1113, 1213, 1313, 1413) entlang Erzeugender imaginärer Flächen angeordnet sind.

**5.** Vorrichtung nach einem der vorhergehenden Ansprüche, dadurch gekennzeichnet, daß die imaginären Flächen imaginäre koaxiale tonnenförmige Flächen sind.

**6.** Vorichtung (200, 500, 900, 1400) nach einem der vorhergehenden Ansprüche, dadurch gekennzeichnet, daß die Kanalbreite von jedem Kanal (202, 502, 902, 1401-1403) mit dem Verlauf des Kanals variiert.

**7.** Vorrichtung (200, 500, 900) nach Anspruch 6, dadurch gekennzeichnet, daß jeder Kanal (202, 502, 902) zumindest in einem Abschnitt seines Verlaufs eine im großen und ganzen konische oder sich verjüngende Gestalt aufweist.

**8.** Vorrichtung (500) nach Anspruch 7, dadurch gekennzeichnet, daß die Breite der Kanäle (502) bei den Ausgangsenden (506) größer oder gleich der Breite der Kanäle an den Eingangsenden (504) ist.

**9.** Vorrichtung (200, 500) nach Anspruch 6, dadurch gekennzeichnet, daß die Kanalbreite jedes Kanals (202, 502) mit dem Verlauf jedes Kanals variiert und in jedem Querschnitt der Vorrichtung ungefähr proportional zu dem Durchmesser der Vorrichtung (200, 500) ist.

10. Vorrichtung (200) nach einem der Ansprüche 1 bis 5, dadurch gekennzeichnet, daß die Kanalbreite (D) an den Eingangsenden (204) geringer ist, als es notwendig ist, damit die Ungleichung

$$\frac{(R\,\theta_{cr})^2}{2D} > 1,$$

erfüllt ist, wobei R der Krümmungsradius des Kanals (202), $\theta_{cr}$ der kritische Winkel der Totalreflektion für die in Betracht kommende Energie und D die Breite des Kanals ist.

11. Vorrichtung (100, 200, 300, 400, 500, 700, 1300, 1400) nach einem der Ansprüche 1 bis 5, dadurch gekennzeichnet, daß die Eingangsenden (104, 204, 304, 404, 504, 1304, 1404) der Vorrichtung ausgerichtet sind, um eine divergente Strahlung einzufangen.

12. Vorrichtung (800, 900, 1000, 1100, 1200) nach einem der Ansprüche 1 bis 5, dadurch gekennzeichnet, daß die Eingangsenden (904, 1004, 1104) der Vorrichtung ausgerichtet sind, um parallele Strahlung einzufangen.

13. Vorrichtung (100, 200, 400, 1100) nach einem der Ansprüche 1 bis 5, dadurch gekennzeichnet, daß die Ausgangsenden (106, 206, 406, 1106) der Vorrichtung ausgerichtet sind, um einen konvergenten Strahl zu bilden.

14. Vorrichtung (300, 500, 700, 800, 900, 1000, 1400) nach einem der Ansprüche 1 bis 5, dadurch gekennzeichnet, daß die Ausgangsenden (306, 506, 906, 1006, 1406) der Vorrichtung ausgerichtet sind, um einen quasi-parallelen Strahl zu bilden.

15. Vorrichtung nach Anspruch 14, dadurch gekennzeichnet, daß die Länge jedes Kanals (904) gewählt ist, um eine erwünschte Abschwächung des Strahlungsflusses zu schaffen, damit die Strahlungsintensität über den Strahlquerschnitt reguliert wird, die aus den Ausgangsenden (306, 506, 906, 1006, 1406) emittiert wird.

16. Vorrichtung nach Anspruch 14, dadurch gekennzeichnet, daß der Abstand zwischen den Kanälen (902) an den Enden nicht über den Querschnitt der Vorrichtung konstant ist, damit die Strahlungsintensität über den Strahlungsquerschnitt reguliert wird, die aus den Ausgangsenden emittiert wird.

17. Vorrichtung (300, 500) nach Anspruch 14, dadurch gekennzeichnet, daß die Vorrichtung überdies einen ebenen Kristall (550) aufweist, der relativ zu den Ausgangsenden (306, 506) angeordnet ist, um beim Betrieb mit einem quasi-parallelen Strahl bestrahlt zu werden, der von den Ausgangsenden (306, 506) emittiert wird.

18. Vorrichtung nach einem der Ansprüche 1 bis 5, dadurch gekennzeichnet, daß die kanalbildenden Elemente (13, 113, 213, 313, 413, 513, 613, 713, 813, 913, 1113, 1213, 1313, 1413) derart ausgebildet sind, daß sich die Ausgangsenden (106, 206, 306, 406, 906, 1006, 1106, 1406) nach außen ausstellen, um die Divergenz des Strahls zu vermindern, der von den Ausgangsenden emittiert wird.

19. Vorrichtung nach Anspruch 18, dadurch gekennzeichnet, daß die Ausgangsenden (106, 206, 306, 406, 906, 1006, 1106, 1406) ausgerichtet sind, um einen quasi-parallelen Strahl zu bilden.

20. Vorrichtung nach Anspruch 19, dadurch gekennzeichnet, daß die kanalbildenden Elemente (13, 113, 213, 313, 413, 513, 613, 713, 813, 913, 1113, 1213, 1313, 1413) derart ausgebildet sind, daß die nach außen ausgestellten Ausgangsenden (106, 206, 306, 406, 906, 1006, 1106, 1406) der Vorrichtung einen spitzen Winkel bestimmen, der kleiner oder gleich dem Ausdruck ($\theta$ - $DL_i$) ist, wobei $\theta$ ein bestimmter Divergenzwinkel des quasi-parallelen Strahls, $L_i$ die Länge des nach außen ausgestellten Endabschnitts des Kanals und D die Breite des Kanals ist.

21. Vorrichtung (1400) nach einem der Ansprüche 1 bis 5, dadurch gekennzeichnet, daß die kanalbildenden Elemente (1413, 1413') ausgebildet sind, um Kanäle (1401, 1402, 1403) mit einer sich verändernden Richtung der Mittelachse des Strahlungsverlaufs zu bilden.

22. Vorrichtung nach einem der Ansprüche 1 bis 5, dadurch gekennzeichnet, daß sich die Form des Strahlungsquerschnitts ändert.

23. Vorrichtung nach einem der Ansprüche 1 bis 5, dadurch gekennzeichnet, daß der Strahl gespalten oder Strahlen vereinigt werden.

24. Vorrichtung (300, 700, 900, 1300, 1400) nach einem der Ansprüche 1 bis 5, dadurch gekennzeichnet, daß die kanalbildenden Elemente (313, 713, 913, 1313, 1413) eine zusammengesetzte Krümmung aufweisen.

25. Vorrichtung (300, 700, 1400) nach Anspruch 24, dadurch gekennzeichnet, daß die Eingangsenden (304, 1404) ausgerichtet sind, um divergente Strahlung einzufangen, und die Ausgangsenden (306, 1406) ausgerichtet sind, um einen quasi-parallelen Strahl zu bilden, der von den Ausgangsenden emittiert wird.

26. Vorrichtung (300) nach Anspruch 25, dadurch gekennzeichnet, daß die kanalbildenden Elemente (313) entlang Erzeugender imaginärer ringförmiger Flächen verlaufen, die mit entsprechenden tonnenförmigen Flächen verbunden sind.

27. Vorrichtung nach einem der Ansprüche 1 bis 5, gekennzeichnet durch ein teilweises oder komplettes Außengehäuse aus einem für die Strahlung des gesteuerten Strahls, undurchlässigen Material, wobei das Gehäuse mit den Eingangsenden (104, 204, 304, 404, 504, 904, 1004, 1104, 1404) und den Ausgangsenden (106, 206, 306, 406, 506, 906, 1006, 1106, 1406) der Kanäle (202, 502, 902, 1401-1403) ausgerichtete Öffnungen aufweist.

28. Vorrichtung nach Anspruch 27, dadurch gekennzeichnet, daß der geradlinige Durchtritt von Strahlung zwischen den Öffnungen blockiert ist.

29. Vorrichtung (100) nach einem der Ansprüche 1 bis 5, dadurch gekennzeichnet, daß die Vorrichtung (100) eine Vielzahl von kanalbildenden Elementen (113) mit einem Bündel von Kapillaren aufweist, und daß die feste Haltestruktur eine Vielzahl von Scheiben oder Platten (4) mit Öffnungen (5) zum Anordnen und Halten der kanalbildenden Elemente aufweist.

30. Vorrichtung (100) nach Anspruch 29, dadurch gekennzeichnet, daß mindestens eine der Scheiben (4) selektiv entlang der Mittelachse der Vorrichtung (100) relativ zu mindestens einer weiteren Scheibe (4) verschiebbar ist.

31. Vorrichtung (400) nach einem der Ansprüche 1 bis 5, dadurch gekennzeichnet, daß jedes kanalbildende Element (413) ein Bündel von Kapillaren aufweist, und daß die feste Haltestruktur durch einen Compound oder eine Vergußmasse gebildet ist, der die Lücken zwischen den Kapillarbündeln ausfüllt.

32. Vorrichtung (100, 200, 300, 500, 900, 1000, 1400) nach einem der Ansprüche 1 bis 5, dadurch gekennzeichnet, daß jedes kanalbildende Element (113, 213, 313, 513, 913, 1013, 1413) ein Bündel von Kapillaren aufweist, das Seite an Seite über eine Strecke verläuft, wobei benachbarte Kapillaren miteinander an außenliegenden Oberflächenbereichen im wesentlichen entlang ihrer gesamten Länge miteinander verbunden sind.

33. Vorrichtung nach einem der Ansprüche 1 bis 5, dadurch gekennzeichnet, daß die feste Haltestruktur drehbar um die Mittelachse des Strahlungsverlaufs angeordnet ist.

34. Vorrichtung nach einem der Ansprüche 1 bis 5, gekennzeichnet durch einen Strahlungsabsorptionsfilter zur Regelung der Intensität der Strahlung über den Strahlungsquerschnitt.

35. Vorrichtung nach einem der Ansprüche 1 bis 5, dadurch gekennzeichnet, daß die kanalbildenden Elemente (13, 113, 213, 313, 413, 513, 613, 713, 813, 913, 1013, 1113, 1213, 1313, 1413) von einem thermisch leitfähigen Material umgeben sind, das gekühlt wird.

36. Vorrichtung nach einem der Ansprüche 1 bis 5, dadurch gekennzeichnet, daß Abschnitte von Innenflächen der kanalbildenden Elemente (13, 113, 213, 313, 413, 513, 613, 713, 813, 913, 1013, 1113, 1213, 1313, 1413) aus Materialien zusammengesetzt sind, die selektiv Strahlung bestimmter Energiebanden absorbieren.

37. Vorrichtung nach Anspruch 36, dadurch gekennzeichnet, daß die Abschnitte der Innenflächen der kanalbildenden Elemente (13, 113, 213, 313, 413, 513, 613, 713, 813, 913, 1013, 1113, 1213, 1313, 1413) mit Kupfer beschichtet sind.

38. Vorrichtung nach Anspruch 36, dadurch gekennzeichnet, daß die Abschnitte der Innenflächen der kanalbildenden Elemente (13, 113, 213, 313, 413, 513, 613, 713, 813, 913, 1013, 1113, 1213, 1313, 1413) mit Beryllium beschichtet sind.

39. Vorrichtung nach einem der Ansprüche 1 bis 5, dadurch gekennzeichnet, daß die kanalbildenden Elemente (13, 113, 213, 313, 413, 513, 613, 713, 813, 913, 1013, 1113, 1213, 1313, 1413) ausgebildet sind, um Kanäle mit Querschnittsformen zu bestimmen, die im wesentlichen rechteckig sind.

40. Vorrichtung nach einem der Ansprüche 1 bis 5, dadurch gekennzeichnet, daß die Abschnitte der Innenflächen der kanalbildenden Elemente aus elektrisch leitfähigem Material bestehen oder damit beschichtet sind.

41. Vorrichtung (300, 500, 700, 800, 900, 1000, 1400) nach Anspruch 40, dadurch gekennzeichnet, daß die Vorrichtung überdies eine konische Kapillare (560) aufweist, die zur Aufnahme von Strahlung angeordnet ist, die aus den Ausgangsenden (506) tritt, wobei die konische Kapillare (560) eine Längsachse aufweist, die im wesentlichen mit der Strahlungsemissionsachse ausgerichtet ist, die bezüglich der Ausgangsenden (506) festgelegt ist, wobei die konische Kapillare (560) im Durchmesser mit wachsenden Abstand von den Ausgangsenden (506) abnimmt.

42. Vorrichtung nach einem der Ansprüche 1 bis 5, dadurch gekennzeichnet, daß die kanalbildenden Elemente (13, 113, 213, 313, 413, 513, 613, 713, 813, 913, 1013, 1113, 1213, 1313, 1413) derart ausgebildet sind, daß die Strahlung unter Winkeln in der Nähe des Grenzwinkels für Totalreflektion der größten Energie reflektiert wird, für die ein hoher Transmissionswirkungsgrad erwünscht ist.

43. Vorrichtung nach Anspruch 42, dadurch gekennzeichnet, daß die kanalbildenden Elemente (13, 113, 213, 313, 413, 513, 613, 713, 813, 913, 1013, 1113, 1213, 1313, 1413) ausgebildet sind, um zwei Kurvenabschnitte der Kanäle festzulegen, die jeweils in im wesentlichen entgegengesetzten Richtungen verlaufen.

44. Vorrichtung nach Anspruch 42, dadurch gekennzeichnet, daß die Vorrichtung überdies eine Einstelleinrichtung zur Einstellung der Krümmung der Kanäle aufweist.

45. Röntgenlithographiesystem (1502, 1504, 1506, 1508, 1510) mit einer Vorrichtung (300, 500, 900) nach einem der Ansprüche 1 bis 44, die zwischen einer Röntgenquelle (1505) und einer Maske (1503) angeordnet ist.

46. Röntgenlithographiesystem (1502, 1504, 1506) nach Anspruch 45, dadurch gekennzeichnet, daß die Kanäle (502, 509) ausgerichtet sind, um einen quasi-parallelen Strahl an Strahlung zu bilden.

47. Röntgenlithographiesystem (1502, 1504, 1506) nach Anspruch 46, dadurch gekennzeichnet, daß der Abstand zwischen der Maske (1503) und den Ausgangsenden (306, 506, 906) ausreicht, um irgendwelche Differenzen in der Strahlungsintensität auszugleichen, die durch die diskreten Muster der Kanäle (502, 902) bewirkt wird.

48. Analytisches Instrument (1602, 1608, 1610, 1612) mit einer Vorrichtung nach einem der Ansprüche 1 bis 44, die zwischen der Strahlungsquelle (1605) und einer zu analysierenden Probe 1603) angeordnet ist, und einem Strahlungsdetektor (1607).

49. Analytisches Instrument (1604, 1606, 1608) mit einer Vorrichtung nach einem der Ansprüche 1 bis 44, die zwischen einer zu analysierenden Probe (1603) und einem Strahlungsdetektor (1607) angeordnet ist, und einer Strahlungsquelle (1605).

50. Analytisches Instrument (1602, 1604, 1606, 1608, 1610, 1612) nach Anspruch 48 oder 49, dadurch gekennzeichnet, daß das analytische Instrument eine Röntgenvorrichtung, eine Ionenvorrichtung, eine Neutronenvorrichtung oder eine Elektronenstrahlvorrichtung ist.

51. Analytisches Instrument (1602, 1604, 1606, 1608, 1610, 1612) nach Anspruch 50, dadurch gekennzeichnet, daß das analytische Instrument eine Röntgenfluoreszenzvorrichtung, ein Röntgenmikroskop, eine Röntgendiffraktionsvorrichtung, ein Ionenmikroskop, ein Neutronenmikroskop oder eine Neutronendiffraktionsvorrichtung ist.

52. Medizinische Vorrichtung (1702, 1704, 1706, 1708, 1710) mit einer Vorrichtung (300, 500, 1300, 1400) nach einem der Ansprüche 1 bis 44.

53. Medizinisches System (1702, 1704, 1706, 1708, 1710) nach Anspruch 52, dadurch gekennzeichnet, daß das medizinische System ein angiographisches System (1702, 1704, 1706), ein Endoskop (1710), ein Neutroneneinfang-Therapiesystem oder ein Tomographiesystem (1708) ist.

54. Medizinisches System (1702, 1704, 1706, 1708, 1710) nach Anspruch 52 oder 53, dadurch gekennzeichnet, daß das System überdies eine Strahlungsquelle (1705) aufweist, und daß die Vorrichtung (300, 500, 1300, 1400) einen konvergenten Strahl auf ein Subjekt (1703) emittiert.

55. Medizinisches System (1702, 1704, 1706, 1708, 1710) nach Anspruch 54, dadurch gekennzeichnet, daß die Vorrichtung (300, 500, 1300, 1400) zwischen der Strahlungsquelle (1705) und dem Subjekt (1703) angeordnet ist.

56. Medizinisches System (1702, 1704, 1706, 1708, 1710) nach Anspruch 54, dadurch gekennzeichnet, daß das medizinische System überdies einen Strahlungsdetektor aufweist, und daß die Vorrichtung (300, 500, 1300, 1400) zwischen dem Subjekt (1703) und dem Strahlungsdetektor angeordnet ist.

57. Energieselektiver Strahlungsfilter mit einer Vorrichtung nach einem der Ansprüche 1 bis 44.

58. Strahlungsfilter nach Anspruch 57, dadurch gekennzeichnet, daß der Strahlungsfilter eine zweite Vorrichtung nach einem der Ansprüche 1 bis 44 aufweist, wobei die erste Vorrichtung einen quasi-parallelen Strahl bildet und die zweite Vorrichtung den Strahl in ein bestimmtes Energieband konzentriert.

59. Strahlungsfilter nach Anspruch 57, dadurch gekennzeichnet, daß die Vorrichtung im wesentlichen gerade Linienabschnitte aufweist, die im großen und ganzen senkrecht zu der Ausbreitungsrichtung des Strahls der Strahlung verlaufen.

60. Strahlungsfilter nach Anspruch 59, dadurch gekennzeichnet, daß die Eingangsenden der Vorrichtung eine Querschnittsform aufweisen, die im wesentlichen rechteckig ist.

**Revendications**

1. Dispositif (100, 200, 300, 400, 500, 600, 700, 800, 900, 1000, 1100, 1200, 1300) pour commander un rayonnement ayant la forme de faisceaux de rayons X ou de rayons gamma ou de faisceaux de neutrons, d'ions ou d'autres particules chargées,

   le dispositif comportant plusieurs canaux (202, 502, 902, 1401 à 1403) ayant des extrémités d'entrée (104, 204, 304, 404, 504, 904, 1004, 1104, 1404) capturant le rayonnement, des surfaces intérieures présentant de multiples réflexions auxiliaires totales et des extrémités de sortie (106, 206, 306, 406, 506, 906, 1006, 1106, 1406) émettant le rayonnement,
   lesdits canaux étant formés par des éléments de formation de canal (13, 113, 213, 313, 413, 513, 613, 713, 813, 913, 1013, 1113, 1213, 1313, 1413) positionnés le long de génératrices de surfaces imaginaires commandées,

   caractérisé en ce que

   - lesdits éléments de formation de canal (13, 113, 213, 313, 413, 513, 613, 713, 813, 913, 1013, 1113, 1213, 1313, 1413) sont positionnés spatialellement à l'aide d'une structure de support rigide, et
   - au moins un élément parmi lesdits éléments de formation de canal comporte un faisceau de capillaires.

2. Dispositif selon la revendication 1, dans lequel la largeur radiale de chaque extrémité d'entrée (D) satisfait à l'équa-tion $D_1 \leq 2\theta_D F + D$, dans laquelle :

   $D_1$  est le diamètre efficace de la source de rayonnement à partir de laquelle le rayonnement est capturé,
   $\theta_D$  est l'angle critique minimum de la réflexion auxiliaire totale dans une bande spectrale spécifiée,
   F   est la distance de la source de rayonnement jusqu'à l'extrémité d'entrée, mesurée le long d'un axe central.

3. Dispositif selon la revendication 1 ou 2, dans lequel le faisceau de capillaires (13, 113, 213, 313, 413, 513, 613, 713, 813, 913, 1013, 1113, 1213, 1313, 1413) est constitué d'une pluralité de capillaires interconnectés.

**4.** Dispositif selon l'une quelconque des revendications précédentes, dans lequel lesdits faisceaux de capillaires (13, 113, 213, 313, 413, 513, 613, 713, 813, 913, 1013, 1113, 1213, 1313, 1413) sont positionnés le long de génératrices desdites surfaces imaginaires commandées.

**5.** Dispositif selon l'une quelconque des revendications précédentes, dans lequel lesdites surfaces imaginaires commandées sont des surfaces imaginaires ayant des formes cylindriques coaxiales.

**6.** Dispositif (200, 500, 900, 1400) selon l'une quelconque des revendications précédentes, caractérisé en ce que la largeur de canal de chaque canal (202, 502, 902, 1401 à 1403) est variable le long de la longueur du canal.

**7.** Dispositif (200, 500, 900) selon la revendication 6, caractérisé en ce que chaque canal (202, 502, 902) a une forme de manière générale conique sur au moins une partie de sa longueur.

**8.** Dispositif (500) selon la revendication 7, caractérisé en ce que la largeur des canaux (502) au niveau des extrémités de sortie (506) est supérieure ou égale à leur largeur au niveau des extrémités d'entrée (504).

**9.** Dispositif (200, 500) selon la revendication 6, caractérisé en ce que la largeur de canal de chaque canal (202, 502) est variable le long de la longueur de chaque canal et est approximativement proportionnelle au diamètre du dispositif (200, 500) de chaque coupe transversale dudit dispositif.

**10.** Dispositif (200) selon l'une quelconque des revendications 1 à 5, caractérisé en ce que la largeur de canal (D) au niveau des extrémités d'entrée (204) est plus petite que cela n'est nécessaire pour obtenir

$$\frac{(R\ \theta_{cr})^2}{2\ D} > 1,$$

dans laquelle R est le rayon de courbure du canal (202), $\theta_{cr}$ est l'angle critique de la réflexion auxiliaire totale pour l'énergie concernée et D est la largeur du canal.

**11.** Dispositif (100, 200, 300, 400, 500, 700, 1300, 1400) selon l'une quelconque des revendications 1 à 5, caractérisé en ce que les extrémités d'entrée (104, 204, 304, 404, 504, 1304, 1404) du dispositif sont orientées pour capturer un rayonnement divergent.

**12.** Dispositif (800, 900, 1000, 1100, 1200) selon l'une quelconque des revendications 1 à 5, caractérisé en ce que les extrémités d'entrée (904, 1004, 1104) du dispositif sont orientées pour capturer un rayonnement parallèle.

**13.** Dispositif (100, 200, 400, 1100) selon l'une quelconque des revendications 1 à 5, caractérisé en ce que les extrémités de sortie (106, 206, 406, 1106) du dispositif sont orientées pour former un faisceau convergent.

**14.** Dispositif (300, 500, 700, 800, 900, 1000, 1400) selon l'une quelconque des revendications 1 à 5, caractérisé en ce que les extrémités de sortie (306, 506, 906, 1006, 1406) du dispositif sont orientées pour former un faisceau quasi-parallèle.

**15.** Dispositif selon la revendication 14, caractérisé en ce que la longueur de chaque canal (902) est choisie pour fournir une atténuation voulue du flux de rayonnement pour commander l'intensité du rayonnement à travers la coupe transversale du faisceau émis à partir des extrémités de sortie (306, 506, 906, 1006, 1406).

**16.** Dispositif selon la revendication 14, caractérisé en ce que l'espacement, au niveau des extrémités, entre les canaux (902) n'est pas constant à travers la coupe transversale du dispositif pour commander l'intensité du rayonnement à travers la coupe transversale du faisceau émis à partir des extrémités de sortie.

**17.** Dispositif (300, 500) selon la revendication 14, caractérisé en ce que le dispositif comporte de plus un cristal plan (550) positionné par rapport aux extrémités de sortie (306, 506) pour être irradié en fonctionnement à l'aide d'un faisceau quasi-parallèle émis à partir des extrémités de sortie (306, 506).

**18.** Dispositif selon l'une quelconque des revendications 1 à 5, caractérisé en ce que les éléments de formation de canal (13, 113, 213, 313, 413, 513, 613, 713, 813, 913, 1013, 1113, 1213, 1313, 1413) sont mis en forme de telle sorte que les extrémités de sortie (106, 206, 306, 406, 906, 1006, 1106, 1406) sont évasées vers l'extérieur pour réduire la divergence du faisceau émis à partir des extrémités de sortie.

19. Dispositif selon la revendication 18, caractérisé en ce que les extrémités de sortie (106, 206, 306, 406, 906, 1006, 1106, 1406) sont orientées pour former un faisceau quasi-parallèle.

20. Dispositif selon la revendication 19, caractérisé en ce que les éléments de formation de canal (13, 113, 213, 313, 413, 513, 613, 713, 813, 913, 1013, 1113, 1213, 1313, 1413) sont mis en forme de telle sorte que les extrémités de sortie évasées vers l'extérieur (106, 206, 306, 406, 906, 1006, 1106, 1406) du dispositif définissent un angle de cône inférieur ou égal à l'expression $(\theta - DL_i)$, où $\theta$ est un angle de divergence spécifié du faisceau quasi-parallèle, $L_i$ est la longueur de la partie d'extrémité évasée vers l'extérieur du canal, et D est la largeur du canal.

21. Dispositif (1400) selon l'une quelconque des revendications 1 à 5, caractérisé en ce que les éléments de formation de canal (1413, 1413') sont mis en forme pour former des canaux (1401, 1402, 1403) ayant une direction qui varie par rapport à l'axe central de propagation de faisceau.

22. Dispositif selon l'une quelconque des revendications 1 à 5, caractérisé en ce que la coupe transversale du faisceau a une forme qui change.

23. Dispositif selon l'une quelconque des revendications 1 à 5, caractérisé en ce que le faisceau est divisé ou les faisceaux sont combinés.

24. Dispositif (300, 700, 900, 1300, 1400) selon l'une quelconque des revendications 1 à 5, caractérisé en ce que les éléments de formation de canal (313, 713, 913, 1313, 1413) ont une courbure composée.

25. Dispositif (300, 700, 1400) selon la revendication 24, caractérisé en ce que les extrémités d'entrée (304, 1404) sont orientées pour capturer un rayonnement divergent et les extrémités de sortie (306, 1406) sont orientées pour former un faisceau quasi-parallèle émis à partir des extrémités de sortie.

26. Dispositif (300) selon la revendication 25, caractérisé en ce que les éléments de formation de canal (313) s'étendent le long de génératrices de surfaces imaginaires toroïdales conjuguées à une surface correspondante parmi lesdites surfaces de forme cylindrique.

27. Dispositif selon l'une quelconque des revendications 1 à 5, comportant de plus un boîtier extérieur partiel ou complet constitué d'un matériau opaque au rayonnement de faisceau commandé, le boîtier ayant des ouvertures alignées avec les extrémités d'entrée (104, 204, 304, 404, 504, 904, 1004, 1104, 1404) et les extrémités de sortie (106, 206, 306, 406, 506, 906, 1006, 1106, 1406) des canaux (202, 502, 902, 1401 à 1403).

28. Dispositif selon la revendication 27, caractérisé en ce que la transmission en ligne droite d'un rayonnement entre les ouvertures est bloquée.

29. Dispositif (100) selon l'une quelconque des revendications 1 à 5, caractérisé en ce que le dispositif (100) comporte une pluralité d'éléments de formation de canal (113) constituant un faisceau de capillaires, et en ce que la structure de support rigide comporte une pluralité de disques ou de plaques (4) ayant des ouvertures (5) pour positionner et supporter les éléments de formation de canal.

30. Dispositif (100) selon la revendication 29, caractérisé en ce qu'au moins un des disques (4) peut être sélectivement translaté le long de l'axe central du dispositif (100) par rapport à au moins un autre disque (4).

31. Dispositif (400) selon l'une quelconque des revendications 1 à 5, caractérisé en ce que chaque élément de formation de canal (413) est constitué d'un faisceau de capillaires, et en ce que la structure de support rigide est formée par des espaces de remplissage d'une composition entre les faisceaux de capillaires.

32. Dispositif (100, 200, 300, 500, 900, 1000, 1400) selon l'une quelconque des revendications 1 à 5, caractérisé en ce que chaque élément de formation de canal (113, 213, 313, 513, 913, 1013, 1413) est constitué d'un faisceau de capillaires s'étendant côte à côte dans une longueur, des capillaires adjacents étant reliés les uns aux autres au niveau de parties de surface extérieure pratiquement sur toutes leurs longueurs.

33. Dispositif selon l'une quelconque des revendications 1 à 5, caractérisé en ce que la structure de support rigide est montée de manière rotative autour de l'axe central de propagation du faisceau.

34. Dispositif selon l'une quelconque des revendications 1 à 5, caractérisé en ce qu'il comporte un filtre par absorption de rayonnement pour commander l'intensité du faisceau à travers la coupe transversale du faisceau.

35. Dispositif selon l'une quelconque des revendications 1 à 5, caractérisé en ce que les éléments de formation de canal (13, 113, 213, 313, 413, 513, 613, 713, 813, 913, 1013, 1113, 1213, 1313, 1413) sont entourés d'un matériau thermiquement conducteur qui est refroidi.

36. Dispositif selon l'une quelconque des revendications 1 à 5, caractérisé en ce que les parties de surface intérieure des éléments de formation de canal (13, 113, 213, 313, 413, 513, 613, 713, 813, 913, 1013, 1113, 1213, 1313, 1413) sont constituées de matériaux qui absorbent de manière sélective un rayonnement ayant des bandes d'énergie prédéterminées.

37. Dispositif selon la revendication 36, caractérisé en ce que les parties de surface intérieure des éléments de formation de canal (13, 113, 213, 313, 413, 513, 613, 713, 813, 913, 1013, 1113, 1213, 1313, 1413) sont revêtues de cuivre.

38. Dispositif selon la revendication 36, caractérisé en ce que les parties de surface intérieure des éléments de formation de canal (13, 113, 213, 313, 413, 513, 613, 713, 813, 913, 1013, 1113, 1213, 1313, 1413) sont revêtues de béryllium.

39. Dispositif selon l'une quelconque des revendications 1 à 5, caractérisé en ce que les éléments de formation de canal (13, 113, 213, 313, 413, 513, 613, 713, 813, 913, 1013, 1113, 1213, 1313, 1413) sont formés pour définir des canaux ayant des formes en coupe transversale qui sont pratiquement rectangulaires.

40. Dispositif selon l'une quelconque des revendications 1 à 5, caractérisé en ce que les parties de surface intérieure des éléments de formation de canal sont constituées d'un matériau électriquement conducteur ou revêtues d'un tel matériau.

41. Dispositif (300, 500, 700, 800, 900, 1000, 1400) selon la revendication 40, caractérisé en ce que le dispositif comporte en outre un capillaire conique (560) positionné pour recevoir un rayonnement provenant des extrémités de sortie (506) le capillaire conique (560) ayant un axe longitudinal qui s'étend en étant pratiquement aligné avec l'axe d'émission de rayonnement défini par rapport aux extrémités de sortie (506), le capillaire conique (560) ayant une largeur diminuant lorsque la distance augmente à partir des extrémités de sortie (506).

42. Dispositif selon l'une quelconque des revendications 1 à 5, caractérisé en ce que les éléments de formation de canal (13, 113, 213, 313, 413, 513, 613, 713, 813, 913, 1013, 1113, 1213, 1313, 1413) sont formés de sorte que le rayonnement est réfléchi selon des angles proches de l'angle critique pour une réflexion auxiliaire totale de l'énergie la plus élevée pour laquelle une efficacité de transmission élevée est voulue.

43. Dispositif selon la revendication 42, caractérisé en ce que les éléments de formation de canal (13, 113, 213, 313, 413, 513, 613, 713, 813, 913, 1013, 1113, 1213, 1313, 1413) sont formés pour définir deux parties des canaux en arc de cercle s'incurvant respectivement dans des directions pratiquement opposées.

44. Dispositif selon la revendication 42, caractérisé en ce que le dispositif comporte de plus des moyens d'ajustement pour ajuster la courbure des canaux.

45. Système de lithographie aux rayons X (1502, 1504, 1506, 1508, 1510) comportant un dispositif (300, 500, 900) selon l'une quelconque des revendications 1 à 44, situé entre une source de rayons X (1505) et un masque (1503).

46. Système de lithographie aux rayons X (1502, 1504, 1506) selon la revendication 45, caractérisé en ce que les canaux (502, 509) sont orientés pour former un faisceau de rayonnement quasi-parallèle.

47. Système de lithographie aux rayons X (1502, 1504, 1506) selon la revendication 46, caractérisé en ce que la distance entre le masque (1503) et les extrémités de sortie (306, 506, 906) est suffisante pour homogénéiser toute différence dans l'intensité du faisceau provoquée par la configuration discrète des canaux (502, 902).

EP 0 555 376 B1

**48.** Instrument analytique (1602, 1608, 1610, 1612) comportant un dispositif selon l'une quelconque des revendications 1 à 44, situé entre la source de rayonnement (1605) et un échantillon (1603) à analyser, et un détecteur de rayonnement (1607).

**49.** Instrument analytique (1604, 1606, 1608) comportant un dispositif selon l'une quelconque des revendications 1 à 44, situé entre un échantillon (1603) à analyser et un détecteur de rayonnement (1607), et une source de rayonnement (1605).

**50.** Instrument analytique (1602, 1604, 1606, 1608, 1610, 1612) selon la revendication 48 ou 49, caractérisé en ce que l'instrument analytique est un dispositif à rayons X, un dispositif ionique, un dispositif à neutrons ou un dispositif à faisceau d'électrons.

**51.** Instrument analytique (1602, 1604, 1606, 1608, 1610, 1612) selon la revendication 50, caractérisé en ce que l'instrument analytique est un dispositif de fluorescence aux rayons X, un microscope à rayons X, un dispositif de diffraction de rayons X, un microscope ionique, un microscope à neutrons ou un dispositif de diffraction de neutrons.

**52.** Dispositif médical (1702, 1704, 1706, 1708, 1710) comportant un dispositif (300, 500, 1300, 1400) selon l'une quelconque des revendications 1 à 44.

**53.** Système médical (1702, 1704, 1706, 1708, 1710) selon la revendication 52, caractérisé en ce que le système médical est un système angiographique (1702, 1704, 1706), un endoscope (1710) un système de thérapie par capture de neutrons ou un système de tomographie (1708).

**54.** Système médical (1702, 1704, 1706, 1708, 1710) selon la revendication 52 ou 53, caractérisé en ce que le système comporte en outre une source de rayonnement (1705), et en ce que le dispositif (300, 500, 1300, 1400) émet un faisceau convergent sur un sujet (1703).

**55.** Système médical (1702, 1704, 1706, 1708, 1710) selon la revendication 54, caractérisé en ce que le dispositif (300, 500, 1300, 1400) est situé entre la source de rayonnement (1705) et le sujet (1703).

**56.** Système médical (1702, 1704, 1706, 1708, 1710) selon la revendication 54, caractérisé en ce que le système médical comporte de plus un détecteur de rayonnement, en ce que le dispositif (300, 500, 1300, 1400) est situé entre le sujet (1703) et le détecteur de rayonnement.

**57.** Filtre de rayonnement par sélection d'énergie comportant un dispositif selon l'une quelconque des revendications 1 à 44.

**58.** Filtre de rayonnement selon la revendication 57, caractérisé en ce que le filtre de rayonnement comporte un second dispositif selon l'une quelconque des revendications 1 à 44, le premier dispositif formant un faisceau quasi-parallèle et le second dispositif focalisant le faisceau dans une bande d'énergies présélectionnée.

**59.** Filtre de rayonnement selon la revendication 57, caractérisé en ce que le dispositif comporte des parties pratiquement rectilignes s'étendant de manière générale perpendiculairement à la direction de propagation du faisceau de rayonnement.

**60.** Filtre de rayonnement selon la revendication 59, caractérisé en ce que les extrémités d'entrée du dispositif ont une forme en coupe transversale qui est pratiquement rectangulaire.

Fig. 1

EP 0 555 376 B1

A - A

Fig. 2

rigid material
(metal or rigid plastic
or composite)

EP 0 555 376 B1

Fig.3

Fig.4

glued positions

Fig. 5

EP 0 555 376 B1

FIG. 6

EP 0 555 376 B1

Fig. 9

Fig. 8

Fig. 7

FIG. 10

Fig 11

Fig.12

Fig.13

EP 0 555 376 B1

Fig. 13a

Fig.14

BARREL SURFACE

POINT AT WHICH SIGN OF CURVATURE CHANGES

313

1

318

7

304

300

16

TOROIDAL SURFACE

320

306

8

DENSE QUASIPARALLEL BEAM

**FIG. 15**

EP 0 555 376 B1

**FIG. 16**

EP 0 555 376 B1

Fig 17

FIG. 18

EP 0 555 376 B1

Figure 19

FIG. 20

FIG. 21B

FIG. 21A

FIG. 22

FIG. 23

FIG. 24

LENS ELEMENTS
(E.G. TUBE WALLS,
FLAT PLATES)

INPUT
RADIATION

HIGH MELTING POINT, HEAT CONDUCTING,
COOLED BAFFLES

FIG. 25

CAPILLARY ELEMENTS

INTER ELEMENT
SPACE COOLED
WITH GAS OR
LIQUID

Radiation

FIG. 26

606 ⟶
613 ⟶

FIG. 27

KUMAKHOV LENS

*500*

*1505*

SOURCE

*504*

*1502*

*506*

MASK

*1503*

**FIG. 28**

KUMAKHOV LENS

*1505*

SOURCE

*304*

*300*

*1504*

*306*

MASK

*1503*

**FIG. 29**

*1506*

SOURCE

θ

KUMAKHOV LENS

*300*

BEAM

MASK

WATER

*304*

*1505*

S

*306*

*1503*

[g]

$L_1$

$L_2$

$L_3$

**FIG. 30A**

MASK      WAFER

$2\theta$

$\rho$

## FIG. 30B

LOW INTENSITY

HIGH INTENSITY

## FIG. 31

DIVERGENT BEAM
FROM SYNCHROTRON   713   700

KUMAKHOV LENS
FOR ENERGY BOND SELECTION   800   813   913

→ 1    → 2

900   ↳ 1    → 2

## FIG. 32A

KUMAKHOV LENS
FOR FOCUSING BEAM
TO QUASI-PARALLEL

KUMAKHOV LENS
FOR BEAM SHAPING

1-1

**FIG. 32B**

2-2

SYNCHROTRON
RADIATION

SYNCHROTRON RING

ΔF

**FIG. 33A**

SYNCHROTRON
RADIATION

1004

1000

1006

1013

HIGHER
ENERGY
PHOTONS

**FIG. 33B**

FIG. 34

FIG. 35

KUMAKHOV LENS

*200*

X-RAYS

SOURCE

X-RAYS

*204*

*206*

## FIG. 36

X-RAYS

KUMAKHOV LENS *1100*

X-RAYS

*1104*

*1113*

*1106*

## FIG. 37

KUMAKHOV LENS

X-RAYS

X-RAYS

SOURCE

*504*

*506*

*500*

## FIG. 38A

KUMAKHOV LENS

X-RAYS

SOURCE

*300*

X-RAYS

*306*

*304*

## FIG. 38B

*1605*
X-RAY SOURCE

X-RAYS

*204*

*1602*

KUMAKHOV LENS

*200*

*1607*

DETECTOR

*206*

X-RAYS

*1603*
SAMPLE

## FIG. 39

*1607*
DETECTOR

*206*

KUMAKHOV LENS

*200*

*1605*
X-RAY SOURCE

*1604*

*204* X-RAYS

*1603*
SAMPLE

## FIG. 40A

*1607*
DETECTOR

*1606*

*1100*

KUMARKHOV
LENS

*550*

*500*

*1605*
X-RAY SOURCE

CRYSTAL

*1603*
SAMPLE

## FIG. 40B

FIG. 41A

FIG. 41B

SINGLE CRYSTAL
OR
MULTILAYER
REFLECTOR

SOURCE POWER SUPPLY

X-RAY SOURCE

*1605*

KUMAKHOV LENSES

WAVE LENGTH DISPERSIVE DETECTOR

DETECTOR ELECTRONICS

KUMAKHOV LENS

*200*

ENERGY DISPERSIVE
DETECTOR

*1607'*

DETECTOR
ELECTRONICS

*550*

*300*

*1607* *1200* *1213*

*200'*

SAMPLE

*1603*

*1610*

SAMPLE POSITIONING SYSTEM

COMPUTER CONTROL
OR ANALYSIS SYSTEM

FIG. 42

SINGLE CRYSTAL
MONOCHROMATOR

*1607*

DETECTOR

*550*

KUMAKHOV
LENS

KUMAKHOV
LENS

*1100*

*500*

*1603*

*1605*

X-RAY
SOURCE

*1612*

SAMPLE

**FIG. 43**

EP 0 555 376 B1

SOURCE

KUMAKHOV LENS ~ 500

~ 560

CAPILLARIES

FIG. 44A

SOURCE

KUMAKHOV LENS ~ 500

FIG. 44B

CAPILLARIES

**SOURCE**

*500*

**KUMAKHOV LENS**

~SYSTEMS OF CAPILLARIES

**FIG. 45**

**SYNCHROTRON RADIATION**

**FIG. 46**

FIG. 47

FIG. 48

EP 0 555 376 B1

FIG. 49A

FIG. 49B

HIGHER ENERGY
PHOTONS (FILTERED OUT)

KUMAKHOV
LENS

SUBJECT

1313

SOURCE

1705

1304

1300

550

1702

CRYSTAL MONOCHROMETER
IN LANE GEOMETRY

1703

FIG. 50

FIG. 51B

FIG. 51A

Figure 53

Figure 52

FIG. 54

EP 0 555 376 B1

Figure 55A

Figure 55B

Figure 56

**FIG. 57**

DETECTOR

1705

KUMAKHOV LENSES

200

206

204

1708

SOURCE OF RADIATION

$(X_0 Y_0 Z_0)$

1703

**FIG. 58**

FIG. 59